# EUROPEAN PATENT APPLICATION

(11) **EP 4 791 154 A1**
(43) Date of publication of application: **12.08.2026**
(21) Application number: 25223715.1
(22) Date of filing: 16.12.2025
(51) Int. Cl.: H10F 39/18, H10F 39/00

(54) **IMAGE SENSOR INCLUDING NANO-PHOTONIC LENS ARRAY AND ELECTRONIC APPARATUS INCLUDING THE IMAGE SENSOR**

(30) Priority: 11.02.2025 KR 20250017229
(71) Applicant: Samsung Electronics Co., Ltd., Suwon-si, Gyeonggi-do 16677 (KR)
(72) Inventor: CHO, Choonlae, 16678 Suwon-si (KR); LEE, Sangyun, 16678 Suwon-si (KR); LEE, Suyeon, 16678 Suwon-si (KR); ROH, Sookyoung, 16678 Suwon-si (KR); SONG, Subeom, 16678 Suwon-si (KR); AHN, Sungmo, 16678 Suwon-si (KR); LEE, Junho, 16678 Suwon-si (KR)
(74) Representative: Elkington and Fife LLP

(57) **Abstract**

An image sensor includes a nano-photonic lens array, the nano-photonic lens array includes unit meta-groups each including a first meta-region, a second meta-region, a third meta-region, and a fourth meta-region, each of the first to fourth meta-regions includes a first sub-region, a second sub-region, a third sub-region, and a fourth sub-region, at least one nanostructure is provided in each of the first to fourth sub-regions, in the first to fourth meta-regions of a peripheral meta-group in a periphery of the nano-photonic lens array, a distance by which the nanostructure of the first sub-region and the nanostructure of the second sub-region are shifted in the first direction decreases as an azimuth angle of the peripheral meta-group increases from 0 degrees to 90 degrees, and a distance by which the nanostructure of the first sub-region and the nanostructure of the third sub-region are shifted in the second direction increases as the azimuth angle of the peripheral meta-group increases from 0 degrees to 90 degrees.

## Description

### FIELD OF THE INVENTION

The disclosure relates to an image sensor including a nano-photonic lens array and an electronic apparatus including the image sensor

### BACKGROUND OF THE INVENTION

Image sensors generally sense the color of incident light by using a color filter. However, a color filter may have low light utilization efficiency because the color filter absorbs light of colors other than the color of the incident light. For example, in the case in which a red-green-blue (RGB) color filter is used, only 1/3 of incident light is transmitted therethrough and the other part of the incident light, that is, 2/3 of the incident light, is absorbed. Thus, light utilization efficiency is only about 33%. Most light loss of image sensors occurs in the color filter. Accordingly, a method of separating colors into each pixel of an image sensor without using a color filter is sought.

### SUMMARY OF THE INVENTION

Provided is an image sensor including a nano-photonic lens array capable of separating and concentrating incident light according to wavelengths.

Provided is an image sensor including a nano-photonic lens array with a low performance variation according to a chief ray angle (CRA).

Additional aspects will be set forth in part in the description which follows and, in part, will be apparent from the description, or may be learned by practice of the presented embodiments of the disclosure.

According to an aspect of the disclosure, there is provided an image sensor including: a sensor substrate including a plurality of unit pixel groups, each of the plurality of unit pixel groups including a first pixel, a second pixel, a third pixel, and a fourth pixel; and a nano-photonic lens array including a plurality of nanostructures configured to separate incident light according to wavelengths and concentrate the incident light onto the first pixel, the second pixel, the third pixel, and the fourth pixel, respectively, wherein the nano-photonic lens array includes a plurality of unit meta-groups, each of the plurality of unit meta-groups including a first meta-region corresponding to the first pixel, a second meta-region corresponding to the second pixel, a third meta-region corresponding to the third pixel, and a fourth meta-region corresponding to the fourth pixel, wherein each of the first meta-region, the second meta-region, the third meta-region, and the fourth meta-region includes a first sub-region, a second sub-region, a third sub-region, and a fourth sub-region, wherein at least one nanostructure may be provided in each of the first sub-region, the second sub-region, the third sub-region, and the fourth sub-region, wherein the plurality of unit meta-groups include a central meta-group located at a center portion of the nano-photonic lens array and a plurality of peripheral meta-groups located at a periphery of the nano-photonic lens array, wherein, in the first meta-region, the second meta-region, the third meta-region, and the fourth meta-region of the plurality of peripheral meta-groups, a nanostructure of the first sub-region and a nanostructure of the second sub-region adjacent to the first sub-region in a first direction are symmetrically shifted with opposite displacements in the first direction, and the nanostructure of the first sub-region and a nanostructure of the third sub-region adjacent to the first sub-region in a second direction are symmetrically shifted opposite displacements in the second direction, and wherein a first distance by which the nanostructure of the first sub-region and the nanostructure of the second sub-region are shifted in the first direction decreases as an azimuth angle of a respective one of the plurality of peripheral meta-groups increases from 0 degrees to 90 degrees, and a second distance by which the nanostructure of the first sub-region and the nanostructure of the third sub-region are shifted in the second direction increases as the azimuth angle of the respective one of the plurality of the plurality of peripheral meta-groups increases from 0 degrees to 90 degrees.

Each of the first pixel, the second pixel, the third pixel, and the fourth pixel may include a first sub-pixel, a second sub-pixel, a third sub-pixel, and a fourth sub-pixel two-dimensionally arranged in the form of a 2×2 array, and each of the first sub-pixel, the second sub-pixel, the third sub-pixel, and the fourth sub-pixel may be configured to independently sense incident light.

The plurality of nanostructures of the nano-photonic lens array may have dimensions, cross-sectional shapes, heights, and an arrangement form to concentrate light of a first wavelength band onto each of the first sub-pixel, the second sub-pixel, the third sub-pixel, and the fourth sub-pixel of the first pixel and each of the first sub-pixel, the second sub-pixel, the third sub-pixel, and the fourth sub-pixel of the fourth pixel, concentrate light of a second wavelength band onto the first sub-pixel, the second sub-pixel, the third sub-pixel, and the fourth sub-pixel of the second pixel, and concentrate light of a third wavelength band onto the first sub-pixel, the second sub-pixel, the third sub-pixel, and the fourth sub-pixel of the third pixel, and the first wavelength band, the second wavelength band and the third wavelength band may be different from each other.

Each of the first sub-pixel, the second sub-pixel, the third sub-pixel, and the fourth sub-pixel may include a plurality of photosensitive cells configured to independently sense light.

The first meta-region in one or more of the plurality of peripheral meta-groups may be shifted by a first displacement in the first direction and a second displacement in the second direction compared to the first meta-region of the central meta-group, the second meta-region in one or more of the plurality of peripheral meta-groups may be shifted by a third displacement in the first direction and a fourth displacement in the second direction compared to the second meta-region of the central meta-group, the third meta-region in one or more of the plurality of peripheral meta-groups may be shifted by a fifth displacement in the first direction and a sixth displacement in the second direction compared to the third meta-region of the central meta-group, and the fourth meta-region in one or more of the plurality of peripheral meta-groups may be shifted by a seventh displacement in the first direction and an eighth displacement in the second direction compared to the fourth meta-region of the central meta-group.

A gap between the first meta-region and the second meta-region in the central meta-group may be different from a gap between the first meta-region and the second meta-region in one or more of the plurality of peripheral meta-groups, a gap between the first meta-region and the third meta-region in the central meta-group may be different from a gap between the first meta-region and the third meta-region in one or more of the plurality of peripheral meta-groups, a gap between the second meta-region and the fourth meta-region in the central meta-group may be different from a gap between the second meta-region and the fourth meta-region in one or more of the plurality of peripheral meta-groups, or a gap between the third meta-region and the fourth meta-region in the central meta-group may be different from a gap between the third meta-region and the fourth meta-region in one or more of the plurality of peripheral meta-groups.

A gap between a first nanostructure in the first meta-region in the central meta-group and a second nanostructure in the second meta-region in the central meta-group may be different from a gap between a third nanostructure in the first meta-region in a first peripheral meta-group, among the plurality of peripheral meta-groups, at a relatively same position as the first nanostructure of the central meta-group and a fourth nanostructure in the first peripheral meta-group at a relatively same position as the second nanostructure of the central meta-group.

The plurality of peripheral meta-groups may include a first peripheral meta-group having a first azimuth angle and a second peripheral meta-group having a second azimuth angle different from the first azimuth, and a gap between a first nanostructure in the first meta-region in the first peripheral meta-group and a second nanostructure in the second meta-region in the first peripheral meta-group may be different from a gap between a third nanostructure in the first meta-region in the second peripheral meta-group at a relatively same position as the first nanostructure of the first peripheral meta-group and a fourth nanostructure in the second meta-region in the second peripheral meta-group at a relatively same position as the second nanostructure of the first peripheral meta-group.

Each of the plurality of unit meta-groups may include a boundary nanostructure located at a boundary of all the first meta-region, the second meta-region, the third meta-region, and the fourth meta-region, and the boundary nanostructure in one or more of the peripheral meta-groups may be shifted by an average of the first displacement, the second displacement, the third displacement, the fourth displacement, the fifth displacement, the sixth displacement, the seventh displacement, and the eighth displacement.

A gap, in the first direction, between the first sub-region and the second sub-region in the first meta-region of the central meta-group may be different from a gap. in the first direction, between the first sub-region and the second sub-region in the first meta-region of a first peripheral meta-group provided at a position where the azimuth angle is 0 degrees, among the plurality of peripheral meta-groups, and a gap, in the first direction, between the third sub-region and the fourth sub-region in the first meta-region of the central meta-group may be different from a gap, in the first direction, between the third sub-region and the fourth sub-region in the first meta-region of the first peripheral meta-group.

A gap, in a second direction crossing the first direction, between the first sub-region and the third sub-region in the first meta-region of the central meta-group may be same as a gap, in the second direction, between the first sub-region and the third sub-region in the first meta-region of the first peripheral meta-group, and a gap, in the second direction, between the second sub-region and the fourth sub-region in the first meta-region of the central meta-group may be same as a gap, in the second direction, between the second sub-region and the fourth sub-region in the first meta-region of the first peripheral meta-group.

A gap, in a second direction crossing the first direction, between the first sub-region and the third sub-region in the first meta-region of the central meta-group may be different from a gap, in the second direction between, the first sub-region and the third sub-region in the first meta-region of a second peripheral meta-group provided at a position where the azimuth angle is 90 degrees, among the plurality of peripheral meta-groups, and a gap, in the second direction, between the second sub-region and the fourth sub-region in the first meta-region of the central meta-group may be different from a gap in the second direction between the second sub-region and the fourth sub-region in the first meta-region of the second peripheral meta-group.

A gap, in the first direction, between the first sub-region and the second sub-region in the first meta-region of the central meta-group may be same as a gap, in the first direction, between the first sub-region and the second sub-region in the first meta-region of the second peripheral meta-group, and a gap, in the first direction, between the third sub-region and the fourth sub-region in the first meta-region of the central meta-group may be same as a gap, in the first direction, between the third sub-region and the fourth sub-region in the first meta-region of the second peripheral meta-group.

A gap between a first nanostructure belonging to the first sub-region of the first meta-region of the central meta-group and a second nanostructure belonging to the second sub-region of the first meta-region of the central meta-group may be different from a gap between a third nanostructure at a relatively same position as the first nanostructure of the central meta-group in the first meta-region of a first peripheral meta-group, among the plurality of peripheral meta-groups and a fourth nanostructure at a relatively same position as the second nanostructure of the central meta-group in the first meta-region of the first peripheral meta-group.

The plurality of peripheral meta-groups may include a first peripheral meta-group having a first azimuth angle and a second peripheral meta-group having a second azimuth angle different from the first azimuth, and a gap between a first nanostructure belonging to the first sub-region of the first meta-region of the first peripheral meta-group and a second nanostructure belonging to the second sub-region of the first meta-region of the first peripheral meta-group may be different from a gap between a third nanostructure at a relatively same position as the first nanostructure of the first peripheral meta-group in the first meta-region of the second peripheral meta-group and a fourth nanostructure at a relatively same position as the second nanostructure of the first peripheral meta-group in the first meta-region of the second peripheral meta-group.

Each of the plurality of unit meta-groups may include a boundary nanostructure located at a boundary of all the first sub-region, the second sub-region, the third sub-region, and the fourth sub-region in the first meta-region, and a gap between the boundary nanostructure of the central meta-group and a first nanostructure inside the first sub-region of the first meta-region of the central meta-group may be different from a gap between the boundary nanostructure of a first peripheral meta-group, among the plurality of peripheral meta-groups and a second nanostructure of the first peripheral meta-group at a relatively same position as the first nanostructure of the central meta-group.

The plurality of peripheral meta-groups may include a first peripheral meta-group having a first azimuth angle and a second peripheral meta-group having a second azimuth angle different from the first azimuth, and a gap between a boundary nanostructure of the first peripheral meta-group and a first nanostructure inside the first sub-region of the first meta-region of the first peripheral meta-group may be different from a gap between a boundary nanostructure of the second peripheral meta-group and a second nanostructure of the second peripheral meta-group at a relatively same position as the first nanostructure of the first peripheral meta-group.

Each of the plurality of unit meta-groups may include a boundary nanostructure located at a boundary between the third sub-region and the fourth sub-region in the first meta-region, and a gap, in the first direction, between the boundary nanostructure of the central meta-group and a first nanostructure inside the third sub-region of the first meta-region of the central meta-group may be different from a gap, in the first direction, between the boundary nanostructure of a first peripheral meta-group, among the plurality of peripheral meta-groups, and a second nanostructure of the first peripheral meta-group at a relatively same position as the first nanostructure of the central meta-group.

The first meta-region and the fourth meta-region are symmetrically shifted relative to each other with respect to an azimuth angle of ±45 degrees in one or more the plurality of peripheral meta-groups.

According to another aspect of the disclosure, there may be provided an electronic device including: a lens assembly configured to form an optical image of a subject; an image sensor configured to convert the optical image formed by the lens assembly into an electrical signal; and a processor configured to process the electrical signal generated by the image sensor, wherein the image sensor includes a plurality of unit pixel groups, each of the plurality of unit pixel groups including a first pixel, a second pixel, a third pixel, and a fourth pixel; and a nano-photonic lens array including a plurality of nanostructures configured to separate incident light according to wavelengths and concentrate the incident light onto the first pixel, the second pixel, the third pixel, and the fourth pixel, respectively, wherein the nano-photonic lens array includes a plurality of unit meta-groups, each of the plurality of unit meta-groups including a first meta-region corresponding to the first pixel, a second meta-region corresponding to the second pixel, a third meta-region corresponding to the third pixel, and a fourth meta-region corresponding to the fourth pixel, wherein each of the first meta-region, the second meta-region, the third meta-region, and the fourth meta-region includes a first sub-region, a second sub-region, a third sub-region, and a fourth sub-region, wherein at least one nanostructure may be provided in each of the first sub-region, the second sub-region, the third sub-region, and the fourth sub-region, wherein the plurality of unit meta-groups include a central meta-group located at a center portion of the nano-photonic lens array and a plurality of peripheral meta-groups located at a periphery of the nano-photonic lens array, wherein, in the first meta-region, the second meta-region, the third meta-region, and the fourth meta-region of the plurality of peripheral meta-groups, a nanostructure of the first sub-region and a nanostructure of the second sub-region adjacent to the first sub-region in a first direction are symmetrically shifted with opposite displacements in the first direction, and the nanostructure of the first sub-region and a nanostructure of the third sub-region adjacent to the first sub-region in a second direction are symmetrically shifted opposite displacements in the second direction, and wherein a first distance by which the nanostructure of the first sub-region and the nanostructure of the second sub-region are shifted in the first direction decreases as an azimuth angle of a respective one of the plurality of peripheral meta-groups increases from 0 degrees to 90 degrees, and a second distance by which the nanostructure of the first sub-region and the nanostructure of the third sub-region are shifted in the second direction increases as the azimuth angle of the respective one of the plurality of the plurality of peripheral meta-groups increases from 0 degrees to 90 degrees.

### BRIEF DESCRIPTION OF THE DRAWINGS

The above and other aspects, features, and advantages of certain embodiments of the disclosure will be more apparent from the following description taken in conjunction with the accompanying drawings, in which:
FIG. 1 is a schematic block diagram of an image sensor according to an embodiment;
FIGS. 2A and 2B are cross-sectional views schematically showing a structure of a pixel array in an image sensor, according to an embodiment;
FIG. 3 shows a pixel arrangement of a sensor substrate, according to an embodiment;
FIG. 4 shows a pixel arrangement of a sensor substrate, according to another embodiment;
FIG. 5 shows a pixel arrangement of a sensor substrate, according to another embodiment;
FIG. 6 shows a color filter arrangement of a color filter layer, according to an embodiment;
FIG. 7 shows an arrangement of meta-regions of a nano-photonic lens array, according to an embodiment;
FIG. 8 shows an arrangement of a plurality of nano-structures in a unit meta-group of a nano-photonic lens array, according to an embodiment;
FIG. 9A shows a phase profile of blue light passing through a nano-photonic lens array, FIG. 9B shows a phase profile of green light passing through the nano-photonic lens array, and FIG. 9C shows a phase profile of red light passing through the nano-photonic lens array;
FIG. 10 is a cross-sectional view showing a phase profile and concentration action of red light by a nano-photonic lens array, according to an embodiment;
FIG. 11A shows concentration regions of blue light formed on a sensor substrate, FIG. 11B shows concentration regions of green light formed on the sensor substrate, and FIG. 11C shows concentration regions of red light formed on the sensor substrate;
FIG. 12 is a cross-sectional view of shifts of meta-regions of a nano-photonic lens array at the periphery of the nano-photonic lens array;
FIG. 13 shows shift directions of unit meta-groups of a nano-photonic lens array according to a position of an azimuth angle at the periphery of the nano-photonic lens array;
FIG. 14 shows shifts of individual meta-regions within a peripheral meta-group of the periphery of the nano-photonic lens array;
FIGS. 15 and 16 show relative displacements of sub-regions in a first meta-region at positions where an azimuth angle of the periphery of a nano-photonic lens array is 0 degrees and 90 degrees, respectively;
FIGS. 17 and 18 show relative displacements of sub-regions in a second meta-region at positions where an azimuth angle of the periphery of a nano-photonic lens array is 0 degrees and 90 degrees, respectively;
FIGS. 19 and 20 show relative displacements of sub-regions in a third meta-region at positions where an azimuth angle of the periphery of a nano-photonic lens array is 0 degrees and 90 degrees, respectively;
FIGS. 21 and 22 show relative displacements of sub-regions in a fourth meta-region at positions where an azimuth angle of the periphery of a nano-photonic lens array is 0 degrees and 90 degrees, respectively;
FIG. 23 shows the relationship between shift distances and azimuth angles of sub-regions within a peripheral meta-group of the periphery of a nano-photonic lens array;
FIG. 24 is a cross-sectional view showing a phase profile and concentration action of red light by a nano-photonic lens array at the periphery of the nano-photonic lens array;
FIG. 25 is a cross-sectional view showing shifts of color filters of a color filter layer and meta-regions of a nano-photonic lens array at the periphery of the nano-photonic lens array, according to another embodiment;
FIG. 26 is a cross-sectional view showing shifts of color filters of a color filter layer and meta-regions of a nano-photonic lens array at the periphery of the nano-photonic lens array, according to another embodiment;
FIG. 27 is a block diagram of an electronic apparatus including an image sensor according to an embodiment;
FIG. 28 is a block diagram of a camera module in FIG. 27;
FIG. 29 is a block diagram of an electronic device including a multi-camera module; and
FIG. 30 is a detailed block diagram of the multi-camera module in the electronic device of FIG. 29.

### DETAILED DESCRIPTION

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list.

Hereinafter, an image sensor including a nano-photonic lens array and an electronic apparatus including the image sensor will be described in detail with reference to accompanying drawings. Embodiments described herein are capable of various modifications and may be embodied in many different forms. In the drawings, like reference numerals denote like elements, and sizes of elements in the drawings may be exaggerated for convenience of explanation
In an example case in which a layer, a film, a region, or a panel is referred to as being "on/under" another element, it may be directly on/under/at left/right sides of the other layer or substrate, or intervening layers may also be present.

It will be understood that although the terms "first," "second," etc. may be used herein to describe various elements, these elements are only used to distinguish one element from another. These terms do not limit that materials or structures of elements are different from one another.

An expression used in the singular encompasses the expression of the plural, unless it has a clearly different meaning in the context. It will be further understood that when a portion is referred to as "comprising" another element, the portion may not exclude another element but may further comprise another element unless the context states otherwise.

In addition, the terms such as "... unit", "module", etc. provided herein indicates a unit performing a function or an operation, and may be realized by hardware, software, or a combination of hardware and software.

The use of the terms of "the" and similar indicative terms may correspond to both the singular forms and the plural forms.

In addition, the operations of all methods described herein may be performed in any suitable order unless otherwise indicated herein or otherwise clearly contradicted by context. In addition, the use of all exemplary terms (for example, etc.) is only to describe technical detail, and the scope of rights is not limited by these terms unless the context is limited by the claims.

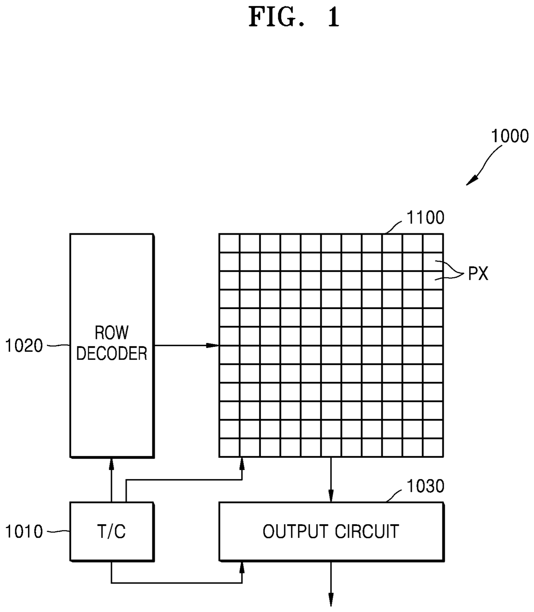

FIG. 1 is a schematic block diagram of an image sensor 1000 according to an embodiment. Referring to FIG. 1, the image sensor 1000 may include a pixel array 1100, a timing controller (T/C) 1010, a row decoder 1020, and an output circuit 1030. The image sensor 1000 may be a charge-coupled device (CCD) image sensor or a complementary metal oxide semiconductor (CMOS) image sensor.

The pixel array 1100 includes a plurality of pixels PX that are two-dimensionally provided in a plurality of rows and columns. The row decoder 1020 selects one of the rows in the pixel array 1100, based on (or in response to) a row address signal output from the T/C 1010. The output circuit 1030 outputs a photosensitive signal from the plurality of pixels PX provided in the selected row in a column unit. To this end, the output circuit 1030 may include a column decoder and an analog-to-digital converter (ADC). For example, the output circuit 1030 may include a plurality of analog-to-digital converters that are respectively provided in columns between the column decoder and the pixel array 1100, or one analog-to-digital converter provided at an output end of the column decoder. The T/C 1010, the row decoder 1020, and the output circuit 1030 may be implemented as one chip or in separate chips. A processor for processing an image signal output from the output circuit 1030 may be implemented as one chip with the T/C 1010, the row decoder 1020, and the output circuit 1030.

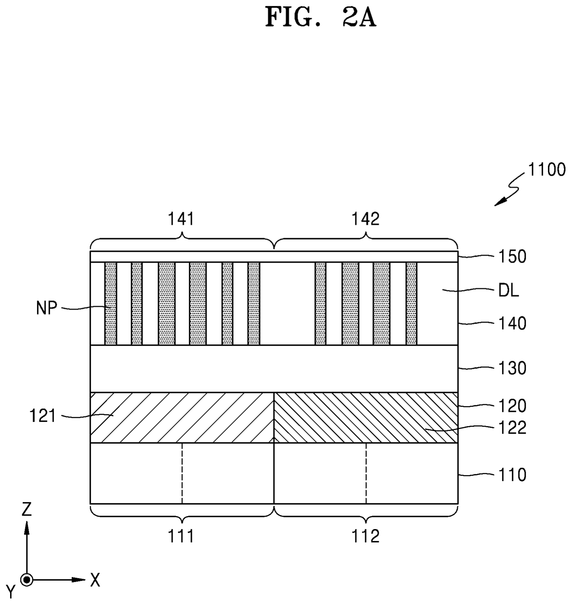

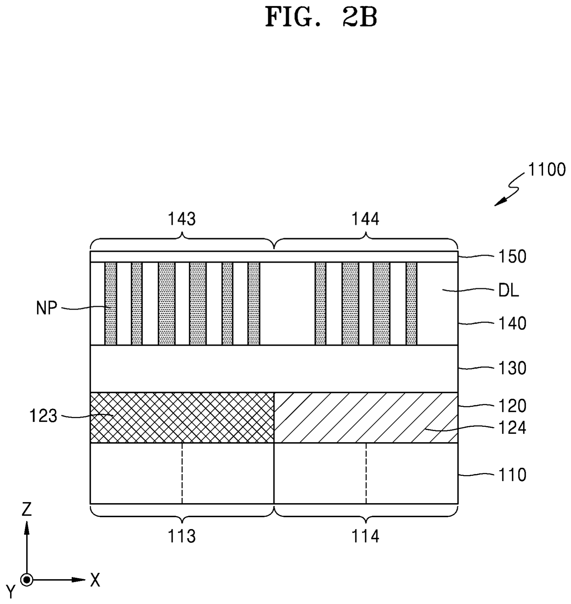

FIGS. 2A and 2B are cross-sectional views schematically showing a structure of the pixel array 1100 in an image sensor 1000 according to an embodiment. FIG. 2A shows a cross-section of the pixel array 1100 in a first direction (e.g., X-axis direction), and FIG. 2B shows a cross-section of the pixel array 1100 in the first direction (e.g., X-axis direction) at a position different from the cross-section of FIG. 2A in a second direction (e.g., Y-axis direction) perpendicular to the first direction. Referring to FIGS. 2A and 2B, the pixel array 1100 may include a sensor substrate 110, a color filter layer 120 provided on the sensor substrate 110, a spacer layer 130 provided on the color filter layer 120, and a nano-photonic lens array 140 provided on the spacer layer 130. In addition, the pixel array 1100 may include an anti-reflection layer 150 provided on the nano-photonic lens array 140. The color filter layer 120 may be provided between the sensor substrate 110 and the nano-photonic lens array 140 in a third direction (e.g., Z-axis direction) perpendicularly crossing the first direction and the second direction. The spacer layer 130 may be provided between the color filter layer 120 and the nano-photonic lens array 140 in the third direction. The nano-photonic lens array 140 may be provided between the spacer layer 130 and the anti-reflection layer 150 in the third direction.

According to an embodiment, the pixel array 1100 may further include an etch stop layer provided between the spacer layer 130 and the nano-photonic lens array 140. The etch stop layer may prevent the spacer layer 130 from being etched in a process of forming the nano-photonic lens array 140 on the spacer layer 130.

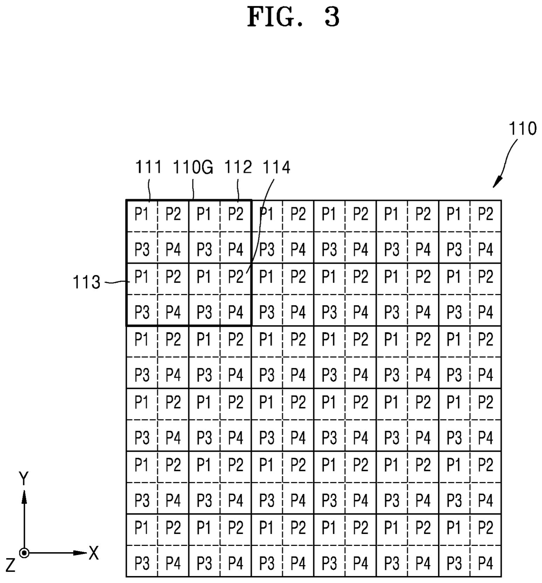

FIG. 3 shows a pixel arrangement of the sensor substrate 110 according to an embodiment. Referring to FIG. 3, the sensor substrate 110 may include a plurality of unit pixel groups 110G arranged two-dimensionally in a first direction and a second direction. According to an embodiment, one unit pixel group 110G of the sensor substrate 110 may include a first pixel 111, a second pixel 112, a third pixel 113, and a fourth pixel 114. The first pixel 111, the second pixel 112, the third pixel 113, and the fourth pixel 114 may be two-dimensionally arranged in the form of a 2×2 array in the first direction and the second direction. A plurality of first pixels 111 and a plurality of second pixels 112 may be alternately arranged in the first direction in one row on the sensor substrate 110, and a plurality of third pixels 113 and a plurality of fourth pixels 114 may be alternately arranged in the first direction in a row having a different position in the second direction perpendicular to the first direction. In addition, the plurality of first pixels 111 and the plurality of fourth pixels 114 may be alternately arranged in a first diagonal direction, and the plurality of second pixels 112 and the plurality of third pixels 113 may be alternately arranged in a second diagonal direction crossing the first diagonal direction.

The first pixel 111, the second pixel 112, the third pixel 113, and the fourth pixel 114 may sense light of different colors. In an example, the first pixel 111 and the fourth pixel 114 may be green pixels that sense green light, the second pixel 112 may be a blue pixel that senses blue light, and the third pixel 113 may be a red pixel that senses red light. In another example, the first pixel 111 and the fourth pixel 114 may be yellow pixels that sense yellow (or yellow-based) light, the second pixel 112 may be a blue pixel that senses blue light, and the third pixel 113 may be a red pixel that senses red light. In another example, the first pixel 111 and the fourth pixel 114 may be yellow pixels, the second pixel 112 may be a cyan pixel that senses cyan (or cyan-based) light, and the third pixel 113 may be a magenta pixel that senses magenta (or magenta-based) light.

Each of the first pixel 111, the second pixel 112, the third pixel 113, and the fourth pixel 114 may include sub-pixels grouped and arranged in the form of a 2×2 array in the first direction and the second direction. For example, the first pixel 111 may include a first sub-pixel P1, a second sub-pixel P2, a third sub-pixel P3, and a fourth sub-pixel P4 that are grouped and two-dimensionally arranged in the form of a 2×2 array in the first direction and the second direction. The first sub-pixel P1 may contact the second sub-pixel P2 in the first direction and the third sub-pixel P3 in the second direction. The second sub-pixel P2 may contact the fourth sub-pixel P4 in the second direction, and the third sub-pixel P3 may contact the fourth sub-pixel P4 in the first direction. Likewise, each of the second pixel 112, the third pixel 113, and the fourth pixel 114 may include the first sub-pixel P1, the second sub-pixel P2, the third sub-pixel P3, and the fourth sub-pixel P4.

The first sub-pixel P1, the second sub-pixel P2, the third sub-pixel P3, and the fourth sub-pixel P4 of each of the first pixel 111, the second pixel 112, the third pixel 113, and the fourth pixel 114 may be configured to independently sense incident light. According to example embodiments, a color image may be obtained in two different ways. In an example, each of the first sub-pixel P1, the second sub-pixel P2, the third sub-pixel P3, and the fourth sub-pixel P4 may operate as one independent channel. In this case, each of the first pixel 111, the second pixel 112, the third pixel 113, and the fourth pixel 114 may have four independent channels, and one unit pixel group 110G may output 16 independent signals. For example, the first pixel 111 may have four independent green channels, the second pixel 112 may have four independent blue channels, the third pixel 113 may have four independent red channels, and the fourth pixel 114 may have four independent green channels. In the image signal processing process, a processor may individually use signals output from the first sub-pixel P1, the second sub-pixel P2, the third sub-pixel P3, and the fourth sub-pixel P4 to perform an operation, for example, noise reduction, color correction, etc., and generate a color image. In an example, the processor may be included in the image sensor 1000, or may be parts included in an electronic device including the image sensor 1000.

In another example, a binning mode operation for increasing sensitivity in a low illuminance environment may be executed. A binning mode is an image processing method of summing outputs of the first sub-pixel P1, the second sub-pixel P2, the third sub-pixel P3, and the fourth sub-pixel P4. For example, a first green image signal may be generated by summing output signals of the first sub-pixel P1, the second sub-pixel P2, the third sub-pixel P3, and the fourth sub-pixel P4 of the first pixel 111, a blue image signal may be generated by summing output signals of the first sub-pixel P1, the second sub-pixel P2, the third sub-pixel P3, and the fourth sub-pixel P4 of the second pixel 112, a red image signal may be generated by summing output signals of the first sub-pixel P1, the second sub-pixel P2, the third sub-pixel P3, and the fourth sub-pixel P4 of the third pixel 113, and a second green image signal may be generated by summing output signals of the first sub-pixel P1, the second sub-pixel P2, the third sub-pixel P3, and the fourth sub-pixel P4 of the fourth pixel 114. The processor may generate a color image by performing image signal processing on the summed image signals.

In a high illuminance environment, the first sub-pixel P1, the second sub-pixel P2, the third sub-pixel P3, and the fourth sub-pixel P4 may individually output first green image signals. Therefore, the first pixel 111 may output four first green image signals having different spatial information. Likewise, the second pixel 112 may output four blue image signals having different spatial information respectively from the first sub-pixel P1, the second sub-pixel P2, the third sub-pixel P3, and the fourth sub-pixel P4, the third pixel 113 may output four red image signals having different spatial information respectively from the first sub-pixel P1, the second sub-pixel P2, the third sub-pixel P3, and the fourth sub-pixel P4, and the fourth sub-pixel 114 may output four second green image signals having different spatial information respectively from the first sub-pixel P1, the second sub-pixel P2, the third sub-pixel P3, and the fourth sub-pixel P4.

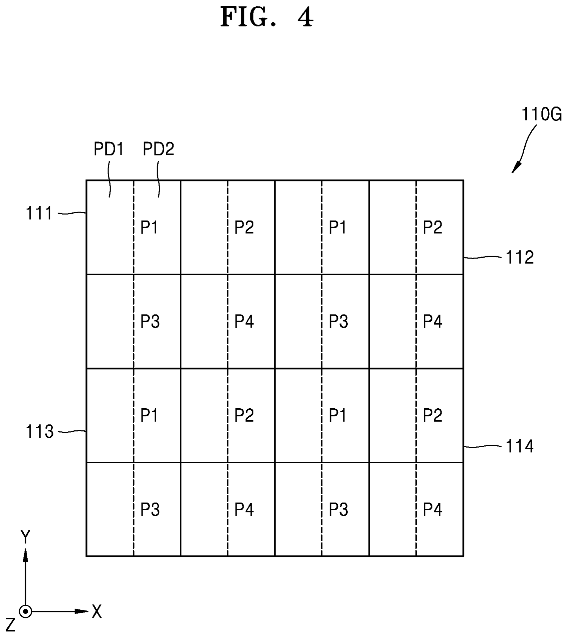

FIG. 4 shows a pixel arrangement of the sensor substrate 110 according to another embodiment. FIG. 4 shows only one unit pixel group 110G for convenience. Like FIG. 3, the sensor substrate 110 may include the plurality of unit pixel groups 110G arranged two-dimensionally. Referring to FIG. 4, each of the first sub-pixel P1, the second sub-pixel P2, the third sub-pixel P3, and the fourth sub-pixel P4 may include a first photosensitive cell PD1 and a second photosensitive cell PD2 that independently sense incident light. For example, in each of the first sub-pixel P1, the second sub-pixel P2, the third sub-pixel P3, and the fourth sub-pixel P4, the first photosensitive cell PD1 and the second photosensitive cell PD2 may be provided adjacent to each other in the first direction. In this case, an autofocus signal may be obtained from a difference between output signals of the first photosensitive cell PD1 and the second photosensitive cell PD2. A general image signal may be obtained by summing the output signals of the first photosensitive cell PD1 and the second photosensitive cell PD2, or by treating each of the output signals of the first photosensitive cell PD1 and the second photosensitive cell PD2 as individual image signal.

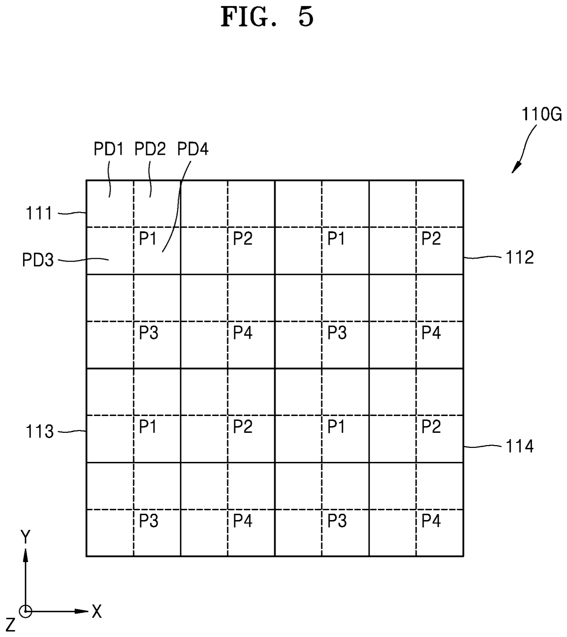

FIG. 5 shows a pixel arrangement of the sensor substrate 110 according to another embodiment. FIG. 5 shows only one unit pixel group 110G for convenience. Like FIG. 3, the sensor substrate 110 may include the plurality of unit pixel groups 110G arranged two-dimensionally. Referring to FIG. 5, each of the first sub-pixel P1, the second sub-pixel P2, the third sub-pixel P3, and the fourth sub-pixel P4 may include a plurality of photosensitive cells which are grouped and two-dimensionally arranged in the form of a 2×2 array in the first direction and the second direction. For example, each of the first sub-pixel P1, the second sub-pixel P2, the third sub-pixel P3, and the fourth sub-pixel P4 may include the first photosensitive cell PD1, the second photosensitive cell PD2, a third photosensitive cell PD3, and a fourth photosensitive cell PD4 which are grouped in the form of a 2×2 array and two-dimensionally arranged. Each of the first photosensitive cell PD1, the second photosensitive cell PD2, the third photosensitive cell PD3, and the fourth photosensitive cell PD4 may independently sense incident light.

FIGS. 4 and 5 show that each of the first sub-pixel P1, the second sub-pixel P2, the third sub-pixel P3, and the fourth sub-pixel P4 includes two or four photosensitive cells, but the disclosure is not necessarily limited thereto. According to the need of the image sensor 1000, each of the first sub-pixel P1, the second sub-pixel P2, the third sub-pixel P3, and the fourth sub-pixel P4 may include various different numbers of photosensitive cells.

According to an embodiment, various autofocus signals may be obtained by using a phase detection method from differences between output signals of adjacent photosensitive cells. For example, an autofocus signal in the first direction may be generated from a difference between the output signal of the first photosensitive cell PD1 and the output signal of the second photosensitive cell PD2, a difference between the output signal of the third photosensitive cell PD3 and the output signal of the fourth photosensitive cell PD4, or a difference between the sum of the output signals of the first photosensitive cell PD1 and the third photosensitive cell PD3 and the sum of the output signals of the second photosensitive cell PD2 and the fourth photosensitive cell PD4. In addition, an autofocus signal in the second direction may be generated from a difference between the output signal of the first photosensitive cell PD1 and the output signal of the third photosensitive cell PD3, a difference between the output signal of the second photosensitive cell PD2 and the output signal of the fourth photosensitive cell PD4, or a difference between the sum of the output signals of the first photosensitive cell PD1 and the second photosensitive cell PD2 and the sum of the output signals of the third photosensitive cell PD3 and the fourth photosensitive cell PD4.

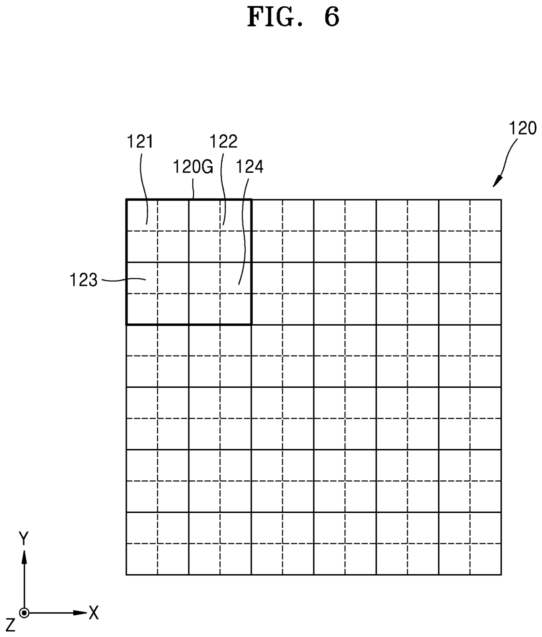

FIG. 6 shows a color filter arrangement of the color filter layer 120 according to an embodiment. Referring to FIG. 6, the color filter layer 120 may include a plurality of unit filter groups 120G arranged two-dimensionally in a first direction and a second direction. Each of the unit filter groups 120G may include a plurality of color filters provided between the sensor substrate 110 and the nano-photonic lens array 140 to transmit light of a specific wavelength band and absorb light of another wavelength band. For example, each unit filter group 120G may include a first color filter 121 that transmits light in a first wavelength band and absorbs light in another wavelength band, a second color filter 122 that transmits light of a second wavelength band that is different from the first wavelength band and absorbs light of another wavelength band, a third color filter 123 that transmits light of a third wavelength band that is different from the first wavelength band and the second wavelength band and absorbs light of another wavelength band, and a fourth color filter 124 that transmits light in the first wavelength band and absorbs light in another wavelength band. The first color filter 121, the second color filter 122, the third color filter 123, and the fourth color filter 124 may be grouped and arranged in the form of a 2×2 array in the first direction and the second direction. For example, the first color filter 121 may contact the second color filter 122 in the first direction and the third color filter 123 in the second direction. The second color filter 122 may contact the fourth color filter 124 in the second direction, and the third color filter 123 may contact the fourth color filter 124 in the first direction.

A plurality of first color filters 121 and a plurality of second color filters 122 may be alternately arranged in the first direction in one row on the color filter layer 120, and a plurality of third color filters 123 and a plurality of fourth color filters 124 may be alternately arranged in the first direction in a row having a different position in the second direction. In addition, the plurality of first color filters 121 and the plurality of fourth color filters 124 may be alternately arranged in a first diagonal direction, and the plurality of second color filters 122 and the plurality of third color filters 123 may be alternately arranged in a second diagonal direction crossing the first diagonal direction.

The first color filter 121 may be provided to face the first pixel 111 in the third direction (Z-axis direction), the second color filter 122 may be provided to face the second pixel 112 in the third direction, the third color filter 123 may be provided to face the third pixel 113 in the third direction, and the fourth color filter 124 may be provided to face the fourth pixel 114 in the third direction. Accordingly, the first pixel 111 may sense light of a first wavelength band that has passed through the first color filter 121. The second pixel 112 may sense light of a second wavelength band that has passed through the second color filter 122, the third pixel 113 may sense light of a third wavelength band that has passed through the third color filter 123, and the fourth pixel 114 may sense light of the first wavelength band that has passed through the fourth color filter 124.

For example, the first color filter 121 and the fourth color filter 124 may be green color filters that transmit green light, the second color filter 122 may be a blue color filter that transmits blue light, and the third color filter 123 may be a red color filter that transmits red light. In another example, the first color filter 121 and the fourth color filter 124 may be yellow color filters that transmit yellow (or yellow-based) light, the second color filter 122 may be a blue color filter, and the third color filter 123 may be a red color filter. In another example, the first color filter 121 and the fourth color filter 124 may be yellow color filters, the second color filter 122 may be a cyan color filter, and the third color filter 123 may be a magenta color filter.

The dashed lines shown in FIG. 6 indicate separators between the first sub-pixel P1, the second sub-pixel P2, the third sub-pixel P3, and the fourth sub-pixel P4. As shown in FIG. 6, the first color filter 121, the second color filter 122, the third color filter 123, and the fourth color filter 124 may be provided in the third direction to face all sub-pixels of the first pixel 111, the second pixel 112, the third pixel 113, and the fourth pixel 114 corresponding thereto. In other words, the first color filter 121 may cover all sub-pixels of the first pixel 111, the second color filter 122 may cover all sub-pixels of the second pixel 112, the third color filter 123 may cover all sub-pixels of the third pixel 113, and the fourth color filter 124 may cover all sub-pixels of the fourth pixel 114.

Each of the first color filter 121, the second color filter 122, the third color filter 123, and the fourth color filter 124 of the color filter layer 120 may include, for example, an organic polymer material. For example, each of the first color filter 121, the second color filter 122, the third color filter 123, and the fourth color filter 124 may include a colorant, a binder resin, a polymer photoresist, etc. The first color filter 121 and the fourth color filter 124 may be organic color filters including a green organic dye or a green organic pigment as a colorant, the second color filter 122 may be an organic color filter including a blue organic dye or a blue organic pigment as a colorant, and the third color filter 123 may be an organic color filter including a red organic dye or a red organic pigment as a colorant. Although not shown in FIGS. 2A, 2B, and 6 for convenience, the color filter layer 120 may further include a black matrix provided boundaries between the first color filter 121, the second color filter 122, the third color filter 123, and the fourth color filter 124. The black matrix may include, for example, carbon black.

Referring back to FIGS. 2A and 2B, the spacer layer 130 provided between the color filter layer 120 and the nano-photonic lens array 140 may provide a flat surface for forming the nano-photonic lens array 140 on the spacer layer 130. The spacer layer 130 may include an organic polymer material that is suitable for being stacked on the color filter layer 120 including an organic material and is easy to form a flat surface. The organic polymer material forming the spacer layer 130 may have a transparent property with respect to visible light. For example, the spacer layer 130 may include at least one organic polymer material among epoxy resin, polyimide, polycarbonate, polyacrylate, or polymethyl methacrylate (PMMA). The spacer layer 130 may be formed on the color filter layer 120 by, for example, spin coating, and may have a flat upper surface through thermal treatment. However, the disclosure is not limited thereto, and as such, according to another embodiment, the spacer layer 130 may include an inorganic material. For example, the spacer layer 130 may include a dielectric material, such as siloxane-based spin on glass (SOG), SiO₂, Si₃N₄, Al₂O₃,etc., having a lower refractive index than nanostructures NP described below and a low absorption rate in a visible light band.

In addition, the spacer layer 130 may serve to keep a distance or a gap between the sensor substrate 110 and the nano-photonic lens array 140 constant. In addition, the spacer layer 130 may provide a sufficient distance for light to be color separated by the nano-photonic lens array 140. For example, the thickness of the spacer layer 130 may be about 0.25 times or more and about 0.5 times or less of the pitch of each pixel.

The nano-photonic lens array 140 may be provided on the spacer layer 130. Although FIG. 2A and FIG. 2B illustrate that the nano-photonic lens array 140 is directly provided on the spacer layer 130, an etch stop layer preventing the spacer layer 130 from being damaged in the process of forming the nano-photonic lens array 140 may be provided on the spacer layer 130, and the nano-photonic lens array 140 may be provided on the etch stop layer.

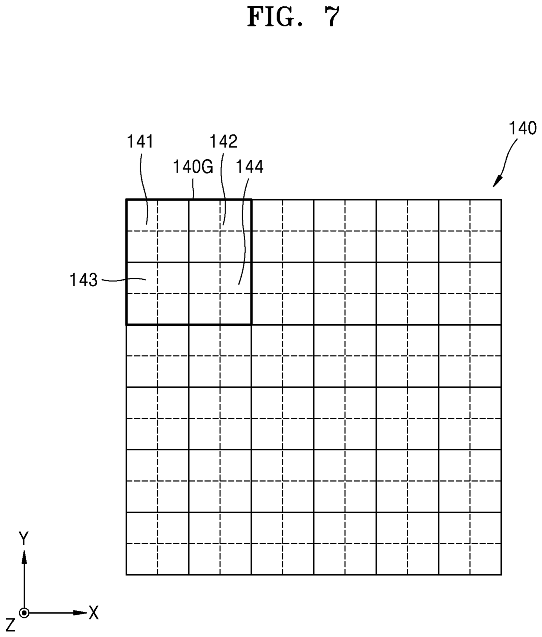

FIG. 7 shows an arrangement of meta-regions of the nano-photonic lens array 140 according to an embodiment. Referring to FIG. 7, the nano-photonic lens array 140 may include a plurality of unit meta-groups 140G arranged two-dimensionally in a first direction and a second direction. Each of the plurality of unit pixel groups 110G may include a first meta-region 141, a second meta-region 142, a third meta-region 143, and a fourth meta-region 144. The first meta-region 141, the second meta-region 142, the third meta-region 143, and the fourth meta-region 144 may be grouped and arranged in the form of a 2×2 array in the first direction and the second direction. For example, the first meta-region 141 may contact the second meta-region 142 in the first direction and the third meta-region 143 in the second direction. The second meta-region 142 may contact the fourth meta-region 144 in the second direction, and the third meta-region 143 may contact the fourth meta-region 144 in the first direction.

A plurality of first meta-regions 141 and a plurality of second meta-regions 142 may be alternately arranged in the first direction in one row on the nano-photonic lens array 140, and a plurality of third meta-regions 143 and a plurality of fourth meta-regions 144 may be alternately arranged in the first direction in a row having a different position in the second direction. In addition, the plurality of first meta-regions 141 and the plurality of fourth meta-regions 144 may be alternately arranged in a first diagonal direction, and the plurality of second meta-regions 142 and the plurality of third meta-regions 143 may be alternately arranged in a second diagonal direction crossing the first diagonal direction.

The first meta-region 141 may be provided to face the first pixel 111 and the first color filter 121 in the third direction. The second meta-region 142 may be provided to face the second pixel 112 and the second color filter 122 in the third direction. The third meta-region 143 may be provided to face the third pixel 113 and the third color filter 123 in the third direction. The fourth meta-region 144 may be provided to face the fourth pixel 114 and the fourth color filter 124 in the third direction.

The nano-photonic lens array 140 may be configured to separate light of the first wavelength band, in incident light incident on the nano-photonic lens array 140, and concentrate the separated light of the first wavelength band onto the first sub-pixel P1, the second sub-pixel P2, the third sub-pixel P3, and the fourth sub-pixel P4 of the first pixel 111 and the first sub-pixel P1, the second sub-pixel P2, the third sub-pixel P3, and the fourth sub-pixel P4 of the fourth pixel 114, separate light of the second wavelength band and concentrate the separated light of the second wavelength band onto the first sub-pixel P1, the second sub-pixel P2, the third sub-pixel P3, and the fourth sub-pixel P4 of the second pixel 112, and separate light of the third wavelength band and concentrate the separated light of the third wavelength band onto the first sub-pixel P1, the second sub-pixel P2, the third sub-pixel P3, and the fourth sub-pixel P4 of the third pixel 113. In other words, the nano-photonic lens array 140 may be configured to form four concentration regions in the first pixel 111 with respect to the light of the first wavelength band, form four concentration regions in the fourth pixel 114 with respect to the light of the first wavelength band, form four concentration regions in the second pixel 112 with respect to the light of the second wavelength band, and form four concentration regions in the third pixel 113 with respect to the light of the third wavelength band.

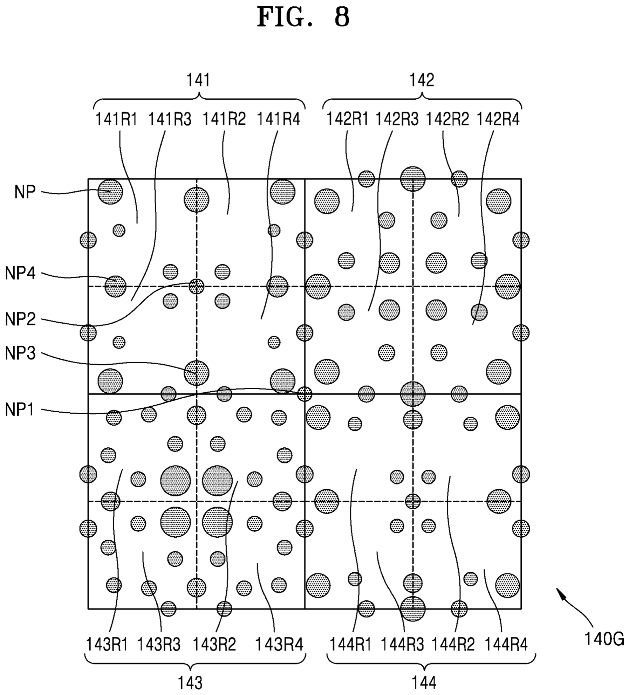

The nano-photonic lens array 140 may include a plurality of nanostructures NP configured to perform the above-described operations. In addition, the nano-photonic lens array 140 may further include a dielectric material DL filled between the plurality of nanostructures NP. FIG. 8 shows an arrangement of the plurality of nanostructures NP in the unit meta-group 140G of the nano-photonic lens array 140 according to an embodiment.

Referring to FIG. 8, each of the first meta-region 141, the second meta-region 142, the third meta-region 143, and the fourth meta-region 144 may include a plurality of sub-regions which are grouped and two-dimensionally arranged in the form of a 2×2 array in a first direction and a second direction. For example, the first meta-region 141 may include a first sub-region 141R1, a second sub-region 141R2, a third sub-region 141R3, and a fourth sub-region 141R4 that are grouped and two-dimensionally arranged in the form of a 2×2 array. The first sub-region 141R1 may be adjacent to the second sub-region 141R2 in the first direction and the third sub-region 141R3 in the second direction, the second sub-region 141R2 may be adjacent to the fourth sub-region 141R4 in the second direction, and the third sub-region 141R3 may be adjacent to the fourth sub-region 141R4 in the first direction. The first sub-region 141R1 may contact the second sub-region 141R2 in the first direction and the third sub-region 141R3 in the second direction, the second sub-region 141R2 may contact the fourth sub-region 141R4 in the second direction, and the third sub-region 141R3 may contact the fourth sub-region 141R4 in the first direction. In addition, the second meta-region 142 may include a first sub-region 142R1, a second sub-region 142R2, a third sub-region 142R3, and a fourth sub-region 142R4 which are grouped and two-dimensionally arranged in the form of a 2×2 array. The third meta-region 143 may include a first sub-region 143R1, a second sub-region 143R2, a third sub-region 143R3, and a fourth sub-region 143R4 which are grouped and two-dimensionally arranged in the form of a 2×2 array. In addition, the fourth meta-region 144 may include a first sub-region 144R1, a second sub-region 144R2, a third sub-region 144R3, and a fourth sub-region 144R4 which are grouped and two-dimensionally arranged in the form of a 2×2 array.

The first sub-region 141R1, the second sub-region 141R2, the third sub-region 141R3, and the fourth sub-region 141R4 of the first meta-region 141 may be provided to respectively face the first sub-pixel P1, the second sub-pixel P2, the third sub-pixel P3, and the fourth sub-pixel P4 of the first pixel 111 in a third direction. The first sub-region 142R1, the second sub-region 142R2, the third sub-region 142R3, and the fourth sub-region 142R4 of the second meta-region 142 may be provided to respectively face the first sub-pixel P1, the second sub-pixel P2, the third sub-pixel P3, and the fourth sub-pixel P4 of the second pixel 112 in the third direction. The first sub-region 143R1, the second sub-region 143R2, the third sub-region 143R3, and the fourth sub-region 143R4 of the third meta-region 143 may be provided to respectively face the first sub-pixel P1, the second sub-pixel P2, the third sub-pixel P3, and the fourth sub-pixel P4 of the third pixel 113 in the third direction. In addition, the first sub-region 144R1, the second sub-region 144R2, the third sub-region 144R3, and the fourth sub-region 144R4 of the fourth meta-region 144 may be provided to respectively face the first sub-pixel P1, the second sub-pixel P2, the third sub-pixel P3, and the fourth sub-pixel P4 of the fourth pixel 114 in the third direction.

The first meta-region 141, the second meta-region 142, the third meta-region 143, and the fourth meta-region 144 of the nano-photonic lens array 140 may each include the plurality of nanostructures NP arranged according to a certain rule to concentrate color-separated light as described above, respectively in the first sub-pixel P1, the second sub-pixel P2, the third sub-pixel P3, and the fourth sub-pixel P4 of first pixel 111, the second pixel 112, the third pixel 113, and the fourth pixel 114 of the sensor substrate 110. In addition, each of the first sub-region 141R1, the second sub-region 141R2, the third sub-region 141R3, and the fourth sub-region 141R4 of the first meta-region 141, the first sub-region 142R1, the second sub-region 142R2, the third sub-region 142R3, and the fourth sub-region 142R4 of the second meta-region 142, the first sub-region 143R1, the second sub-region 143R2, the third sub-region 143R3, and the fourth sub-region 143R4 of the third meta-region 143, and the first sub-region 144R1, the second sub-region 144R2, the third sub-region 144R3, and the fourth sub-region 144R4 of the fourth meta-region 144 may include the at least one nanostructure NP.

The plurality of nanostructures NP may be arranged to change a phase of transmitted light passing through the nano-photonic lens array 140 differently according to a position on the nano-photonic lens array 140. A phase profile of the transmitted light implemented by the nano-photonic lens array 140 may be determined according to a dimension of each nanostructure NP, a cross-sectional shape, and height, and an arrangement form of the plurality of nanostructures NP. For example, the dimension may be cross-sectional width or cross-sectional diameter. In addition, the behavior of light transmitted through the nano-photonic lens array 140 may be determined according to the phase profile of the transmitted light. For example, the plurality of nanostructures NP may be arranged to form a phase profile such that the light transmitted through the nano-photonic lens array 140 is separated according to wavelengths and respectively concentrated onto sub-pixels of the corresponding pixels.

The nanostructure NP may be such that a dimension (e.g., cross-sectional width or cross-sectional diameter) has a dimension of a sub-wavelength. The sub-wavelength refers to a wavelength smaller than a wavelength band of light concentrated by the nano-photonic lens array 140. In an example case in which incident light is visible light, the diameter of the cross section of the nanostructure NP may have, for example, a dimension less than 400 nm, 300 nm, or 200 nm. The height of the nanostructure NP may be about 300 nm to about 1500 nm, and may be greater than the diameter of the cross section.

The nanostructure NP may include a material having a relatively high refractive index and a relatively low absorption rate in a visible light band compared to a peripheral material. For example, the nanostructure NP may include c-Si, p-Si, a-Si, a III-V compound semiconductor (GaP, GaN, GaAs, etc.), SiC, TiO₂, SiN₃, ZnS, ZnSe, Si₃N₄ and/or combinations thereof. The periphery of the nanostructure NP may be filled with a dielectric material DL having a relatively low refractive index and a relatively low absorption rate in the visible light band compared to the nanostructure NP. For example, the periphery of the nanostructure NP may be filled with SOG, SiO₂, Si₃N₄, Al₂O₃, air, etc.

The refractive index of the high refractive index nanostructure NP may be about 2.0 or more with respect to light having a wavelength of about 630 nm, and the refractive index of the low refractive index dielectric material DL may be about 1.0 or more and less than about 2.0 with respect to the light having the wavelength of about 630 nm. In addition, a difference between the refractive index of the nanostructure NP and the refractive index of the dielectric material DL may be about 0.5 or more. The nanostructure NP having a refractive index difference from the peripheral material may change a phase of light passing through the nanostructure NP. This is due to phase delay caused by shape dimensions of sub-wavelengths of the nanostructures NP, and a degree of phase delay is determined according to detailed shape dimensions, an arrangement form, etc. of the nanostructures NP.

In the example shown in FIG. 8, the plurality of nanostructures NP may be arranged in the first meta-region 141 in a 2-fold symmetry structure. In other words, the plurality of nanostructures NP within the first meta-region 141 may be arranged to have mirror symmetry in the first direction and the second direction with respect to the center of the first meta-region 141. In addition, the nanostructures NP in the first sub-region 141R1, the second sub-region 141R2, the third sub-region 141R3, and the fourth sub-region 141R4 may be arranged to have mirror symmetry with the nanostructures NP in other sub-regions adjacent in the first direction or the second direction with respect to a boundary with the other sub-regions adjacent in the first direction or the second direction.

For example, the nanostructures NP in the first sub-region 141R1 of the first meta-region 141 and the nanostructures NP in the second sub-region 141R2 may be arranged to have mirror symmetry with respect to a boundary between the first sub-region 141R1 and the second sub-region 141R2. The nanostructures NP in the first sub-region 141R1 and the nanostructures NP in the third sub-region 141R3 may be arranged to have mirror symmetry with respect to a boundary between the first sub-region 141R1 and the third sub-region 141R3. The nanostructures NP in the second sub-region 141R2 and the nanostructures NP in the fourth sub-region 141R4 may be arranged to have mirror symmetry with respect to a boundary between the second sub-region 141R2 and the fourth sub-region 141R4. In addition, the nanostructures NP in the third sub-region 141R3 and the nanostructures NP in the fourth sub-region 141R4 may be arranged to have mirror symmetry with respect to a boundary between the third sub-region 141R3 and the fourth sub-region 141R4.

In addition, the nanostructures NP in sub-regions facing in a diagonal direction within the first meta-region 141 may be arranged to have rotational symmetry with respect to the center of the first meta-region 141. For example, the nanostructures NP in the first sub-region 141R1 and the nanostructures NP in the fourth sub-region 141R4 may be arranged to have 180 degrees rotational symmetry with respect to the center of the first meta-region 141. The nanostructures NP in the second sub-region 141R2 and the nanostructures NP in the third sub-region 141R3 may be arranged to have 180 degrees rotational symmetry with respect to the center of the first meta-region 141.

The plurality of nanostructures NP arranged in the second meta-region 142 may be arranged in a 4-fold symmetry structure. In other words, the plurality of nanostructures NP within the second meta-region 142 may be arranged to have mirror symmetry in all of the first direction, the second direction, and two diagonal directions with respect to the center of the second meta-region 142. In addition, the nanostructures NP in the first sub-region 142R1, the second sub-region 142R2, the third sub-region 142R3, and the fourth sub-region 142R4 may be arranged to have mirror symmetry with the nanostructures NP in other sub-regions adjacent in the first direction or second direction with respect to the boundary with the other sub-regions adjacent in the first direction or second direction.

For example, the nanostructures NP in the first sub-region 142R1 of the second meta-region 142 and the nanostructures NP in the second sub-region 142R2 may be arranged to have mirror symmetry with respect to the boundary between the first sub-region 142R1 and the second sub-region 142R2. The nanostructures NP in the first sub-region 142R1 and the nanostructures NP in the third sub-region 142R3 may be arranged to have mirror symmetry with respect to a boundary between the first sub-region 142R1 and the third sub-region 142R3. The nanostructures NP in the second sub-region 142R2 and the nanostructures NP in the fourth sub-region 142R4 may be arranged to have mirror symmetry with respect to the boundary between the second sub-region 142R2 and the fourth sub-region 142R4. In addition, the nanostructures NP in the third sub-region 142R3 and the nanostructures NP in the fourth sub-region 142R4 may be arranged to have mirror symmetry with respect to the boundary between the third sub-region 142R3 and the fourth sub-region 142R4.

In addition, the nanostructures NP in sub-regions facing in the diagonal direction within the second meta-region 142 may be arranged to have mirror symmetry with respect to the center of the second meta-region 142. For example, the nanostructures NP in the first sub-region 142R1 and the nanostructures NP in the fourth sub-region 142R4 may be arranged to have mirror symmetry with respect to the center of the second meta-region 142. The nanostructures NP in the second sub-region 142R2 and the nanostructures NP in the third sub-region 142R3 may be arranged to have mirror symmetry with respect to the center of the second meta-region 142.

The plurality of nanostructures NP arranged in the third meta-region 143 may be arranged in the 4-fold symmetry structure. In other words, the plurality of nanostructures NP within the third meta-region 143 may be arranged to have mirror symmetry in all of the first direction, the second direction, and the two diagonal directions with respect to the center of the third meta-region 143. In addition, the nanostructures NP in the first sub-region 143R1, the second sub-region 143R2, the third sub-region 143R3, and the fourth sub-region 143R4 may be arranged to have mirror symmetry with the nanostructures NP in other sub-regions adjacent in the first direction or the second direction with respect to the boundary with the other sub-regions adjacent in the first direction or the second direction.

For example, the nanostructures NP in the first sub-region 143R1 of the third meta-region 143 and the nanostructures NP in the second sub-region 143R2 may be arranged to have mirror symmetry with respect to the boundary between the first sub-region 143R1 and the second sub-region 143R2. The nanostructures NP in the first sub-region 143R1 and the nanostructures NP in the third sub-region 143R3 may be arranged to have mirror symmetry with respect to the boundary between the first sub-region 143R1 and the third sub-region 143R3. The nanostructures NP in the second sub-region 143R2 and the nanostructures NP in the fourth sub-region 143R4 may be arranged to have mirror symmetry with respect to the boundary between the second sub-region 143R2 and the fourth sub-region 143R4. In addition, the nanostructures NP in the third sub-region 143R3 and the nanostructures NP in the fourth sub-region 143R4 may be arranged to have mirror symmetry with respect to the boundary between the third sub-region 143R3 and the fourth sub-region 143R4.

In addition, the nanostructures NP in sub-regions facing in the diagonal direction within the third meta-region 143 may be arranged to have mirror symmetry with respect to the center of the third meta-region 143. For example, the nanostructures NP in the first sub-region 143R1 and the nanostructures NP in the fourth sub-region 143R4 may be arranged to have mirror symmetry with respect to the center of the third meta-region 143. The nanostructures NP in the second sub-region 143R2 and the nanostructures NP in the third sub-region 143R3 may be arranged to have mirror symmetry with respect to the center of the third meta-region 143.

The size and arrangement of the plurality of nanostructures NP in the third meta-region 143 may be different from the size and arrangement of the plurality of nanostructures NP in the second meta-region 142. For example, the cross-sectional diameter of the nanostructure NP provided near the center of the second meta-region 142 may be different from the diameter of the nanostructure NP provided near the center of the third meta-region 143. In addition, the number of nanostructures NP arranged in the second meta-region 142 and the number of nanostructures NP arranged in the third meta-region 143 may be different from each other. The positions of the nanostructures NP within the second meta-region 142 and the third meta-region 143 may also be different.

The plurality of nanostructures NP arranged in the fourth meta-region 144 may be arranged in a 2-fold symmetry structure. In other words, the plurality of nanostructures NP within the fourth meta-region 144 may be arranged to have mirror symmetry in the first direction and the second direction with respect to the center of the fourth meta-region 144. In addition, the nanostructures NP in the first sub-region 144R1, the second sub-region 144R2, the third sub-region 144R3, and the fourth sub-region 144R4 may be arranged to have mirror symmetry with the nanostructures NP in other sub-regions adjacent in the first direction or the second direction with respect to the boundary with the other sub-regions adjacent in the first direction or the second direction.

For example, the nanostructures NP in the first sub-region 144R1 of the fourth meta-region 144 and the nanostructures NP in the second sub-region 144R2 may be arranged to have mirror symmetry with respect to the boundary between the first sub-region 144R1 and the second sub-region 144R2. The nanostructures NP in the first sub-region 144R1 and the nanostructures NP in the third sub-region 144R3 may be arranged to have mirror symmetry with respect to the boundary between the first sub-region 144R1 and the third sub-region 144R3. The nanostructures NP in the second sub-region 144R2 and the nanostructures NP in the fourth sub-region 144R4 may be arranged to have mirror symmetry with respect to the boundary between the second sub-region 144R2 and the fourth sub-region 144R4. In addition, the nanostructures NP in the third sub-region 144R3 and the nanostructures NP in the fourth sub-region 144R4 may be arranged to have mirror symmetry with each other with respect to the boundary between the third sub-region 144R3 and the fourth sub-region 144R4.

In addition, the nanostructures NP in sub-regions facing in the diagonal direction within the fourth meta-region 144 may be arranged to have rotational symmetry with respect to the center of the fourth meta-region 144. For example, the nanostructures NP in the first sub-region 144R1 and the nanostructures NP in the fourth sub-region 144R4 may be arranged to have 180 degrees rotational symmetry with each other with respect to the center of the fourth meta-region 144. The nanostructures NP in the second sub-region 144R2 and the nanostructures NP in the third sub-region 144R3 may be arranged to have 180 degrees rotational symmetry with respect to the center of the fourth meta-region 144. For example, the arrangement form of the plurality of nanostructures NP in the fourth meta-region 144 is rotated by 90 degrees with respect to the arrangement form of the plurality of nanostructures NP in the first meta-region 141.

FIG. 8 shows that the nanostructures NP have cylindrical shapes, but the cross-sectional shapes of the nanostructures NP are not limited thereto. According to the design of the nano-photonic lens array 140, the nanostructures NP may have pillar shapes having various cross sections such as rectangular shapes, triangular shapes, cross shapes, or elliptical shapes.

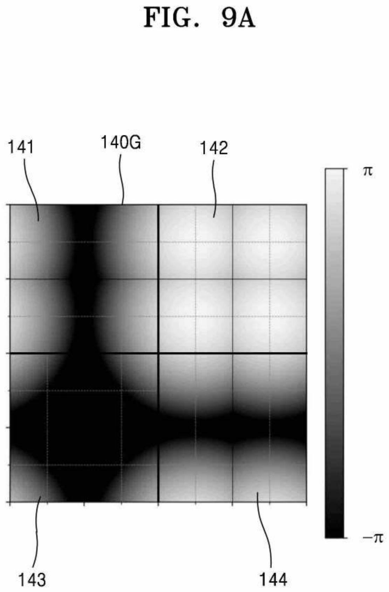

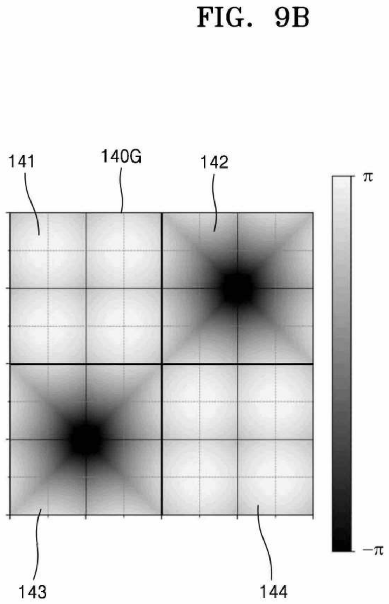

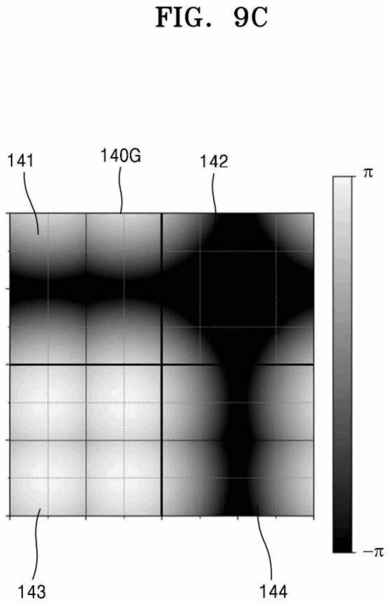

FIG. 9A shows a phase profile of blue light passing through the nano-photonic lens array 140, FIG. 9B shows a phase profile of green light passing through the nano-photonic lens array 140, and FIG. 9C shows a phase profile of red light passing through the nano-photonic lens array 140. FIGS. 9A, 9B, and 9C illustrate only one unit meta-group 140G for convenience.

Referring to FIG. 9A, a phase delay of blue light in the transmitted light may be the greatest in the second meta-region 142, at a position immediately after the incident light passes through the nano-photonic lens array 140, that is, at a lower surface of the nano-photonic lens array 140. For example, the phase delay of blue light may be the greatest at the center of each of the first sub-region 142R1, the second sub-region 142R2, the third sub-region 142R3, and the fourth sub-region 142R4 of the second meta-region 142. The phase delay of blue light may decrease away from the center of each of the first sub-region 142R1, the second sub-region 142R2, the third sub-region 142R3, and the fourth sub-region 142R4 of the second meta-region 142, and may be the smallest at the center of the third meta-region 143.

Referring to FIG. 9B, a phase delay of green light in the transmitted light may be the greatest in the first meta-region 141 and the fourth meta-region 144, at the position immediately after the incident light passes through the nano-photonic lens array 140, that is, at the lower surface of the nano-photonic lens array 140. For example, the phase delay of green light may be the greatest at the center of each of the first sub-region 141R1, the second sub-region 141R2, the third sub-region 141R3 and the fourth sub-region 141R4 of the first meta-region 141, and at the center of each of the first sub-region 144R1, the second sub-region 144R2, the third sub-region 144R3, and the fourth sub-region 144R4 of the fourth meta-region 144. The phase delay of green light may decrease away from the center of each of the first sub-region 141R1, the second sub-region 141R2, the third sub-region 141R3, and the fourth sub-region 141R4 of the first meta-region 141R1 of the first meta-region 141, and from the center of each of the first sub-region 144R1, the second sub-region 144R2, the third sub-region 144R3, and the fourth sub-region 144R4 of the fourth meta-region 144, and may be the smallest at the center of the second meta-region 142 and the center of the third meta-region 143.

Referring to FIG. 9C, a phase delay of red light in the transmitted light may be the greatest in the third meta-region 143, at the position immediately after the incident light passes through the nano-photonic lens array 140, that is, at the lower surface of the nano-photonic lens array 140. For example, the phase delay of red light may be the greatest at the center of each of the first sub-region 143R1, the second sub-region 143R2, the third sub-region 143R3, and the fourth sub-region 143R4 of the third meta-region 143. The phase delay of red light may decrease away from the center of each of the first sub-region 143R1, the second sub-region 143R2, the third sub-region 143R3, and the fourth sub-region 143R4 of the third meta-region 143 and may be the smallest at the center of the second meta-region 142.

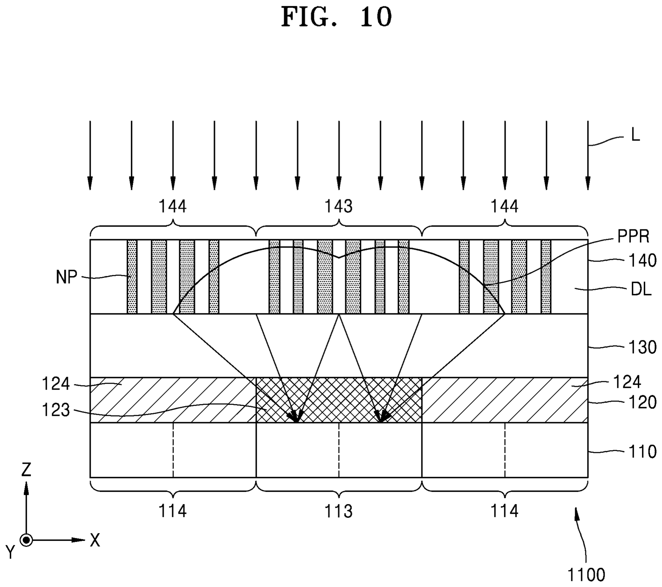

FIG. 10 is a cross-sectional view showing a phase profile and a concentration action of red light by the nano-photonic lens array 140 according to an embodiment. Referring to FIG. 10, the red light passing through the nano-photonic lens array 140 in light L incident on the nano-photonic lens array 140 may have a red light phase profile PPR having two peaks within the third meta-region 143 and being the smallest at the center of the fourth meta-region 144 in a first direction. Although not shown in the cross-sectional view of FIG. 10, the red light phase profile PPR may have two other peaks in a cross-section different in a second direction. Such four phase delay peaks of the red light phase profile PPR may serve as four convex lenses with respect to the red light to respectively form four red light concentration regions in the third pixel 113. For example, the red light concentration regions may be respectively formed near the centers of the first sub-pixel P1, the second sub-pixel P2, the third sub-pixel P3, and the fourth sub-pixel P4 of the third pixel 113 respectively facing the first sub-region 143R1, the second sub-region 143R2, the third sub-region 143R3, and the fourth sub-region 143R4. According to an embodiment, not only red light incident on the third meta-region 143 but also red light incident on other meta-regions adjacent to the third meta-region 143 may be concentrated onto the third pixel 113.

According to an embodiment, a principle or a feature similar to that of the phase profile of red light illustrated in FIG. 10 may be applied to a phase profile of blue light and a phase profile of green light by the nano-photonic lens array 140. For example, not only green light incident on the first meta-region 141 but also green light incident on other meta-regions adjacent to the first meta-region 141 may be concentrated onto each of the four sub-pixels of the first pixel 111, not only blue light incident on the second meta-region 142 but also blue light incident on other meta-regions adjacent to the second meta-region 142 may be concentrated onto each of the four sub-pixels of the second pixel 112, and not only green light incident on the fourth meta-region 144 but also green light incident on other meta-regions adjacent to the fourth meta-region 144 may be concentrated onto each of the four sub-pixels of the fourth pixel 114.

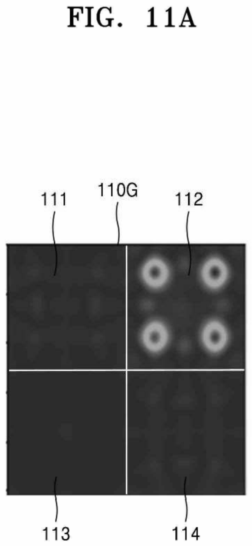

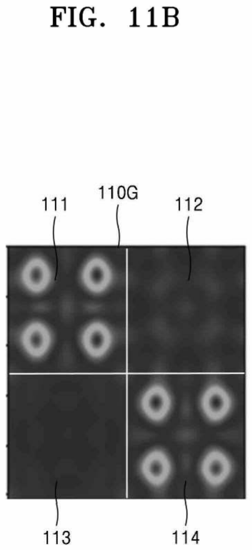

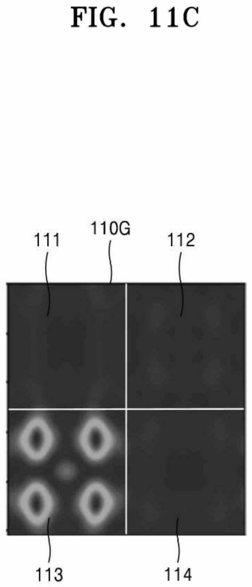

FIG. 11A shows concentration regions of blue light formed on the sensor substrate 110, FIG. 11B shows concentration regions of green light formed on the sensor substrate 110, and FIG. 11C shows concentration regions of red light formed on the sensor substrate 110. FIGS. 11A, 11B, and 11C illustrate only one unit pixel group 110G for convenience. Referring to FIGS. 11A, 11B, and 11C, the nano-photonic lens array 140 may form four green light concentration regions in the first pixel 111, four blue light concentration regions in the second pixel 112, four red light concentration regions in the third pixel 113, and four green light concentration regions in the fourth pixel 114. For example, the nano-photonic lens array 140 may form concentration regions at the centers of the first sub-pixel P1, the second sub-pixel P2, the third sub-pixel P3, and the fourth sub-pixel P4 of the first pixel 111, the second pixel 112, the third pixel 113, and the fourth pixel 114. In addition, an average position of the four concentration regions in each of the first pixel 111, the second pixel 112, the third pixel 113, and the fourth pixel 114 may coincide with the center of each of the first pixel 111, the second pixel 112, the third pixel 113, and the fourth pixel 114. In other words, the four concentration regions in each of the first pixel 111, the second pixel 112, the third pixel 113, and the fourth pixel 114 may be located at the same distance from the center of each of the first pixel 111, the second pixel 112, the third pixel 113, and the fourth pixel 114. The image sensor 1000 according to the embodiment may have improved light utilization efficiency because the nano-photonic lens array 140 color-separates incident light and concentrates the color-separated light onto sub-pixels of each pixel without absorbing or reflecting the incident light.

Meanwhile, FIG. 2A, FIG. 2B, and FIG. 10 show a cross section at the center portion of the nano-photonic lens array 140 in which the incident light is perpendicularly incident on the nano-photonic lens array 140, that is, a chief ray angle (CRA) is 0 degrees. According to an embodiment, boundaries of the first pixel 111, the first color filter 121, and the first meta-region 141 facing each other in a third direction at the center portion of the image sensor 1000, the center portion of the pixel array 1100, or the center portion of the nano-photonic lens array 140 in which the incident light is perpendicularly incident may coincide with each other in a first direction and a second direction. Likewise, boundaries of the second pixel 112, the second color filter 122, and the second meta-region 142 facing each other in the third direction at the center portion of the nano-photonic lens array 140 may coincide with each other in the first direction and the second direction, and boundaries of the third pixel 113, the third color filter 123, and the third meta-region 143 facing each other in the third direction may coincide with each other in the first direction and the second direction, and boundaries of the fourth pixel 114, the fourth color filter 124, and the fourth meta-region 144 facing each other in the third direction may coincide with each other in the first direction and the second direction.

According to an embodiment, at the periphery of the nano-photonic lens array 140 in which incident light is obliquely incident on the nano-photonic lens array 140, in order to compensate for a phase delay change according to an incident angle and prevent or reduce decreases in image quality, sensitivity, and autofocus characteristics, the first meta-region 141, the second meta-region 142, the third meta-region 143, and the fourth meta-region 144 of the nano-photonic lens array 140 may be shifted. For example, the first meta-region 141, the second meta-region 142, the third meta-region 143, and the fourth meta-region 144 of the nano-photonic lens array 140 may be shifted toward the center of the nano-photonic lens array 140 with respect to the first pixel 111, the second pixel 112, the third pixel 113, and the fourth pixel 114 corresponding thereto. For example, the first meta-region 141 may be shifted toward the center of the nano-photonic lens array 140 with respect to the first pixel 111, the second meta-region 142 may be shifted toward the center of the nano-photonic lens array 140 with respect to the second pixel 112, the third meta-region 143 may be shifted toward the center of the nano-photonic lens array 140 with respect to the third pixel 113 and the fourth meta-region 144 may be shifted toward the center of the nano-photonic lens array 140 with respect to the fourth pixel 114.

Here, the periphery may be defined as all regions in which the CRA of incident light is greater than 0 degrees, but is not limited thereto. Considering the convenience of the manufacturing process, a partial region near the center of the nano-photonic lens array 140 may be defined as the center portion even though the CRA of incident light is not completely 0 degrees. For example, a region in which the CRA of incident light is within 5 degrees may be defined as the center portion of the nano-photonic lens array 140, and a region in which the CRA of incident light is greater than 5 degrees may be defined as the periphery of the nano-photonic lens array 140. However, the disclosure is not limited thereto, and as such, according to another embodiment, a region in which the CRA of incident light is within 10 degrees may be defined as the center portion of the nano-photonic lens array 140, and a region in which the CRA of incident light is greater than 10 degrees may be defined as the periphery of the nano-photonic lens array 140. The CRA of incident light for determining the center portion and the periphery may be determined differently according to optical characteristics of the nano-photonic lens array 140 according to the design of the nanostructures NP of the nano-photonic lens array 140.

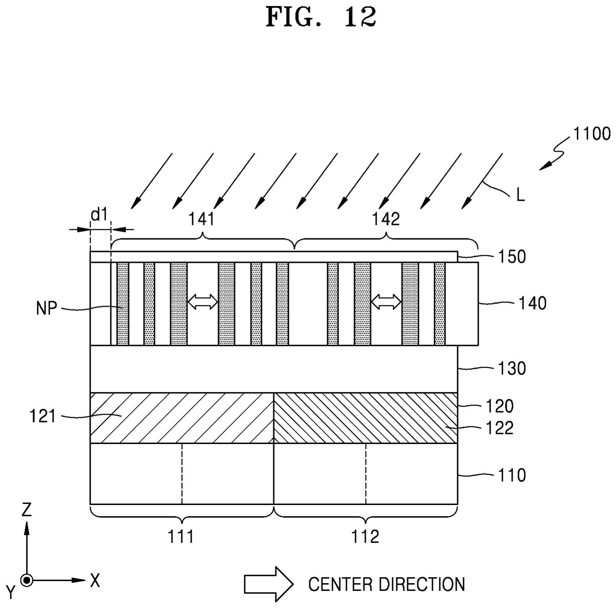

FIG. 12 is a cross-sectional view of shifts of meta-regions of the nano-photonic lens array 140 at the periphery of the nano-photonic lens array 140. Referring to FIG. 12, the first meta-region 141, the second meta-region 142, the third meta-region 143, and the fourth meta-region 144 of the nano-photonic lens array 140 may be shifted in a direction in which light is incident with respect to the first pixel 111, the second pixel 112, the third pixel 113, and the fourth pixel 114 corresponding thereto, at the periphery of the nano-photonic lens array 140 or the periphery of the pixel array 1100 in which the incident light L is obliquely incident. In other words, the first meta-region 141, the second meta-region 142, the third meta-region 143, and the fourth meta-region 144 of the nano-photonic lens array 140 may be shifted toward the center of the pixel array 1100 or the center of the nano-photonic lens array 140 with respect to the first pixel 111, the second pixel 112, the third pixel 113, and the fourth pixel 114 corresponding thereto.

For example, the first meta-region 141, the second meta-region 142, the third meta-region 143, and the fourth meta-region 144 of the nano-photonic lens array 140 may be shifted by a first distance d1 toward the center of the nano-photonic lens array 140 or the center of the pixel array 1100 with respect to the first pixel 111, the second pixel 112, the third pixel 113, and the fourth pixel 114 corresponding thereto. Therefore, boundaries of the corresponding pixels and meta-regions do not coincide with each other in a first direction and a second direction at the periphery of the nano-photonic lens array 140 or the periphery of the pixel array 1100.

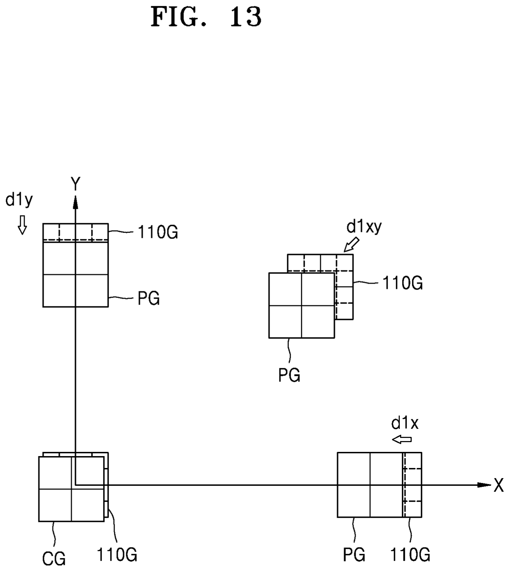

FIG. 13 shows shift directions of unit meta-groups of the nano-photonic lens array 140 according to a position of an azimuth angle at the periphery of the nano-photonic lens array 140. FIG. 13 illustrates the central meta group CG and the unit pixel group 110G in an oblique direction for convenience such that both the central meta group CG and the unit pixel group 110G are shown. The unit meta-groups of the nano-photonic lens array 140 may be classified into a central meta-group CG and a peripheral meta-group PG according to a position on the nano-photonic lens array 140. The central meta-group CG may be defined as a unit meta-group located at the center portion of the nano-photonic lens array 140, and the peripheral meta-group PG may be defined as a unit meta-group of the periphery spaced apart from the center portion of the nano-photonic lens array 140. Although FIG. 13 shows one central meta-group CG, a plurality of central meta-groups CG may exist according to the design of the nano-photonic lens array 140.

Referring to FIG. 13, the central meta-group CG among the unit meta-groups of the nano-photonic lens array 140 may coincide and be aligned with a unit pixel group 110G facing the central meta-group CG. In other words, the first meta-region 141, the second meta-region 142, the third meta-region 143, and the fourth meta-region 144 of the central meta-group CG may respectively coincide and be aligned with the first pixel 111, the second pixel 112, the third pixel 113, and the fourth pixel 114 corresponding thereto of the unit pixel group 110G.

The peripheral meta-group PG may be shifted from the unit pixel group 110G corresponding thereto. The shift direction may be a direction toward the center of the nano-photonic lens array 140. For example, the peripheral meta-group PG spaced apart from the center of the nano-photonic lens array 140 in a first direction may be shifted by a first distance d1x in the first direction toward the center of the nano-photonic lens array 140 in the first direction. In addition, the peripheral meta-group PG spaced apart from the center of the nano-photonic lens array 140 in a second direction may be shifted by a first distance d1y in the second direction toward the center of the nano-photonic lens array 140 in the second direction. The peripheral meta-groups PG spaced apart from the center of the nano-photonic lens array 140 in a diagonal direction may be shifted by a first distance d1xy in the diagonal direction toward the center of the nano-photonic lens array 140 in the diagonal direction.

The greater the CRA of incident light, e.g., the greater the distance from the center of the nano-optical lens array 140, the greater the distance by which the peripheral meta-group PG is shifted from the corresponding unit pixel group 110G. For example, a first distance d1 by which the peripheral meta-group PG is shifted from the corresponding unit pixel group 110G at the periphery of the nano-photonic lens array 140 may be expressed as follows. $d 1 = h \times tan \left(CRA′\right)$

Here, h is the shortest straight line distance in a third direction between a lower surface of the nano-photonic lens array 140 and an upper surface of the sensor substrate 110. Therefore, the first distance d1 may be proportional to a distance between the nano-photonic lens array 140 and the sensor substrate 110 in the third direction. A CRA' denotes an incident angle of light incident on the sensor substrate 110. In an example case in which an incident angle of light incident on the nano-photonic lens array 140 is a CRA, the CRA' may be expressed as follows. $CRA ′ = {sin}^{- 1} \left(n\times sin CRA\right)$

Here, n denotes an average effective refractive index of layers provided between the nano-photonic lens array 140 and the sensor substrate 110.

The peripheral meta-group PG is shifted by the first distance d1 toward the center of the nano-photonic lens array 140 with respect to the corresponding unit pixel group 110G at the periphery of the nano-photonic lens array 140, and thus color separation may be efficiently performed even at a position where the CRA is large. Accordingly, a deviation in the color separation efficiency in the center portion and periphery of the nano-photonic lens array 140 may be reduced.

Meanwhile, diffraction characteristics and refractive characteristics of light passing through the nano-photonic lens array 140 may vary depending on a wavelength of light. As a result, an average position of four concentration regions formed in each of the first pixel 111, the second pixel 112, the third pixel 113, and the fourth pixel 114 at the periphery of the sensor substrate 110 may deviate from the center of each of the first pixel 111, the second pixel 112, the third pixel 113, and the fourth pixel 114. In addition, a distance and a direction in which the average positions of the four concentration regions are spaced apart from the center of each of the first pixel 111, the second pixel 112, the third pixel 113, and the fourth pixel 114 may vary for each of the first pixel 111, the second pixel 112, the third pixel 113, and the fourth pixel 114. According to an embodiment, the first meta-region 141, the second meta-region 142, the third meta-region 143, and the fourth meta-region 144 corresponding to pixels of different colors in the peripheral meta-group PG may be individually shifted by different distances in different directions to alleviate chromatic aberration in consideration of a characteristic difference according to a wavelength of incident light.

In an example case in which a concentration region is formed in each of the first sub-pixel P1, the second sub-pixel P2, the third sub-pixel P3, and the fourth sub-pixel P4 of the first pixel 111, the second pixel 112, the third pixel 113, and the fourth pixel 114, the concentration region may deviate from the center of each of the first sub-pixel P1, the second sub-pixel P2, the third sub-pixel P3, and the fourth sub-pixel P4 at the periphery of the sensor substrate 110. According to an embodiment, four sub-regions of each of the first meta-region 141, the second meta-region 142, the third meta-region 143, and the fourth meta-region 144 of the peripheral meta-group PG may be individually shifted such that the concentration region may be accurately formed at the center of each of the first sub-pixel P1, the second sub-pixel P2, the third sub-pixel P3, and the fourth sub-pixel P4 even at the periphery of the sensor substrate 110.

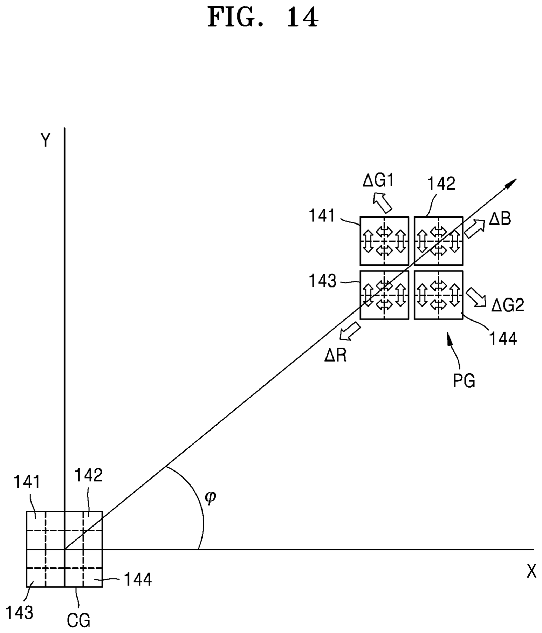

FIG. 14 shows shifts of individual meta-regions within the peripheral meta-group PG of the periphery of the nano-photonic lens array 140. Referring to FIG. 14, the relative position relationship between the first meta-region 141, the second meta-region 142, the third meta-region 143, and the fourth meta-region 144 in the peripheral meta-group PG may be different from the relative position relationship between the first meta-region 141, the second meta-region 142, the third meta-region 143, and the fourth meta-region 144 of the central meta-group CG. For example, the first meta-region 141, the second meta-region 142, the third meta-region 143, and the fourth meta-region 144 in the peripheral meta-group PG may be shifted in a first direction and/or a second direction compared to the first meta-region 141, the second meta-region 142, the third meta-region 143, and the fourth meta-region 144 in the central meta-group CG. Therefore, a gap between the first meta-region 141 and the second meta-region 142, a gap between the first meta-region 141 and the third meta-region 143, a gap between the second meta-region 142 and the fourth meta-region 144, and a gap between the third meta-region 143 and the fourth meta-region 144 within the central meta-group CG may be respectively different from a gap between the first meta-region 141 and the second meta-region 142, a gap between the first meta-region 141 and the third meta-region 143, a gap between the second meta-region 142 and the fourth meta-region 144, and a gap between the third meta-region 143 and the fourth meta-region 144 in the peripheral meta-group PG. For example, gap between the first meta-region 141 and the second meta-region 142 in the central meta-group CG may be different from a gap between the first meta-region 141 and the second meta-region 142 in the peripheral meta-group PG, a gap between the first meta-region 141 and the third meta-region 143 in the central meta-group CG may be different from a gap between the first meta-region 141 and the third meta-region 143 in the peripheral meta-group PG, a gap between the second meta-region 142 and the fourth meta-region 144 in the central meta-group CG may be different from a gap between the second meta-region 142 and the fourth meta-region 144 in the peripheral meta-group PG, and a gap between the third meta-region 143 and the fourth meta-region 144 in the central meta-group CG may be different from a gap between the third meta-region 143 and the fourth meta-region 144 in the peripheral meta-group PG.

In other words, the gap between the first meta-region 141 and the second meta-region 142 in the central meta-group CG and the gap between the first meta-region 141 and the second meta-region 142 in the peripheral meta-group PG may be different from each other, the gap between the first meta-region 141 and the third meta-region 143 in the central meta-group CG and the gap between the first meta-region 141 and the third meta-region 143 in the peripheral meta-group PG may be different from each other, the gap between the second meta-region 142 and the fourth meta-region 144 in the central meta-group CG and the gap between the second meta-region 142 and the fourth meta-region 144 in the peripheral meta-group PG may be different from each other, and/or the gap between the third meta-region 143 and the fourth meta-region 144 in the central meta-group CG and the gap between the third meta-region 143 and the fourth meta-region 144 in the peripheral meta-group PG may be different from each other.

For example, the first meta-region 141 of the peripheral meta-group PG may be shifted by ΔG1 with respect to the center of the peripheral meta-group PG, the second meta-region 142 may be shifted by ΔB with respect to the center of the peripheral meta-group PG, the third meta-region 143 may be shifted by ΔR with respect to the center of the peripheral meta-group PG, and the fourth meta-region 144 may be shifted by ΔG2 with respect to the center of the peripheral meta-group PG. ΔG1, ΔB, ΔR, and ΔG2 respectively indicate relative displacements of the first meta-region 141, the second meta-region 142, the third meta-region 143, and the fourth meta-region 144 with respect to the center of the peripheral meta-group PG. The arrows shown in ΔG1, ΔB, ΔR, and ΔG2 in FIG. 14 only illustratively show the shifts of the first meta-region 141, the second meta-region 142, the third meta-region 143, and the fourth meta-region 144, respectively, and actual shift directions and distances may be different from arrow directions. As described above, the first meta-region 141, the second meta-region 142, the third meta-region 143, and the fourth meta-region 144 at the periphery of the nano-photonic lens array 140 may be shifted toward the center of the nano-photonic lens array 140 together with the peripheral meta-group PG, and besides, may be relatively further shifted within the peripheral meta-group PG.

In addition, four sub-regions in each of the first meta-region 141, the second meta-region 142, the third meta-region 143, and the fourth meta-region 144 may be symmetrically shifted relative to each other in opposite directions to other adjacent sub-regions which belong to the same meta-region. For example, in each of the first meta-region 141, the second meta-region 142, the third meta-region 143, and the fourth meta-region 144, two sub-regions adjacent in the X-axis may be shifted in opposite directions by the same distance in the X-axis, and two sub-regions adjacent in the Y-axis may be shifted in opposite directions by the same distance in the Y-axis. For example, the two sub-regions adjacent in the X-axis (e.g., the first direction) may be shifted with opposite displacements in the first direction, and two sub-regions adjacent in the Y-axis (e.g., the second direction) may be shifted with opposite displacements in the second direction. The shifts of sub-regions may be defined with respect to a center line of a meta-region to which the sub-regions belong. In other words, the sub-regions may be shifted by ΔG1, ΔB, ΔR, or ΔG2 along with meta-regions, and in addition, may be further shifted relative to each other differently within the corresponding meta-region.

The relative shift directions of the first meta-region 141, the second meta-region 142, the third meta-region 143, and the fourth meta-region 144 within the peripheral meta-group PG and the relative shift directions of the sub regions in the first meta-region 141, the second meta-region 142, the third meta-region 143, and the fourth meta-region 144 may be mainly determined according to a position of an azimuth angle φ of the peripheral meta-group PG on the nano-photonic lens array 140. The azimuth angle φ may be defined with respect to a reference axis (e.g., an X-axis) that passes through a center C of the nano-photonic lens array 140 and is parallel to the first direction. For example, the azimuth angle φ of the peripheral meta-group PG may be determined as a counterclockwise angle between the reference axis and a line segment connecting the center of the peripheral meta-group PG to the center of the nano-photonic lens array 140.

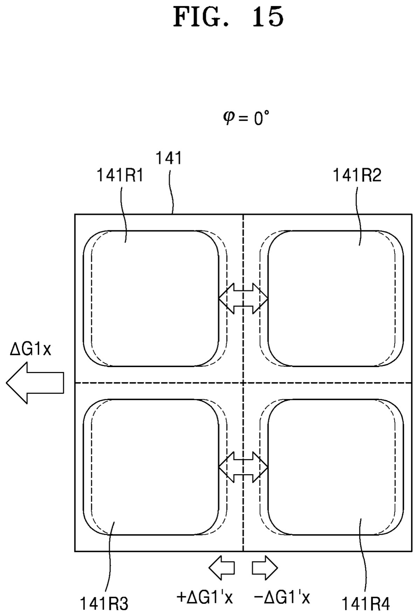

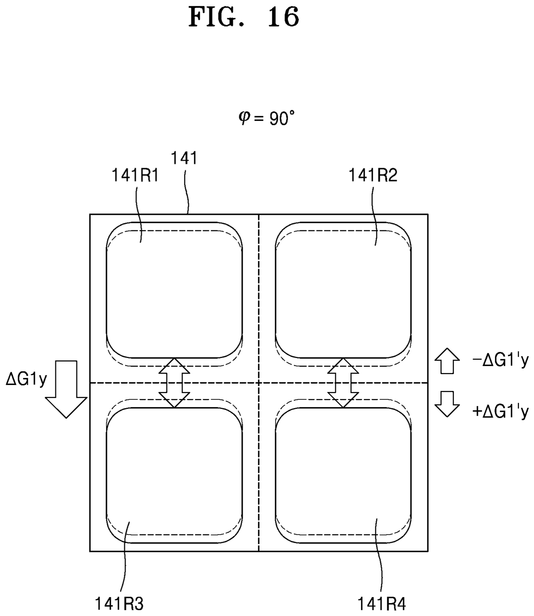

FIGS. 15 and 16 show relative displacements of sub-regions in the first meta-region 141 at positions where an azimuth angle of the periphery of the nano-photonic lens array 140 is 0 degrees and 90 degrees, respectively.

Referring to FIG. 15, the first meta-region 141 may be shifted by a first displacement ΔG1x in a first direction (e.g., the X-axis) with respect to the center of the peripheral meta-group PG, at the position where the azimuth angle φ is 0 degrees (i.e. on the X-axis). In FIG. 15, the first displacement ΔG1x is indicated by an arrow in the left direction, but the disclosure is not limited thereto. For example, according to the design of the nanostructures NP of the nano-photonic lens array 140, G1x may have a positive value or a negative value. Hereinafter, a positive value or a positive direction is defined as a direction closer to the center of the nano-photonic lens array 140, and a negative value or a negative direction is defined as a direction away from the center of the nano-photonic lens array 140.

In addition, in the first meta-region 141, the first sub-region 141R1 and the second sub-region 141R2 adjacent to each other in the X-axis may be further shifted in opposite directions in the X-axis, and the third sub-region 141R3 and the fourth sub-region 141R4 adjacent to each other in the X-axis may be further shifted in opposite directions in the X-axis. Shift distances of the first sub-region 141R1, the second sub-region 141R2, the third sub-region 141R3, and the fourth sub-region 141R4 in the first direction may be the same. For example, the first sub-region 141R1 and the third sub-region 141R3 may be shifted by a positive first sub-displacement (+ΔG1'x) in the first direction, and the second sub-region 141R2 and the fourth sub-region 141R4 may be shifted by a negative first sub-displacement (-ΔG1'x) in the first direction. Therefore, the first sub-region 141R1 and the second sub-region 141R2 may be provided symmetrically with respect to a second direction (e.g., the Y-axis) center line of the first meta-region 141, and the third sub-region 141R3 and the fourth sub-region 141R4 may be provided symmetrically with respect to the second direction center line of the first meta-region 141. Here, the second direction center line of the first meta-region 141 may be defined as a straight line passing through the center of the first meta-region 141 in the second direction.

According to an embodiment illustrated in FIG. 15, the first sub-region 141R1 and the second sub-region 141R2 move away from each other in the first direction, and the third sub-region 141R3 and the fourth sub-region 141R4 move away from each other in the first direction, but the disclosure is not limited thereto. According to the design of the nanostructures NP of the nano-photonic lens array 140, the first sub-displacement ΔG1'x may have a positive value or a negative value. In other words, according to the design of the nanostructures NP of the nano-photonic lens array 140, the first sub-region 141R1 and the second sub-region 141R2 may be closer to each other in the first direction, and the third sub-region 141R3 and the fourth sub-region 141R4 may be closer to each other in the first direction.

As a result, at the position where the azimuth angle φ is 0 degrees, in the first meta-region 141, the first sub-region 141R1 and the third sub-region 141R3 may be shifted by ΔG1x+ΔG1'x in the first direction with respect to the center of the peripheral meta-group PG to which the first meta-region 141 belongs, and the second sub-region 141R2 and the fourth sub-region 141R4 may be shifted by ΔG1x-ΔG1'x in the first direction with respect to the center of the peripheral meta-group PG to which the first meta-region 141 belongs. In addition, in the first meta-region 141, the first sub-region 141R1 and the third sub-region 141R3 may be shifted by d2x+(ΔG1x+ΔG1'x) in the first direction with respect to the corresponding first sub-pixel P1 and third sub-pixel P3 of the first pixel 111, and the second sub-region 141R2 and the fourth sub-pixel 141R4 may be shifted by d2x+(ΔG1x-ΔG1'x) in the first direction with respect to the corresponding second sub-pixel P2 and fourth sub-pixel P4 of the first pixel 111.

At the position where the azimuth angle φ is 0 degrees, the first meta-region 141 may not be shifted in the second direction with respect to the center of the peripheral meta-group PG. In addition, the first sub-region 141R1, the second sub-region 141R2, the third sub-region 141R3, and the fourth sub-region 141R4 within the first meta-region 141 may not be shifted in the second direction with respect to each other. For example, at the position where the azimuth angle φ is 0 degrees, a gap in the second direction between the first sub-region 141R1 and the third sub-region 141R3 and a gap in the second direction between the second sub-region 141R2 and the fourth sub-region 141R4 may not change.

Therefore, a gap in the first direction between the first sub-region 141R1 and the second sub-region 141R2 in the first meta-region 141 of the central meta-group CG may be different from a gap in the first direction between the first sub-region 141R1 and the second sub-region 141R2 in the first meta-region 141 of the peripheral meta-group PG provided at the position where the azimuth angle φ is 0 degrees. A gap in the first direction between the third sub-region 141R3 and the fourth sub-region 141R4 in the first meta-region 141 of the central meta-group CG may be different from a gap in the first direction between the third sub-region 141R3 and the fourth sub-region 141R4 in the first meta-region 141 of the peripheral meta-group PG provided at the position where the azimuth angle φ is 0 degrees. A gap in the second direction between the first sub-region 141R1 and the third sub-region 141R3 in the first meta-region 141 of the central meta-group CG may be the same as a gap in the second direction between the first sub-region 141R1 and the third sub-region 141R3 in the first meta-region 141 of the peripheral meta-group PG provided at the position where the azimuth angle φ is 0 degrees. A gap in the second direction between the second sub-region 141R2 and the fourth sub-region 141R4 in the first meta-region 141 of the central meta-group CG may be the same as a gap in the second direction between the second sub-region 141R2 and the fourth sub-region 141R4 in the first meta-region 141 of the peripheral meta-group PG provided at the position where the azimuth angle φ is 0 degrees.

Referring to FIG. 16, the first meta-region 141 may be shifted by a second displacement ΔG1y in the second direction with respect to the center of the peripheral meta-group PG, at the position where the azimuth angle φ is 90 degrees, e.g., on the Y-axis. In FIG. 16, the second displacement ΔG1y is indicated by an arrow in the downward direction, but the disclosure is not limited thereto. For example, according to the design of the nanostructures NP of the nano-photonic lens array 140, G1y may have a positive value or a negative value.

In addition, in the first meta-region 141, the first sub-region 141R1 and the third sub-region 141R3 adjacent to each other in the Y-axis may be further shifted in opposite directions in the Y-axis, and the second sub-region 141R2 and the fourth sub-region 141R4 adjacent to each other in the Y-axis may be further shifted in opposite directions in the Y-axis. Shift distances of the first sub-region 141R1, the second sub-region 141R2, the third sub-region 141R3, and the fourth sub-region 141R4 in the second direction may be the same. For example, the first sub-region 141R1 and the second sub-region 141R2 may be shifted by a negative second sub-displacement (-ΔG1'y) in the second direction, and the third sub-region 141R3 and the fourth sub-region 141R4 may be shifted by a positive second sub-displacement (*+*ΔG1'y) in the second direction. Therefore, the first sub-region 141R1 and the third sub-region 141R3 may be provided symmetrically with respect to a first direction center line of the first meta-region 141, and the second sub-region 141R2 and the fourth sub-region 141R4 may be provided symmetrically with respect to the first direction center line of the first meta-region 141. Here, the first direction center line of the first meta-region 141 may be defined as a straight line passing through the center of the first meta-region 141 in the first direction.

According to an embodiment illustrated in FIG. 16, the first sub-region 141R1 and the third sub-region 141R3 move away from each other in the second direction and the second sub-region 141R2 and the fourth sub-region 141R4 move away from each other in the second direction, but the disclosure is not limited thereto. According to the design of the nanostructures NP of the nano-photonic lens array 140, the second sub-displacement ΔG1'y may have a positive value or a negative value. In other words, according to the design of the nanostructures NP of the nano-photonic lens array 140, the first sub-region 141R1 and the third sub-region 141R3 may be closer to each other in the second direction, and the second sub-region 141R2 and the fourth sub-region 141R4 may be closer to each other in the second direction.

As a result, at the position where the azimuth angle φ is 90 degrees, in the first meta-region 141, the first sub-region 141R1 and the second sub-region 141R2 may be shifted by ΔG1y-ΔG1'y in the second direction with respect to the center of the peripheral meta-group PG to which the first meta-region 141 belongs, and the third sub-region 141R3 and the fourth sub-region 141R4 may be shifted by ΔG1y+ΔG1'y in the second direction with respect to the center of the peripheral meta-group PG to which the first meta-region 141 belongs. In addition, in the first meta-region 141, the first sub-region 141R1 and the second sub-region 141R2 may be shifted by d2y+(ΔG1y-ΔG1'y) with respect to the corresponding first sub-pixel P1 and second sub-pixel P2 of the first pixel 111, and the third sub-region 141R3 and the fourth sub-pixel 141R4 may be shifted by d2y+(ΔG1y+ΔG1'y) with respect to the corresponding third sub-pixel P3 and fourth sub-pixel P4 of the first pixel 111.

At the position where the azimuth angle φ is 90 degrees, the first meta-region 141 may not be shifted in the first direction with respect to the center of the peripheral meta-group PG. In addition, the first sub-region 141R1, the second sub-region 141R2, the third sub-region 141R3, and the fourth sub-region 141R4 within the first meta-region 141 may not be shifted in the first direction with respect to each other. For example, at the position where the azimuth angle φ is 90 degrees, a gap in the first direction between the first sub-region 141R1 and the second sub-region 141R2 and a gap in the first direction between the third sub-region 141R3 and the fourth sub-region 141R4 may not change.

Therefore, a gap in the second direction between the first sub-region 141R1 and the third sub-region 141R3 in the first meta-region 141 of the central meta-group CG may be different from a gap in the second direction between the first sub-region 141R1 and the third sub-region 141R3 in the first meta-region 141 of the peripheral meta-group PG provided at the position where the azimuth angle φ is 90 degrees. A gap in the second direction between the second sub-region 141R2 and the fourth sub-region 141R4 in the first meta-region 141 of the central meta-group CG may be different from a gap in the second direction between the second sub-region 141R2 and the fourth sub-region 141R4 in the first meta-region 141 of the peripheral meta-group PG provided at the position where the azimuth angle φ is 90 degrees. A gap in the first direction between the first sub-region 141R1 and the second sub-region 141R2 in the first meta-region 141 of the central meta-group CG may be the same as a gap in the first direction between the first sub-region 141R1 and the second sub-region 141R2 in the first meta-region 141 of the peripheral meta-group PG provided at the position where the azimuth angle φ is 90 degrees. A gap in the first direction between the third sub-region 141R3 and the fourth sub-region 141R4 in the first meta-region 141 of the central meta-group CG may be the same as gap in the first direction between the third sub-region 141R3 and the fourth sub-region 141R4 in the first meta-region 141 of the peripheral meta-group PG provided at the position where the azimuth angle φ is 90 degrees.

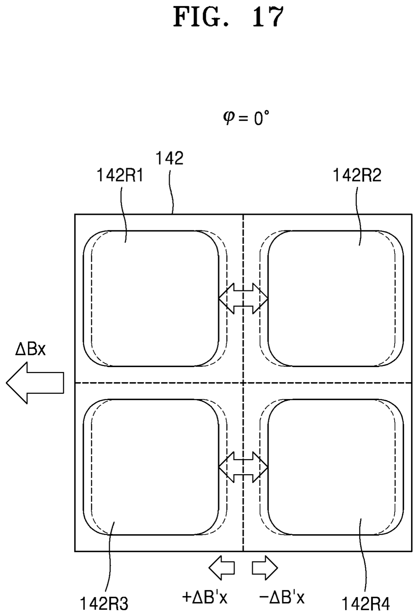

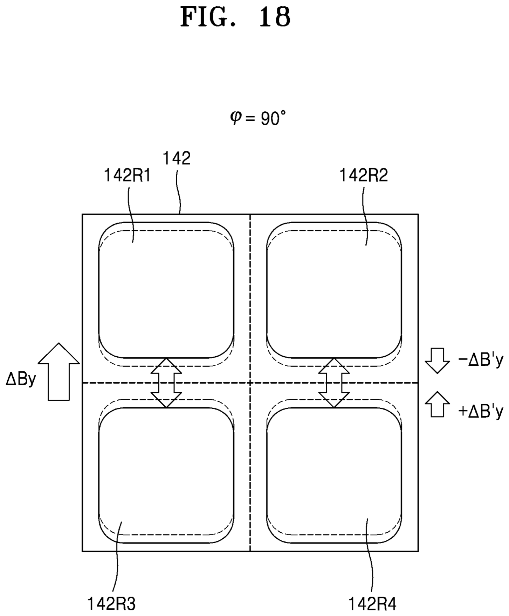

FIGS. 17 and 18 show relative displacements of sub-regions in the second meta-region 142 at positions where an azimuth angle of the periphery of the nano-photonic lens array 140 is 0 degrees and 90 degrees, respectively.

Referring to FIG. 17, at the position where the azimuth angle φ is 0 degrees, the second meta-region 142 may be shifted by a third displacement ΔBx in a first direction with respect to the center of the peripheral meta-group PG. According to the design of the nanostructures NP of the nano-photonic lens array 140, Bx may have a positive value or a negative value.

In addition, in the second meta-region 142, the first sub-region 142R1 and the second sub-region 142R2 adjacent to each other in the X-axis may be shifted by the same distance in opposite directions in the X-axis, and the third sub-region 142R3 and the fourth sub-region 142R4 adjacent to each other in the X-axis may be shifted by the same distance in opposite directions in the X-axis. For example, the first sub-region 142R1 and the third sub-region 142R3 may be shifted by a positive third sub-displacement (+ΔB'x) in the first direction, and the second sub-region 142R2 and the fourth sub-region 142R4 may be shifted by a negative third sub-displacement (-ΔB'x) in the first direction. According to the design of the nanostructures NP of the nano-photonic lens array 140, the third sub-displacement ΔB'x may have a positive value or a negative value.

As a result, at the position where the azimuth angle φ is 0 degrees, in the second meta-region 142, the first sub-region 142R1 and the third sub-region 142R3 may be shifted by ΔBx+ΔB'x in the first direction with respect to the center of the peripheral meta-group PG to which the second meta-region 142 belongs, and the second sub-region 142R2 and the fourth sub-region 142R4 may be shifted by ΔBx-ΔB'x in the first direction with respect to the center of the peripheral meta-group PG to which the second meta-region 142 belongs. In addition, in the second meta-region 142, the first sub-region 142R1 and the third sub-region 142R3 may be shifted by d2x+(ΔBx+ΔB'x) with respect to the corresponding first sub-pixel P1 and third sub-pixel P3 of the second pixel 112, and the second sub-region 142R2 and the fourth sub-pixel 142R4 may be shifted by d2x+(ΔBx-ΔB'x) with respect to the corresponding second sub-pixel P2 and fourth sub-pixel P4 of the second pixel 112.

At the position where the azimuth angle φ is 0 degrees, the second meta-region 142 may not be shifted in the second direction with respect to the center of the peripheral meta-group PG. In addition, the first sub-region 142R1, the second sub-region 142R2, the third sub-region 142R3, and the fourth sub-region 142R4 within the second meta-region 142 may not be shifted in the second direction with respect to each other.

Therefore, a gap in the first direction between the first sub-region 142R1 and the second sub-region 142R2 in the second meta-region 142 of the central meta-group CG may be different from a gap in the first direction between the first sub-region 142R1 and the second sub-region 142R2 in the second meta-region 142 of the peripheral meta-group PG provided at the position where the azimuth angle φ is 0 degrees. A gap in the first direction between the third sub-region 142R3 and the fourth sub-region 142R4 in the second meta-region 142 of the central meta-group CG may be different from a gap in the first direction between the third sub-region 142R3 and the fourth sub-region 142R4 in the second meta-region 142 of the peripheral meta-group PG provided at the position where the azimuth angle φ is 0 degrees. A gap in the second direction between the first sub-region 142R1 and the third sub-region 142R3 in the second meta-region 142 of the central meta-group CG may be the same as a gap in the second direction between the first sub-region 142R1 and the third sub-region 142R3 in the second meta-region 142 of the peripheral meta-group PG provided at the position where the azimuth angle φ is 0 degrees. A gap in the second direction between the second sub-region 142R2 and the fourth sub-region 142R4 in the second meta-region 142 of the central meta-group CG may be the same as a gap in the second direction between the second sub-region 142R2 and the fourth sub-region 142R4 in the second meta-region 142 of the peripheral meta-group PG provided at the position where the azimuth angle φ is 0 degrees.

Referring to FIG. 18, the second meta-region 142 may be shifted by a fourth displacement ΔBy with respect to the center of the peripheral meta-group PG at the position where the azimuth angle φ is 90 degrees. According to the design of the nanostructures NP of the nano-photonic lens array 140, By may have a positive value or a negative value.

In addition, in the second meta-region 142, the first sub-region 142R1 and the third sub-region 142R3 adjacent to each other in the Y-axis may be further shifted by the same distance in opposite directions in the Y-axis, and the second sub-region 142R2 and the fourth sub-region 142R4 adjacent to each other in the Y-axis may be further shifted by the same distance in opposite directions in the Y-axis. For example, the first sub-region 142R1 and the second sub-region 142R2 may be shifted by a negative fourth sub-displacement (-ΔB'y) in the second direction, and the third sub-region 142R3 and the fourth sub-region 142R4 may be shifted by a positive fourth sub-displacement (+ΔB'y) in the second direction. According to the design of the nanostructures NP of the nano-photonic lens array 140, the fourth sub-displacement ΔB'y may have a positive value or a negative value.

As a result, at the position where the azimuth angle φ is 90 degrees, in the second meta-region 142, the first sub-region 142R1 and the second sub-region 142R2 may be shifted by ΔBy-ΔB'y in the second direction with respect to the center of the peripheral meta-group PG to which the second meta-region 142 belongs, and the third sub-region 142R3 and the fourth sub-region 142R4 may be shifted by ΔBy+ΔB'y in the second direction with respect to the center of the peripheral meta-group PG to which the second meta-region 142 belongs. In addition, in the second meta-region 142, the first sub-region 142R1 and the second sub-region 142R2 may be shifted by d2y+(ΔBy-ΔB'y) with respect to the corresponding first sub-pixel P1 and second sub-pixel P2 of the second pixel 112, and the third sub-region 142R3 and the fourth sub-pixel 142R4 may be shifted by d2y+(ΔBy+ΔB'y) with respect to the corresponding third sub-pixel P3 and fourth sub-pixel P4 of the second pixel 112.

At the position where the azimuth angle φ is 90 degrees, the second meta-region 142 may not be shifted in the first direction with respect to the center of the peripheral meta-group PG. In addition, the first sub-region 142R1, the second sub-region 142R2, the third sub-region 142R3, and the fourth sub-region 142R4 may not be shifted in the first direction with respect to each other within the second meta-region 142.

Therefore, a gap in the second direction between the first sub-region 142R1 and the third sub-region 142R3 in the second meta-region 142 of the central meta-group CG may be different from a gap in the second direction between the first sub-region 142R1 and the third sub-region 142R3 in the second meta-region 142 of the peripheral meta-group PG provided at the position where the azimuth angle φ is 90 degrees. A gap in the second direction between the second sub-region 142R2 and the fourth sub-region 142R4 in the second meta-region 142 of the central meta-group CG may be different from a gap in the second direction between the second sub-region 142R2 and the fourth sub-region 142R4 in the second meta-region 142 of the peripheral meta-group PG provided at the position where the azimuth angle φ is 90 degrees. A gap in the first direction between the first sub-region 142R1 and the second sub-region 142R2 in the second meta-region 142 of the central meta-group CG may be the same as a gap in the first direction between the first sub-region 142R1 and the second sub-region 142R2 in the second meta-region 142 of the peripheral meta-group PG provided at the position where the azimuth angle φ is 90 degrees. A gap in the first direction between the third sub-region 142R3 and the fourth sub-region 142R4 in the second meta-region 142 of the central meta-group CG may be the same as a gap in the first direction between the third sub-region 142R3 and the fourth sub-region 142R4 in the second meta-region 142 of the peripheral meta-group PG provided at the position where the azimuth angle φ is 90 degrees.

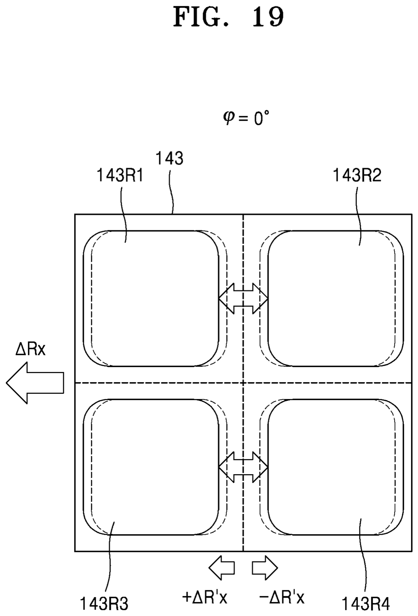

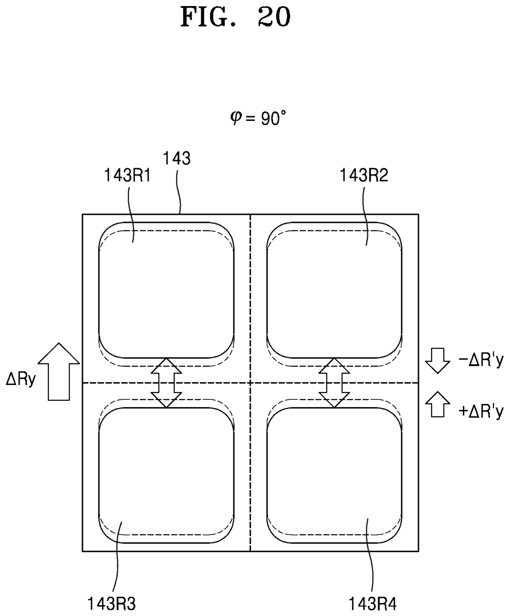

FIGS. 19 and 20 show relative displacements of sub-regions in the third meta-region 143 at positions where an azimuth angle of the periphery of the nano-photonic lens array 140 is 0 degrees and 90 degrees, respectively.

The description of the second meta-region 142 of FIGS. 17 and 18 may be similarly applied to the third meta-region 143 of FIGS. 19 and 20. Referring to FIG. 19, at the position where the azimuth angle φ is 0 degrees, the third meta-region 143 may be shifted by a fifth displacement ΔRx in the X-axis with respect to the center of the peripheral meta-group PG. In the third meta-region 143, the first sub-region 143R1 and the second sub-region 143R2 may be further shifted by the same distance in opposite directions in the X-axis, and the third sub-region 143R3 and the fourth sub-region 143R4 may be further shifted by the same distance in opposite directions in the X-axis. For example, the first sub-region 143R1 and the third sub-region 143R3 may be shifted by a positive fifth sub-displacement (+ΔR'x) in the first direction, and the second sub-region 143R2 and the fourth sub-region 143R4 may be shifted by a negative fifth sub-displacement (-ΔR'x) in the first direction.

As a result, at the position where the azimuth angle φ is 0 degrees, in the third meta-region 143, the first sub-region 143R1 and the third sub-region 143R3 may be shifted by ΔRx+ΔR'x in the first direction with respect to the center of the peripheral meta-group PG to which the third meta-region 143 belongs, and the second sub-region 143R2 and the fourth sub-region 143R4 may be shifted by ΔRx-ΔR'x in the first direction with respect to the center of the peripheral meta-group PG to which the third meta-region 143 belongs. In the third meta-region 143, the first sub-region 143R1 and the third sub-region 143R3 may be shifted by d2x+(ΔRx+ΔR'x) with respect to the corresponding first sub-pixel P1 and third sub-pixel P3 of the third pixel 113, and the second sub-region 143R2 and the fourth sub-pixel 143R4 may be shifted by d2x+(ΔRx-ΔR'x) with respect to the corresponding second sub-pixel P2 and fourth sub-pixel P4 of the third pixel 113.

At the position where the azimuth angle φ is 0 degrees, the third meta-region 143 may not be shifted in the second direction with respect to the center of the peripheral meta-group PG. In addition, the first sub-region 143R1, the second sub-region 143R2, the third sub-region 143R3, and the fourth sub-region 143R4 within the third meta-region 143 may not be shifted in the second direction with respect to each other.

Therefore, a gap in the first direction between the first sub-region 143R1 and the second sub-region 143R2 in the third meta-region 143 of the central meta-group CG may be different from a gap in the first direction between the first sub-region 143R1 and the second sub-region 143R2 in the third meta-region 143 of the peripheral meta-group PG provided at the position where the azimuth angle φ is 0 degrees. A gap in the first direction between the third sub-region 143R3 and the fourth sub-region 143R4 in the third meta-region 143 of the central meta-group CG may be different from a gap in the first direction between the third sub-region 143R3 and the fourth sub-region 143R4 in the third meta-region 143 of the peripheral meta-group PG provided at the position where the azimuth angle φ is 0 degrees. A gap in the second direction between the first sub-region 143R1 and the third sub-region 143R3 in the third meta-region 143 of the central meta-group CG may be the same as a gap in the second direction between the first sub-region 143R1 and the third sub-region 143R3 in the third meta-region 143 of the peripheral meta-group PG provided at the position where the azimuth angle φ is 0 degrees. A gap in the second direction between the second sub-region 143R2 and the fourth sub-region 143R4 in the third meta-region 143 of the central meta-group CG may be the same as a gap in the second direction between the second sub-region 143R2 and the fourth sub-region 143R4 in the third meta-region 143 of the peripheral meta-group PG provided at the position where the azimuth angle φ is 0 degrees.

Referring to FIG. 20, the third meta-region 143 may be shifted by a sixth displacement ΔRy in the second direction with respect to the center of the peripheral meta-group PG at the position where the azimuth angle φ is 90 degrees. In addition, in the third meta-region 143, the first sub-region 143R1 and the third sub-region 143R3 may be further shifted by the same distance in opposite directions in the Y-axis, and the second sub-region 143R2 and the fourth sub-region 143R4 may be further shifted by the same distance in opposite directions in the Y-axis. For example, the first sub-region 143R1 and the second sub-region 143R2 may be shifted by a negative sixth sub-displacement (-ΔR'y) in the second direction, and the third sub-region 143R3 and the fourth sub-region 143R4 may be shifted by a positive sixth sub-displacement (+ΔR'y) in the second direction.

As a result, at the position where the azimuth angle φ is 90 degrees, in the third meta-region 143, the first sub-region 143R1 and the second sub-region 143R2 may be shifted by ΔRy-ΔR'y in the second direction with respect to the center of the peripheral meta-group PG to which the third meta-region 143 belongs, and the third sub-region 143R3 and the fourth sub-region 143R4 may be shifted by ΔRy+ΔR'y in the second direction with respect to the center of the peripheral meta-group PG to which the third meta-region 143 belongs. In addition, in the third meta-region 143, the first sub-region 143R1 and the second sub-region 143R2 may be shifted by d2y+(ΔRy-ΔR'y) with respect to the corresponding first sub-pixel P1 and second sub-pixel P2 of the third pixel 113, and the third sub-region 143R3 and the fourth sub-pixel 143R4 may be shifted by d2y+(ΔRy+ΔR'y) with respect to the corresponding third sub-pixel P3 and fourth sub-pixel P4 of the third pixel 113.

At the position where the azimuth angle φ is 90 degrees, the third meta-region 143 may not be shifted in the first direction with respect to the center of the peripheral meta-group PG. In addition, the first sub-region 143R1, the second sub-region 143R2, the third sub-region 143R3, and the fourth sub-region 143R4 within the third meta-region 143 may not be shifted in the first direction with respect to each other.

Therefore, a gap in the second direction between the first sub-region 143R1 and the third sub-region 143R3 in the third meta-region 143 of the central meta-group CG may be different from a gap in the second direction between the first sub-region 143R1 and the third sub-region 143R3 in the third meta-region 143 of the peripheral meta-group PG provided at the position where the azimuth angle φ is 90 degrees. A gap in the second direction between the second sub-region 143R2 and the fourth sub-region 143R4 in the third meta-region 143 of the central meta-group CG may be different from a gap in the second direction between the second sub-region 143R2 and the fourth sub-region 143R4 in the third meta-region 143 of the peripheral meta-group PG provided at the position where the azimuth angle φ is 90 degrees. A gap in the first direction between the first sub-region 143R1 and the second sub-region 143R2 in the third meta-region 143 of the central meta-group CG may be the same as a gap in the first direction between the first sub-region 143R1 and the second sub-region 143R2 in the third meta-region 143 of the peripheral meta-group PG provided at the position where the azimuth angle φ is 90 degrees. A gap in the first direction between the third sub-region 143R3 and the fourth sub-region 143R4 in the third meta-region 143 of the central meta-group CG may be the same as a gap in the first direction between the third sub-region 143R3 and the fourth sub-region 143R4 in the third meta-region 143 of the peripheral meta-group PG provided at the position where the azimuth angle φ is 90 degrees.

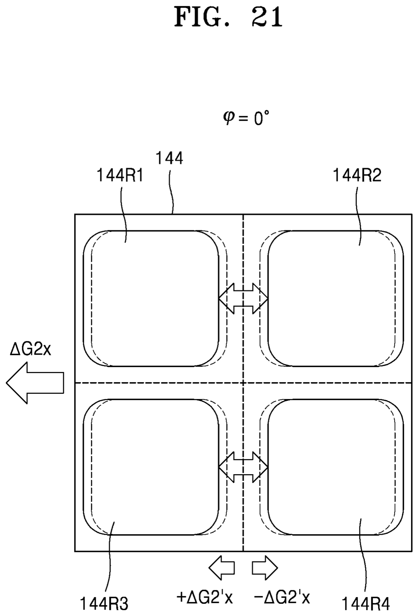

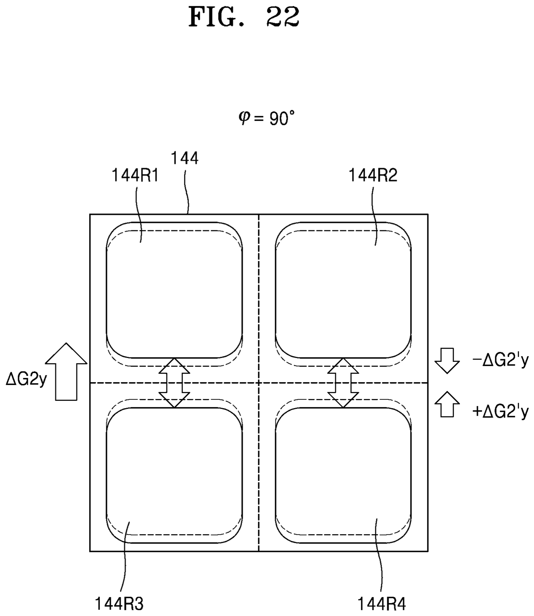

FIGS. 21 and 22 show relative displacements of sub-regions in the fourth meta-region 144 at positions where an azimuth angle of the periphery of the nano-photonic lens array 140 is 0 degrees and 90 degrees, respectively.

The description of the first meta-region 141 of FIGS. 15 and 16 may be similarly applied to the fourth meta-region 144 of FIGS. 21 and 22. Referring to FIG. 21, at the position where the azimuth angle φ is 0 degrees, the fourth meta-region 144 may be shifted by a seventh displacement ΔG2x in the X-axis with respect to the center of the peripheral meta-group PG. In the fourth meta-region 144, the first sub-region 144R1 and the second sub-region 144R2 may be further shifted by the same distance in opposite directions in the X-axis, and the third sub-region 144R3 and the fourth sub-region 144R4 may be further shifted by the same distance in opposite directions in the X-axis. For example, the first sub-region 144R1 and the third sub-region 144R3 may be shifted by a positive seventh sub-displacement (+ΔG2'x) in the X-axis, and the second sub-region 144R2 and the fourth sub-region 144R4 may be shifted by a negative seventh sub-displacement (-ΔG2'x) in the first direction.

As a result, at the position where the azimuth angle φ is 0 degrees, in the fourth meta-region 144, the first sub-region 144R1 and the third sub-region 144R3 may be shifted by ΔG2x+ΔG2'x in the first direction with respect to the center of the peripheral meta-group PG to which the fourth meta-region 144 belongs, and the second sub-region 144R2 and the fourth sub-region 144R4 may be shifted by ΔG2x-ΔG2'x in the first direction with respect to the center of the peripheral meta-group PG to which the fourth meta-region 144 belongs. In the fourth meta-region 144, the first sub-region 144R1 and the third sub-region 144R3 may be shifted by d2x+(ΔG2x+ΔG2'x) with respect to the corresponding first sub-pixel P1 and third sub-pixel P3 of the fourth pixel 114, and the second sub-region 144R2 and the fourth sub-pixel 144R4 may be shifted by d2x+(ΔG2x-ΔG2'x) with respect to the corresponding second sub-pixel P2 and fourth sub-pixel P4 of the fourth pixel 114.

At the position where the azimuth angle φ is 0 degrees, the fourth meta-region 144 may not be shifted in a second direction with respect to the center of the peripheral meta-group PG. In addition, the first sub-region 144R1, the second sub-region 144R2, the third sub-region 144R3, and the fourth sub-region 144R4 within the fourth meta-region 144 may not be shifted in the second direction with respect to each other.

Accordingly, a gap in the first direction between the first sub-region 144R1 and the second sub-region 144R2 in the fourth meta-region 144 of the central meta-group CG may be different from a gap in the first direction between the first sub-region 144R1 and the second sub-region 144R2 in the fourth meta-region 144 of the peripheral meta-group PG provided at the position where the azimuth angle φ is 0 degrees. A gap in the first direction between the third sub-region 144R3 and the fourth sub-region 144R4 in the fourth meta-region 144 of the central meta-group CG may be different from a gap in the first direction between the third sub-region 144R3 and the fourth sub-region 144R4 in the fourth meta-region 144 of the peripheral meta-group PG provided at the position where the azimuth angle φ is 0 degrees. A gap in the second direction between the first sub-region 144R1 and the third sub-region 144R3 in the fourth meta-region 144 of the central meta-group CG may be the same as a gap in the second direction between the first sub-region 144R1 and the third sub-region 144R3 in the fourth meta-region 144 of the peripheral meta-group PG provided at the position where the azimuth angle φ is 0 degrees. A gap in the second direction between the second sub-region 144R2 and the fourth sub-region 144R4 in the fourth meta-region 144 of the central meta-group CG may be the same as a gap in the second direction between the second sub-region 144R2 and the fourth sub-region 144R4 in the fourth meta-region 144 of the peripheral meta-group PG provided at the position where the azimuth angle φ is 0 degrees.

Referring to FIG. 22, the fourth meta-region 144 may be shifted by an eighth displacement ΔG2y with respect to the center of the peripheral meta-group PG at the position where the azimuth angle φ is 90 degrees. In addition, in the fourth meta-region 144, the first sub-region 144R1 and the third sub-region 144R3 may be further shifted by the same distance in opposite directions in the Y-axis, and the second sub-region 144R2 and the fourth sub-region 144R4 may be further shifted by the same distance in opposite directions in the Y-axis. For example, the first sub-region 144R1 and the second sub-region 144R2 may be shifted by a negative eighth sub-displacement (-ΔG2'y) in the second direction, and the third sub-region 144R3 and the fourth sub-region 144R4 may be shifted by a positive eighth sub-displacement (+ΔG2'y) in the second direction.

As a result, at the position where the azimuth angle φ is 90 degrees, in the fourth meta-region 144, the first sub-region 144R1 and the second sub-region 144R2 may be shifted by ΔG2y-ΔG2'y in the second direction with respect to the center of the peripheral meta-group PG to which the fourth meta-region 144 belongs, and the third sub-region 144R3 and the fourth sub-region 144R4 may be shifted by ΔG2y+ΔG2'y in the second direction with respect to the center of the peripheral meta-group PG to which the fourth meta-region 144 belongs. In addition, in the fourth meta-region 144, the first sub-region 144R1 and the second sub-region 144R2 may be shifted by d2y+(ΔG2y-ΔG2'y) with respect to the corresponding first sub-pixel P1 and second sub-pixel P2 of the fourth pixel 114, and the third sub-region 144R3 and the fourth sub-pixel 144R4 may be shifted by d2y+(ΔG2y+ΔG2'y) with respect to the corresponding third sub-pixel P3 and fourth sub-pixel P4 of the fourth pixel 114.

At the position where the azimuth angle φ is 90 degrees, the fourth meta-region 144 may not be shifted in the first direction with respect to the center of the peripheral meta-group PG. In addition, the first sub-region 144R1, the second sub-region 144R2, the third sub-region 144R3, and the fourth sub-region 144R4 within the fourth meta-region 144 may not be shifted in the first direction with respect to each other.

Accordingly, a gap in the second direction between the first sub-region 144R1 and the third sub-region 144R3 in the fourth meta-region 144 of the central meta-group CG may be different from a gap in the second direction between the first sub-region 144R1 and the third sub-region 144R3 in the fourth meta-region 144 of the peripheral meta-group PG provided at the position where the azimuth angle φ is 90 degrees. A gap in the second direction between the third sub-region 144R2 and the fourth sub-region 144R4 in the fourth meta-region 144 of the central meta-group CG may be different from a gap in the second direction between the second sub-region 144R2 and the fourth sub-region 144R4 in the fourth meta-region 144 of the peripheral meta-group PG provided at the position where the azimuth angle φ is 90 degrees. A gap in the first direction between the first sub-region 144R1 and the second sub-region 144R2 in the fourth meta-region 144 of the central meta-group CG may be the same as a gap in the first direction between the first sub-region 144R1 and the second sub-region 144R2 in the fourth meta-region 144 of the peripheral meta-group PG provided at the position where the azimuth angle φ is 90 degrees. A gap in the first direction between the third sub-region 144R3 and the fourth sub-region 144R4 in the fourth meta-region 144 of the central meta-group CG may be the same as a gap in the first direction between the third sub-region 144R3 and the fourth sub-region 144R4 in the fourth meta-region 144 of the peripheral meta-group PG provided at the position where the azimuth angle φ is 90 degrees.

Meanwhile, the absolute value of the seventh displacement ΔG2x of the fourth meta-region 144 may be the same as the absolute value of the second displacement ΔG1y of the first meta-region 141, and the absolute value of the seventh sub-displacement ΔG2'x of the fourth meta-region 144 may be the same as the absolute value of the second sub-displacement ΔG1'y of the first meta-region 141. In addition, the absolute value of the eighth displacement ΔG2y of the fourth meta-region 144 may be the same as the absolute value of the first displacement ΔG1x of the first meta-region 141, and the absolute value of the eighth sub-displacement ΔG2'y of the fourth meta-region 144 may be the same as the absolute value of the first sub-displacement ΔG1'x of the first meta-region 141. Therefore, the first meta-region 141 and the fourth meta-region 144 in the peripheral meta-group PG may be symmetrically shifted relative to each other with respect to the azimuth angle φ of ±45 degrees.

At the periphery of the nano-photonic lens array 140 having the azimuth angle φ between 0 degrees and 90 degrees, the first meta-region 141, the second meta-region 142, the third meta-region 143, and the fourth meta-region 144 may be shifted in the first direction and the second direction with respect to the center of the peripheral meta-group PG. In addition, four sub-regions of each of the first meta-region 141, the second meta-region 142, the third meta-region 143, and the fourth meta-region 144 may also be shifted in the first direction and the second direction. A shift distance in the first direction may be proportional to a cosine value of the azimuth angle φ, and a shift distance in the second direction may be proportional to a sine value of the azimuth angle φ. Therefore, in each of the first meta-region 141, the second meta-region 142, the third meta-region 143, and the fourth meta-region 144 of the peripheral meta-group PG, shift distances in the first direction of the first sub-regions and the second sub-regions adjacent in the first direction and shift distances in the first direction of the third sub-regions and the fourth sub-regions adjacent in the first direction may decrease as the azimuth angle φ of the peripheral meta-group PG increases from 0 degrees to 90 degrees, and shift distances in the second direction of the first sub-regions and the third sub-regions adjacent in the second direction and shift distances in the second direction of the second sub-regions and the fourth sub-regions may increase as the azimuth angle φ of the peripheral meta-group PG increases from 0 degrees to 90 degrees.

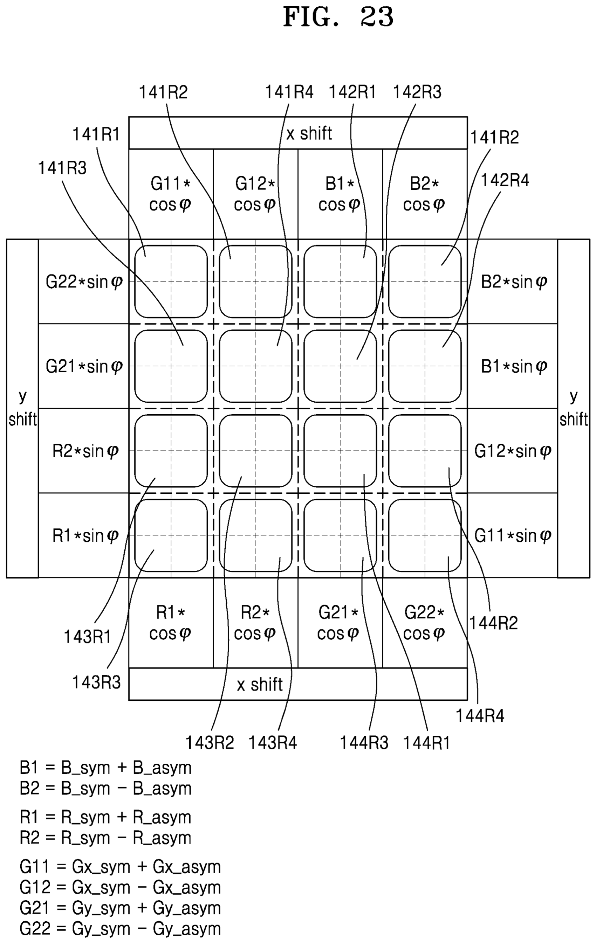

FIG. 23 shows the relationship between shift distances and azimuths of sub-regions of the first meta-region 141, the second meta-region 142, the third meta-region 143, and the fourth meta-region 144 within the peripheral meta-group PG of the periphery of the nano-photonic lens array 140. Referring to FIG. 23, the first sub-region 141R1 of the first meta-region 141 may be shifted by G11×cos(φ) in a first direction and by G22×sin(φ) in a second direction. The second sub-region 141R2 of the first meta-region 141 may be shifted by G12×cos(φ) in the first direction and by G22×sin(φ) in the second direction. The third sub-region 141R3 of the first meta-region 141 may be shifted by G11×cos(φ) in the first direction and by G21×sin(φ) in the second direction. The fourth sub-region 141R4 of the first meta-region 141 may be shifted by G12×cos(φ) in the first direction and by G21×sin(φ) in the second direction.

The first sub-region 142R1 of the second meta-region 142 may be shifted by B1×cos(φ) in the first direction and by B2×sin(φ) in the second direction. The second sub-region 142R2 of the second meta-region 142 may be shifted by B2×cos(φ) in the first direction and by B2×sin(φ) in the second direction. The third sub-region 142R3 of the second meta-region 142 may be shifted by B1×cos(φ) in the first direction and by B1×sin(φ) in the second direction. The fourth sub-region 142R4 of the second meta-region 142 may be shifted by B2×cos(φ) in the first direction and by B1×sin(φ) in the second direction.

The first sub-region 143R1 of the third meta-region 143 may be shifted by R1×cos(φ) in the first direction and by R2×sin(φ) in the second direction. The second sub-region 143R2 of the third meta-region 143 may be shifted by R2×cos(φ) in the first direction and by R2×sin(φ) in the second direction. The third sub-region 143R3 of the third meta-region 143 may be shifted by R1×cos(φ) in the first direction and by R1×sin(φ) in the second direction. The fourth sub-region 143R4 of the third meta-region 143 may be shifted by R2×cos(φ) in the first direction and by R1×sin(φ) in the second direction.

The first sub-region 144R1 of the fourth meta-region 144 may be shifted by G21×cos(φ) in the first direction and by G12×sin(φ) in the second direction. The second sub-region 144R2 of the fourth meta-region 144 may be shifted by G22×cos(φ) in the first direction and by G12×sin(φ) in the second direction. The third sub-region 144R3 of the fourth meta-region 144 may be shifted by G21 ×cos(φ) in the first direction and by G11×sin(φ) in the second direction. The fourth sub-region 144R4 of the fourth meta-region 144 may be shifted by G22×cos(φ) in the first direction and by G11 ×sin(φ) in the second direction.

Here, G11 = Gx_sym + Gx_asym, G12 = Gx_sym - Gx_asym, G21 = Gy_sym + Gy_asym, G22 = Gy_sym - Gy_asym, B1 = B_sym + B_asym, B2 = B_sym - B_asym, R1 = R_sym + R_asym, R2 = R_sym - R_asym. For example, Gx_sym, Gy_sym, B_sym, and R_sym may respectively indicate amounts of shifting the first meta-region 141, the second meta-region 142, the third meta-region 143, and the fourth meta-region 144 within the peripheral meta-group PG in consideration of characteristic differences according to wavelengths of incident light. In addition, Gx_asym, Gy_asym, B_asym, and R_asym may respectively indicate amounts of individually shifting four sub-regions of each of the first meta-region 141, the second meta-region 142, the third meta-region 143, and the fourth meta-region 144 of the peripheral meta-group PG to form a concentration region at the center of each of the first sub-pixel P1, the second sub-pixel P2, the third sub-pixel P3, and the fourth sub-pixel P4.

For example, Gx_sym×cos(φ) may be the same as the first displacement ΔG1x described with reference to FIG. 15, and Gx_asym×cos(φ) may be the same as the first sub-displacement ΔG1'x described with reference to FIG. 15. Gy_sym×sin(φ) may be the same as the second displacement ΔG1y described with reference to FIG. 16, and Gy_asym× sin(φ) may be the same as the second sub displacement ΔG1'y described with reference to FIG. 16. B_sym×cos(φ) may be the same as the third displacement ΔBx described with reference to FIG. 17, and B_asym×cos(φ) may be the same as the third sub displacement ΔB'x described with reference to FIG. 17. B_sym×sin(φ) may be the same as the fourth displacement ΔBy described with reference to FIG. 18, and B_asym×sin(φ) may be the same as the fourth sub-displacement ΔB'y described with reference to FIG. 18. The R_sym×cos(φ) may be the same as the fifth displacement ΔRx described with reference to FIG. 19, and the R_asym×cos(φ) may be the same as the fifth sub-displacement ΔR'x described with reference to FIG. 19. R_sym×sin(φ) may be the same as the sixth displacement ΔRy described with reference to FIG. 20, and R_asym×sin(φ) may be the same as the sixth sub-displacement ΔR'y described with reference to FIG. 20. Gy_sym×cos(φ) may be the same as the seventh displacement ΔG2x described with reference to FIG. 21, and Gy_asym×cos(φ) may be the same as the seventh sub-displacement ΔG2'x described with reference to FIG. 21. Gx_sym×sin(φ) may be the same as the eighth displacement ΔG2y described with reference to FIG. 22, and Gx_asym×sin(φ) may be the same as the eighth sub-displacement ΔG2'y described with reference to FIG. 22. Actual values of Gx_sym, Gy_sym, B_sym, R_sym, Gx_asym, Gy_asym, B_asym, and R_asym may vary depending on the design of the plurality of nanostructures NP of the nano-photonic lens array 140.

As described above, in an example case in which the peripheral meta-group PG shifts according to a CRA at the periphery of the nano-photonic lens array 140, positions of the nanostructures NP belonging to the peripheral meta-group PG may be shifted. In addition, in an example case in which the first meta-region 141, the second meta-region 142, the third meta-region 143, and the fourth meta-region 144 are shifted within the peripheral meta-group PG to alleviate a chromatic aberration, the relative positions between the nanostructures NP belonging to each of the first meta-region 141, the second meta-region 142, the third meta-region 143, and the fourth meta-region 144 may be changed. In addition, in an example case in which the sub-regions of each of the first meta-region 141, the second meta-region 142, the third meta-region 143, and the fourth meta-region 144 are shifted to form the concentration region at the center of each of the first meta-region 141, the second meta-region 142, the third meta-region 143, and the fourth meta-region 144, the relative positions between the nanostructures NP belonging to the sub-regions of each of the first meta-region 141, the second meta-region 142, the third meta-region 143, and the fourth meta-region 144 may be changed. Here, the shift of the peripheral meta-group PG may refer to the shift of all nanostructures belonging to the peripheral meta-group PG, the shift of each of the first meta-region 141, the second meta-region 142, the third meta-region 143, and the fourth meta-region 144 may refer to the shift of the nanostructures NP belonging to each of the first meta-region 141, the second meta-region 142, the third meta-region 143, and the fourth meta-region 144, and the shift of the sub-regions of each of the first meta-region 141, the second meta-region 142, the third meta-region 143, and the fourth meta-region 144 may refer tp the shift of the nanostructures NP belonging to each of the sub-regions.

For example, referring back to FIG. 8, the unit meta-group 140G shown in FIG. 8 may be the central meta-group CG. In the peripheral meta-group PG, the nanostructures NP shown in FIG. 8 may be shifted and located toward the center of the nano-photonic lens array 140 with respect to the unit pixel group 110G corresponding to the peripheral meta-group PG. In addition, in the peripheral meta-group PG, the nanostructures NP belonging to the first meta-region 141 may be shifted by the first displacement ΔG1x and the second displacement ΔG1y, the nanostructures NP belonging to the second meta-region 142 may be shifted by the third displacement ΔBx and the fourth displacement ΔBy, the nanostructures NP belonging to the third meta-region 143 may be shifted by the fifth displacement ΔRx and the sixth displacement ΔRy, and the nanostructures NP belonging to the fourth meta-region 144 may be shifted by the seventh displacement ΔG2x and the eighth displacement ΔG2y.

Therefore, gaps between the nanostructures NP belonging to different meta-regions within the central meta-group CG may be different from gaps between the nanostructures NP belonging to different meta-regions within the peripheral meta-group PG. In other words, a gap between a first nanostructure and a second nanostructure which belong to different meta-regions in the central meta-group CG may be different from a gap between a third nanostructure at the relatively same position as the first nanostructure of the central meta-group CG in the peripheral meta-group PG and a fourth nanostructure at the relatively same position as the second nanostructure of the central meta-group CG in the peripheral meta-group PG.

Because shift directions and shift amounts of the first meta-region 141, the second meta-region 142, the third meta-region 143, and the fourth meta-region 144 may vary depending on azimuth angle directions, gaps between the nanostructures NP belonging to different meta-regions within the peripheral meta-group PG having different azimuths may be different. In other words, a gap between a fifth nanostructure and a sixth nanostructure which belong to different meta-regions in a first peripheral meta-group may be different from a gap between a seventh nanostructure at the relatively same position as the fifth nanostructure of the first peripheral meta-group in a second peripheral meta-group and an eighth nanostructure at the relatively same position as the sixth nanostructure of the first peripheral meta-group in the second peripheral meta-group. The first peripheral meta-group may have a first azimuth angle and the second peripheral meta-group may have a second azimuth angle different from the first azimuth.

In each of the first meta-region 141, the second meta-region 142, the third meta-region 143, and the fourth meta-region 144 of the peripheral meta-group PG, the nanostructures NP belonging to different sub-regions may be shifted by the same distance in opposite directions with respect to the nanostructure NP belonging to an adjacent sub-region. Therefore, a gap between the nanostructures NP belonging to different sub-regions in one meta-region of the central meta-group CG may be different from a gap between the nanostructures NP belonging to different sub-regions in one meta-region of the peripheral meta-group PG. For example, a gap between a ninth nanostructure belonging to the first sub-region 141R1 of the first meta-region 141 of the central meta-group CG and a tenth nanostructure belonging to the second sub-region 141R2 of the first meta-region 141 of the central meta-group CG may be different from a gap between an eleventh nanostructure at the relatively same position as the ninth nanostructure of the central meta-group CG in the first meta-region 141 of the peripheral meta-group PG and a twelfth nanostructure at the relatively same position as the tenth nanostructure of the central meta-group CG in the first meta-region 141 of the peripheral meta-group PG.

Because shift directions and shift amounts of the sub-regions of the first meta-region 141, the second meta-region 142, the third meta-region 143, and the fourth meta-region 144 may vary depending on azimuth angle directions, gaps between the nanostructures NP belonging to different sub-regions within the peripheral meta-group PG having different azimuths may also be different. For example, a gap between a thirteenth nanostructure belonging to the first sub-region 141R1 of the first meta-region 141 of the first peripheral meta-group and a fourteenth nanostructure belonging to the second sub-region 141R2 of the first meta-region 141 of the first peripheral meta-group may be different from a gap between a fifteenth nanostructure at the relatively same position as the thirteenth nanostructure of the first peripheral meta-group in the first meta-region 141 of the second peripheral meta-group and a sixteenth nanostructure at the relatively same position as the fourteenth nanostructure of the first peripheral meta-group in the first meta-region 141 of the second peripheral meta-group. The first peripheral meta-group may have a first azimuth angle and the second peripheral meta-group may have a second azimuth angle different from the first azimuth.

According to an embodiment, the nanostructures NP at a boundary between meta-regions or a boundary between sub-regions within the unit meta-group 140G may be shifted by an average of shifts of the other adjacent nanostructures NP. Referring to FIG. 8, a first boundary nanostructure NP1 provided at the center of the unit meta-group 140G may be located at a boundary of all of the first meta-region 141, the second meta-region 142, the third meta-region 143, and the fourth meta-region 144. In the peripheral meta-group PG, the first boundary nanostructure NP1 may be shifted by an average of shifts of the first meta-region 141, the second meta-region 142, the third meta-region 143, and the fourth meta-region 144. Therefore, the first boundary nanostructure NP1 in the peripheral meta-group PG may be shifted by an average of the first displacement ΔG1x, the second displacement ΔG1y, the third displacement ΔBx, the fourth displacement ΔBy, the fifth displacement ΔRx, the sixth displacement ΔRy, the seventh displacement ΔG2x, and the eighth displacement ΔG2y. Here, the average may be an average considering both directions and numerical values. In an example case in which the first meta-region 141, the second meta-region 142, the third meta-region 143, and the fourth meta-region 144 are symmetrically shifted relative to each other, the relative position of the first boundary nanostructure NP1 within the peripheral meta-group PG may not change and may be the same as the relative position of the first boundary nanostructure NP1 within the central meta-group CG.

A second boundary nanostructure NP2 provided at the center of the first meta-region 141 may be located at a boundary of all of the first sub-region 141R1, the second sub-region 141R2, the third sub-region 141R3, and the fourth sub-region 141R4. Therefore, a sub-displacement of the second boundary nanostructure NP2 may be an average of sub-displacements of the first sub-region 141R1, the second sub-region 141R2, the third sub-region 141R3, and the fourth sub-region 141R4. Because the first sub-region 141R1, the second sub-region 141R2, the third sub-region 141R3, and the fourth sub-region 141R4 are symmetrically shifted relative to each other, the sub-displacement of the second boundary nanostructure NP2 may be zero. Therefore, the second boundary nanostructure NP2 may be shifted only by the first displacement ΔG1x and the second displacement ΔG1y along the first meta-region 141, and may not be further shifted.

Therefore, a gap between the second boundary nanostructure NP2 and any one nanostructure in the first sub-region 141R1, the second sub-region 141R2, the third sub-region 141R3, and the fourth sub-region 141R4 may vary depending on the position of the unit meta-group 140G. For example, a gap between the second boundary nanostructure NP2 in the central meta-group CG and a seventeenth nanostructure inside the first sub-region 141R1 of the first meta-region 141 in the central meta-group CG may be different from a gap between the second boundary nanostructure NP2 in the peripheral meta-group PG and an eighteenth nanostructure at the relatively same position as the seventeenth nanostructure of the central meta-group CG in the peripheral meta-group PG. In addition, a gap between the second boundary nanostructure NP2 and a nineteenth nanostructure inside the first sub-region 141R1 of the first meta-region 141 in the first peripheral meta-group having the first azimuth angle may be different from a gap between the second boundary nanostructure NP2 and a twentieth nanostructure at the relatively same position as the nineteenth nanostructure of the first peripheral meta-group in the second peripheral meta-group having the second azimuth.

A sub-displacement of a third boundary nanostructure NP3 provided at a boundary between the third sub-region 141R3 and the fourth sub-region 141R4 in the first meta-region 141 may be zero in the X-axis because the third sub-region 141R3 and the fourth sub-region 141R4 are symmetrically shifted in opposite directions in the X-axis. Therefore, a gap in the first direction between the third boundary nanostructure NP3 in the central meta-group CG and a twenty-first nanostructure inside the third sub-region 141R3 of the first meta-region 141 in the central meta-group CG may be different from a gap in the first direction between the third boundary nanostructure NP3 in the peripheral meta-group PG and a twenty-second nanostructure at the relatively same position as the twenty-first nanostructure of the central meta-group CG in the peripheral meta-group PG. The third boundary nanostructure NP3 may be shifted by the second sub-displacement ΔG1'y in the second direction together with the third sub-region 141R3 and the fourth sub-region 141R4.

A sub-displacement of a fourth boundary nanostructure NP4 provided at a boundary between the first sub-region 141R1 and the third sub-region 141R3 in the first meta-region 141 may be zero in the Y-axis because the first sub-region 141R1 and the third sub-region 141R3 are symmetrically shifted in opposite directions in the Y-axis. Therefore, a gap in the second direction between the fourth boundary nanostructure NP4 in the central meta-group CG and a twenty-third nanostructure inside the first sub-region 141R1 of the first meta-region 141 may be different from a gap in the second direction between the fourth boundary nanostructure NP4 in the peripheral meta-group PG and a twenty-fourth nanostructure at the relatively same position as the twenty-third nanostructure of the central meta-group CG in the peripheral meta-group PG. The fourth boundary nanostructure NP4 may be shifted by the first sub-displacement ΔG1'x in the first direction together with the first sub-region 141R1 and the third sub-region 141R3.

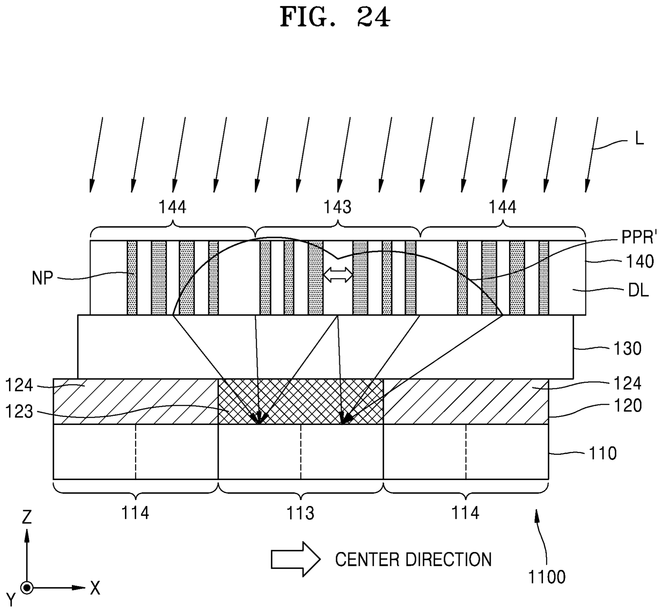

FIG. 24 is a cross-sectional view showing a phase profile and a concentration action of red light by the nano-photonic lens array 140 at the periphery of the nano-photonic lens array 140. Referring to FIG. 24, the red light passing through the nano-photonic lens array 140 in the light L incident on the nano-photonic lens array 140 may have a red light phase profile PPR' having two peaks within the third meta-region 143 and being the smallest at the center of the fourth meta-region 144 in a first direction. The red light phase profile PPR' shown in FIG. 24 may be different from the red light phase profile PPR shown in FIG. 10. For example, the red light phase profile PPR' may have a shape descending obliquely toward the center of the nano-photonic lens array 140, and may have an asymmetrically curved shape with respect to two phase delay peaks. In addition, the two phase delay peaks are shifted toward the center of the nano-photonic lens array 140. According to an embodiment, by forming the red light phase profile PPR' as shown in FIG. 24, a red light concentration region may be formed around the center of each of the first sub-pixel P1, the second sub-pixel P2, the third sub-pixel P3, and the fourth sub-pixel P4 of the third pixel 113 even at the periphery of the nano-photonic lens array 140 in which the incident light is obliquely incident.

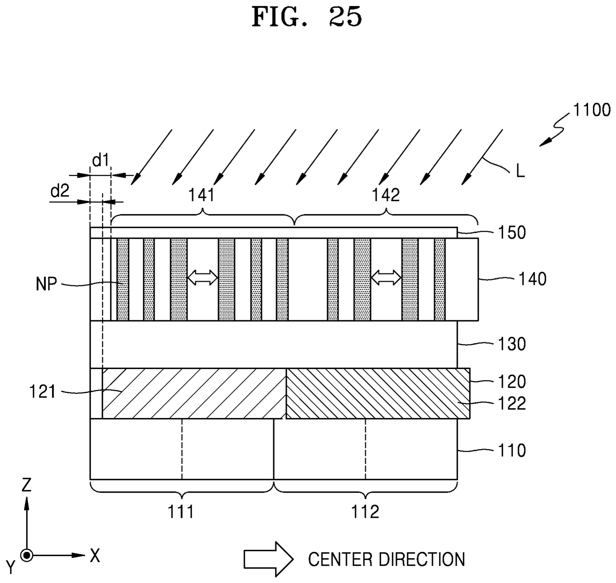

FIG. 25 is a cross-sectional view showing shifts of color filters of the color filter layer 120 and meta-regions of the nano-photonic lens array 140 at the periphery of the nano-photonic lens array 140 according to another embodiment. Referring to FIG. 25, not only the meta-regions of the nano-photonic lens array 140 but also the color filters of the color filter layer 120 may be shifted in a direction in which light is incident on the corresponding pixels at the periphery of the pixel array 1100 or the periphery of the nano-photonic lens array 140. In other words, the first color filter 121, the second color filter 122, the third color filter 123, and the fourth color filter 124 of the color filter layer 120 may be shifted toward the center of the pixel array 1100 or the center of the nano-photonic lens array 140 with respect to the first pixel 111, the second pixel 112, the third pixel 113, and the fourth pixel 114 corresponding thereto.

For example, the first color filter 121, the second color filter 122, the third color filter 123, and the fourth color filter 124 of the color filter layer 120 may be shifted by the second distance d2 toward the center of the nano-photonic lens array 140 or the center of the pixel array 1100 with respect to the first pixel 111, the second pixel 112, the third pixel 113, and the fourth pixel 114 corresponding thereto. The first meta-region 141, the second meta-region 142, the third meta-region 143, and the fourth meta-region 144 of the nano-photonic lens array 140 may be shifted by the first distance d1 toward the center of the nano-photonic lens array 140 or the center of the pixel array 1100 with respect to the first pixel 111, the second pixel 112, the third pixel 113, and the fourth pixel 114 corresponding thereto. The first distance d1 may be greater than the second distance d2. In other words, shift distances of the first meta-region 141, the second meta-region 142, the third meta-region 143, and the fourth meta-region 144 may be respectively greater than shift distances of the first color filter 121, the second color filter 122, the third color filter 123, and the fourth color filter 124. Therefore, boundaries of corresponding pixels, color filters, and meta-regions may not coincide with each other in a first direction and a second direction at the periphery of the nano-photonic lens array 140 or the periphery of the pixel array 1100.

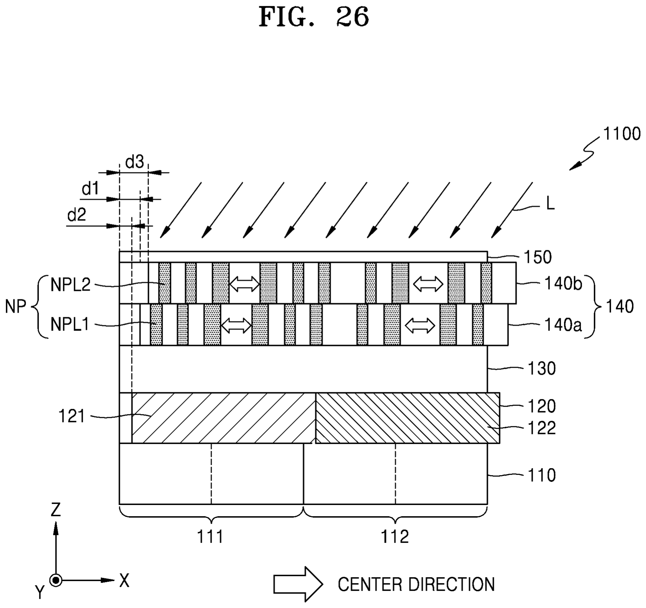

FIG. 25 is a cross-sectional view showing shifts of color filters of the color filter layer 120 and meta-regions of the nano-photonic lens array 140 at the periphery of the nano-photonic lens array 140 according to another embodiment. Referring to FIG. 26, the nano-photonic lens array 140 may have a multilayer structure of two or more layers. For example, the nano-photonic lens array 140 may include a first nano-photonic lens array layer 140a provided on the spacer layer 130 and a second nano-photonic lens array layer 140b provided on the first nano-photonic lens array layer 140a. The first nano-photonic lens array layer 140a may include a plurality of first layer nanostructures NPL1, and the second nano-photonic lens array layer 140b may include a plurality of second layer nanostructures NPL2.

Meta-regions of the first nano-photonic lens array layer 140a may be shifted by the first distance d1 toward the center of the nano-photonic lens array 140 or the center of the pixel array 1100 with respect to the first pixel 111, the second pixel 112, the third pixel 113, and the fourth pixel 114 corresponding thereto. Meta-regions of the second nano-photonic lens array layer 140b may be shifted by a third distance d3 toward the center of the nano-photonic lens array 140 or the center of the pixel array 1100 with respect to the first pixel 111, the second pixel 112, the third pixel 113, and the fourth pixel 114 corresponding thereto. The third distance d3 may be greater than the first distance d1. In other words, shift distances of the meta-regions of the second nano-photonic lens array layer 140b may be respectively greater than shift distances of the meta-regions of the first nano-photonic lens array layer 140a.

In addition, the meta-regions and sub-regions of the first nano-photonic lens array layer 140a and the meta-regions and sub-regions of the second nano-photonic lens array layer 140b may be independently shifted. For example, values of Gx_sym, Gy_sym, B_sym, R_sym, Gx_asym, Gy_asym, B_asym, and R_asym in the first nano-photonic lens array layer 140a may be respectively different from values of Gx_sym, Gy_sym, B_sym, R_sym, Gx_asym, Gy_asym, B_asym, and R_asym in the second nano-photonic lens array layer 140b.

The image sensor 1000 according to an embodiment may have improved light utilization efficiency. In addition, the image sensor 1000 according to the above-described embodiment may provide a more improved autofocus signal, and may maintain relatively uniform sensitivity and performance in a plurality of pixels. The image sensor 1000 according to an embodiment may constitute a camera module together with a module lens having various performances, and may be used in various electronic devices.

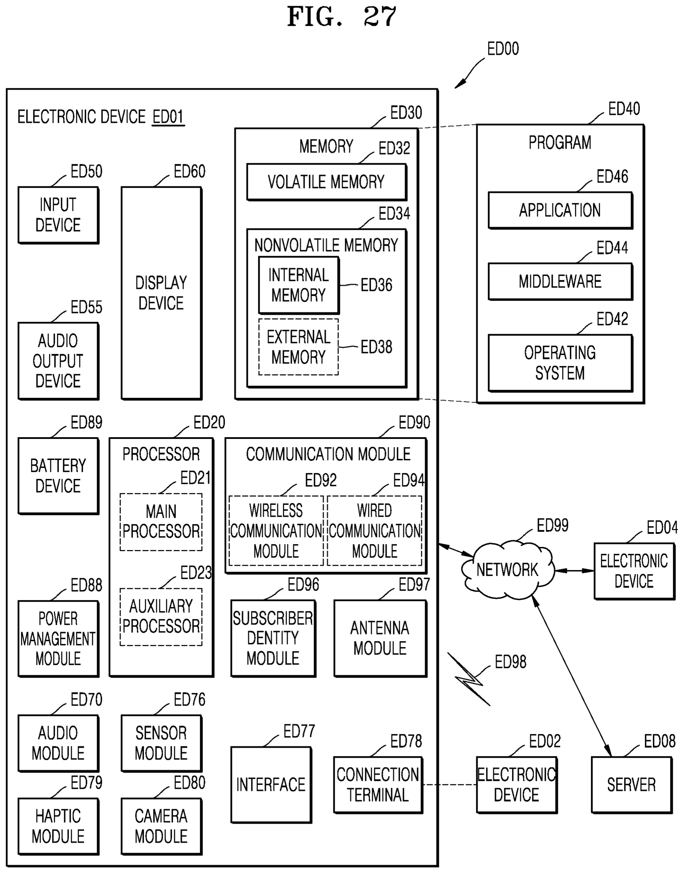

FIG. 27 is a block diagram showing an example of an electronic apparatus ED01 including the image sensor 1000. Referring to FIG. 27, in a network environment ED00, the electronic apparatus ED01 may communicate with another electronic apparatus ED02 through a first network ED98 (short-range wireless communication network, etc.), or may communicate with another electronic apparatus ED04 and/or a server ED08 through a second network ED99 (long-range wireless communication network, etc.) The electronic apparatus ED01 may communicate with the electronic apparatus ED04 through the server ED08. The electronic apparatus ED01 may include a processor ED20, a memory ED30, an input device ED50, a sound output device ED55, a display device ED60, an audio module ED70, a sensor module ED76, an interface ED77, a haptic module ED79, a camera module ED80, a power management module ED88, a battery ED89, a communication module ED90, a subscriber identification module ED96, and/or an antenna module ED97. In the electronic apparatus ED01, some (the display device ED60, etc.) of the elements may be omitted or another element may be added. Some of the elements may be configured as one integrated circuit. For example, the sensor module ED76 (a fingerprint sensor, an iris sensor, an illuminance sensor, etc.) may be embedded and implemented in the display device ED60 (display, etc.)

The processor ED20 may control one or more elements (hardware and software elements, etc.) of the electronic apparatus ED01 connected to the processor ED20 by executing software (program ED40, etc.) and may perform various data processing or operations. As a part of the data processing or operations, the processor ED20 may load a command and/or data received from another element (sensor module ED76, communication module ED90, etc.) to a volatile memory ED32, may process the command and/or data stored in the volatile memory ED32, and may store result data in a non-volatile memory ED34. The processor ED20 may include a main processor ED21 a (central processing unit, an application processor, etc.) and an auxiliary processor ED23 (a graphics processing unit, an image signal processor, a sensor hub processor, a communication processor, etc.) that may operate independently from or along with the main processor ED21. The auxiliary processor ED23 may use less power than that of the main processor ED21 and may perform specialized functions.

The auxiliary processor ED23, on behalf of the main processor ED21 while the main processor ED21 is in an inactive state (sleep state) or along with the main processor ED21 while the main processor ED21 is in an active state (application executed state), may control functions and/or states related to some (the display device ED60, the sensor module ED76, the communication module ED90, etc.) of the elements in the electronic apparatus ED01. The auxiliary processor ED23 (an image signal processor, a communication processor, etc.) may be implemented as a part of another element (the camera module ED80, the communication module ED90, etc.) that is functionally related thereto.

The memory ED30 may store various data required by the elements (the processor ED20, the sensor module ED76, etc.) of the electronic apparatus ED01. The data may include, for example, input data and/or output data about software (program ED40, etc.) and commands related thereto. The memory ED30 may include the volatile memory ED32 and/or the non-volatile memory ED34.

The program ED40 may be stored as software in the memory ED30 and may include an operation system ED42, middleware ED44, and/or an application ED46.

The input device ED50 may receive commands and/or data to be used in the elements (the processor ED20, etc.) of the electronic apparatus ED01, from outside (a user, etc.) of the electronic apparatus ED01. The input device ED50 may include a microphone, a mouse, a keyboard, and/or a digital pen (stylus pen).

The sound output device ED55 may output a sound signal to outside of the electronic apparatus ED01. The sound output device ED55 may include a speaker and/or a receiver. The speaker may be used for a general purpose such as multimedia reproduction or record play, and the receiver may be used to receive a call. The receiver may be coupled as a part of the speaker or may be implemented as an independent device.

The display device ED60 may provide visual information to outside of the electronic apparatus ED01. The display device ED60 may include a display, a hologram device, or a projector, and a control circuit for controlling the corresponding device. The display device ED60 may include touch circuitry set to sense a touch, and/or a sensor circuit (pressure sensor, etc.) that is set to measure the strength of a force generated by the touch.

The audio module ED70 may convert sound into an electrical signal or vice versa. The audio module ED 70 may obtain sound through the input device ED50, or may output sound through the sound output device ED55 and/or a speaker and/or a headphone of another electronic apparatus (the electronic apparatus ED02, etc.) connected directly or wirelessly to the electronic apparatus ED01.

The sensor module ED76 may sense an operating state (power, temperature, etc.) of the electronic apparatus ED01, or an outer environmental state (user state, etc.) and may generate an electrical signal and/or data value corresponding to the sensed state. The sensor module ED76 may include a gesture sensor, a gyro-sensor, a pressure sensor, a magnetic sensor, an acceleration sensor, a grip sensor, a proximity sensor, a color sensor, an infrared (IR) ray sensor, a vivo sensor, a temperature sensor, a humidity sensor, and/or an illuminance sensor.

The interface ED77 may support one or more designated protocols that may be used in order for the electronic apparatus ED01 to be directly or wirelessly connected to another electronic apparatus (the electronic apparatus ED02, etc.) The interface ED77 may include a high-definition multimedia interface (HDMI), a universal serial bus (USB) interface, an SD card interface, and/or an audio interface.

The connection terminal ED78 may include a connector by which the electronic apparatus ED01 may be physically connected to another electronic apparatus (the electronic apparatus ED02, etc.) The connection terminal ED78 may include an HDMI connector, a USB connector, an SD card connector, and/or an audio connector (a headphone connector, etc.)

The haptic module ED79 may convert the electrical signal into a mechanical stimulation (vibration, motion, etc.) or an electric stimulation that the user may sense through a tactile or motion sensation. The haptic module ED79 may include a motor, a piezoelectric device and/or an electric stimulus device.

The camera module ED80 may capture a still image and a video. The camera module ED80 may include a lens assembly including one or more lenses, the image sensor 1000 of FIG. 1, image signal processors, and/or flashes. The lens assembly included in the camera module ED80 may collect light emitted from a subject that is to be captured.

The power management module ED88 may manage the power supplied to the electronic apparatus ED01. The power management module ED88 may be implemented as a part of a power management integrated circuit (PMIC).

The battery ED89 may supply electric power to elements of the electronic apparatus ED01. The battery ED89 may include a primary battery that is not rechargeable, a secondary battery that is rechargeable, and/or a fuel cell.

The communication module ED90 may support the establishment of a direct (wired) communication channel and/or a wireless communication channel between the electronic apparatus ED01 and another electronic apparatus (the electronic apparatus ED02, the electronic apparatus ED04, the server ED08, etc.), and execution of communication through the established communication channel. The communication module ED90 may be operated independently from the processor ED20 (application processor, etc.) and may include one or more communication processors that support direct communication and/or wireless communication. The communication module ED90 may include a wireless communication module ED92 (a cellular communication module, a short-range wireless communication module, a global navigation satellite system (GNSS) communication module) and/or a wired communication module ED94 (a local area network (LAN) communication module, a power line communication module, etc.) From among the communication modules, a corresponding communication module may communicate with another electronic apparatus through the first network ED98 (short-range communication network such as Bluetooth, WiFi direct, or infrared data association (IrDA)) or a second network ED99 (long-range communication network such as a cellular network, Internet, or computer network (LAN, WAN, etc.)). Such various kinds of communication modules may be integrated as one element (single chip, etc.) or may be implemented as a plurality of elements (a plurality of chips) separately from one another. The wireless communication module ED92 may identify and authenticate the electronic apparatus ED01 in a communication network such as the first network ED98 and/or the second network ED99 by using subscriber information (international mobile subscriber identifier (IMSI), etc.) stored in the subscriber identification module ED96.

The antenna module ED97 may transmit or receive the signal and/or power to/from outside (another electronic apparatus, etc.) An antenna may include a radiator formed as a conductive pattern formed on a substrate (PCB, etc.) The antenna module ED97 may include one or more antennas. In an example case in which the antenna module ED97 includes a plurality of antennas, from among the plurality of antennas, an antenna that is suitable for the communication type used in the communication network such as the first network ED98 and/or the second network ED99 may be selected by the communication module ED90. The signal and/or the power may be transmitted between the communication module ED90 and another electronic apparatus through the selected antenna. Parts (RFIC, etc.) other than the antenna may be included as a part of the antenna module ED97.

Some of the elements may be connected to one another through communication methods among the peripheral devices (bus, general purpose input and output (GPIO), serial peripheral interface (SPI), mobile industry processor interface (MIPI), etc.) and may exchange signals (commands, data, etc.)

The command or data may be transmitted or received between the electronic apparatus ED01 and the external electronic apparatus ED04 through the server ED08 connected to the second network ED99. The other electronic apparatuses ED02 and ED04 may be the devices that are the same as or different kinds from the electronic apparatus ED01. All or some of the operations executed in the electronic apparatus ED01 may be executed in one or more devices among the other electronic apparatuses ED02, ED04, and ED08. In an example case in which the electronic apparatus ED01 needs to perform a certain function or service, the electronic apparatus ED01 may request one or more other electronic apparatuses to perform some or entire function or service, instead of executing the function or service by itself. One or more electronic apparatuses receiving the request execute an additional function or service related to the request and may transfer a result of the execution to the electronic apparatus ED01. To this end, a cloud computing technique, a distributed computing technique, or a client-server computing technique may be used.

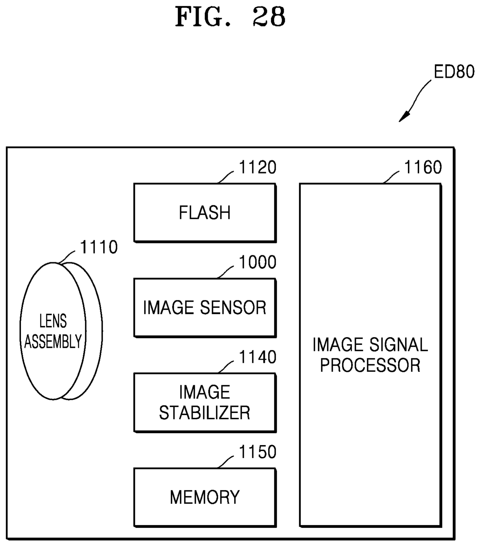

FIG. 28 is a block diagram showing an example of the camera module ED80 included in the electronic apparatus ED01 of FIG. 27. Referring to FIG. 28, the camera module ED80 may include a lens assembly 1110, a flash 1120, the image sensor 1000, an image stabilizer 1140, a memory 1150 (buffer memory, etc.), and/or an image signal processor 1160. The lens assembly 1110 may collect light emitted from a subject that is to be captured. The camera module ED80 may include a plurality of lens assemblies 1110, and in this case, the camera module ED80 may include a dual camera module, a 360-degree camera, or a spherical camera. Some of the plurality of lens assemblies 1110 may have the same lens properties (viewing angle, focal length, auto-focus, F number, optical zoom, etc.) or different lens properties. The lens assembly 1110 may include a wide-angle lens or a telephoto lens.

The flash 1120 may emit light that is used to strengthen the light emitted or reflected from the subject. The flash 1120 may emit visible light or infrared-ray light. The flash 1120 may include one or more light-emitting diodes (red-green-blue (RGB)) LED, white LED, infrared LED, ultraviolet LED, etc.), and/or a Xenon lamp. The image sensor 1000 may be the image sensor described above with reference to FIG. 1, and convert the light emitted or reflected from the subject and transferred through the lens assembly 1110 into an electrical signal to obtain an image corresponding to the object.

The image stabilizer 1140 may, in response to a motion of the camera module ED80 or the electronic apparatus 1101 including the camera module ED80, move one or more lenses included in the lens assembly 1110 or the image sensor 1000 in a certain direction or control the operating characteristics of the image sensor 1000 (adjusting of a read-out timing, etc.) in order to compensate for a negative influence of the motion. The image stabilizer 1140 may sense the movement of the camera module ED80 or the electronic apparatus ED01 by using a gyro sensor or an acceleration sensor provided inside or outside the camera module ED80. The image stabilizer 1140 may be implemented as an optical type.

The memory 1150 may store partial or entire data of the image obtained through the image sensor 1000 for next image processing operation. In an example case in which a plurality of images are obtained at a high speed, the plurality of images may be used to store obtained original data (Bayer-patterned data, high-resolution data, etc.) in the memory 1150, display only a low-resolution image, and then transfer original data of a selected image (user selection, etc.) to the image signal processor 1160. The memory 1150 may be integrated with the memory ED30 of the electronic apparatus ED01, or may include an additional memory that is operated independently.

The image signal processor 1160 may perform image processing operations on the image obtained through the image sensor 1000 or the image data stored in the memory 1150. The image processing operations may include a depth map generation, a three-dimensional modeling, a panorama generation, extraction of features, an image combination, and/or an image compensation (noise reduction, resolution adjustment, brightness adjustment, blurring, sharpening, softening, etc.) The image signal processor 1160 may perform controlling (exposure time control, read-out timing control, etc.) of the elements (image sensor 1000, etc.) included in the camera module ED80. In addition, the image signal processor 1160 may generate a full-color image by executing the above-described demosaic algorithm. For example, when executing the demosaic algorithm to generate the full-color image, the image signal processor 1160 may reconstruct most of the spatial resolution information by using an image signal of a green channel or a yellow channel having high spatial sampling rate.

The image processed by the image signal processor 1160 may be stored again in the memory 1150 for additional process, or may be provided to an external element (e.g., the memory ED30, the display device ED60, the electronic apparatus ED02, the electronic apparatus ED04, the server ED08, etc.) of the camera module ED80. The image signal processor 1160 may be integrated with the processor ED20, or may be configured as an additional processor that is independently operated from the processor ED20. In an example case in which the image signal processor 1160 is configured as an additional processor separately from the processor ED20, the image processed by the image signal processor 1160 may undergo through an additional image processing by the processor ED20 and then be displayed on the display device ED60.

In addition, the image signal processor 1160 may receive two output signals independently from adjacent photosensitive cells in each pixel or sub-pixel of the image sensor 1000, and may generate an auto-focusing signal from a difference between the two output signals. The image signal processor 1160 may control the lens assembly 1110 such that the focus of the lens assembly 1110 may be accurately formed on the surface of the image sensor 1000 based on the auto-focusing signal.

The electronic apparatus ED01 may further include one or a plurality of camera modules having different properties or functions. The camera module may include elements similar to those of the camera module ED80 of FIG. 23, and the image sensor included in the camera module may be implemented as a CCD sensor and/or a CMOS sensor and may include one or a plurality of sensors selected from the image sensors having different properties, such as an RGB sensor, a black and white (BW) sensor, an IR sensor, or a UV sensor. In this case, one of the plurality of camera modules ED80 may include a wide-angle camera and another camera module ED80 may include a telephoto camera. Similarly, one of the plurality of camera modules ED80 may include a front camera and another camera module ED80 may include a rear camera.

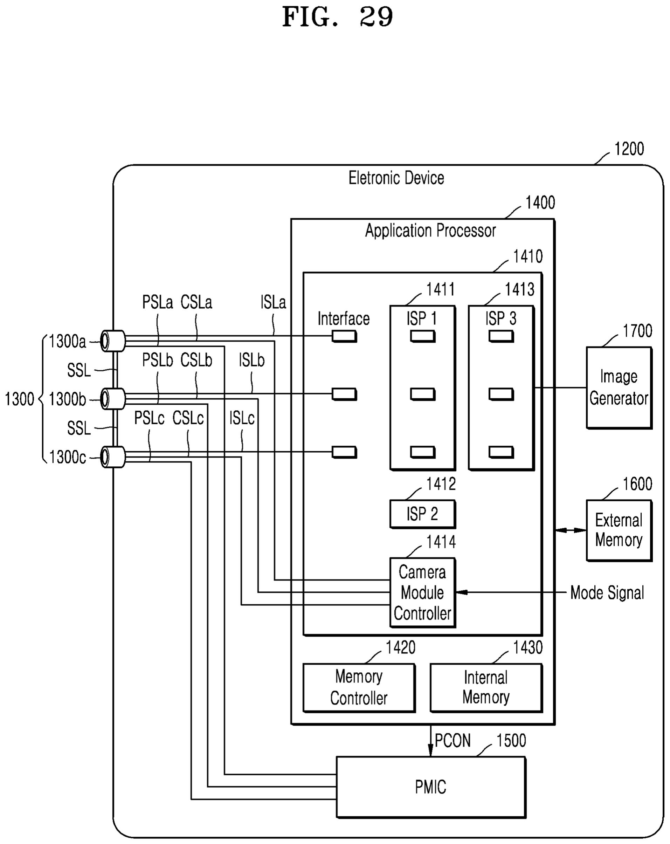

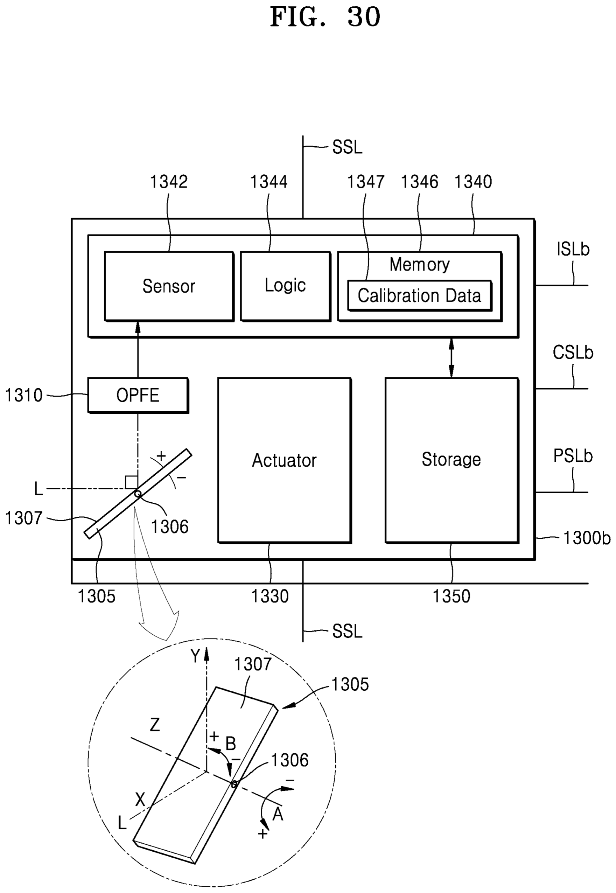

FIG. 29 is a block diagram of an electronic device 1200 including a multi-camera module. FIG. 30 is a detailed block diagram of the multi-camera module in the electronic device of FIG. 29.

Referring to FIG. 29, the electronic device 1200 may include a camera module group 1300, an application processor 1400, a PMIC 1500, an external memory 1600, and an image generator 1700

The camera module group 1300 may include a plurality of camera modules 1300a, 1300b, and 1300c. The drawings show an example in which three camera modules 1300a, 1300b, and 1300c are arranged, but embodiments are not limited thereto. In some embodiments, the camera module group 1300 may be modified to include only two camera modules. In addition, in some embodiments, the camera module group 1300 may be modified to include n (n is 4 or greater natural number) camera modules.

Hereinafter, detailed configuration of one camera module 1300b is described in detail below with reference to FIG. 30, but the description provided below may be also applied to the other camera modules 1300a and 1300c according to the embodiment.

Referring to FIG. 30, the camera module 1300b may include a prism 1305, an optical path folding element (OPFE) 1310, an actuator 1330, an image sensing device 1340, and a storage 1350.

The prism 1305 may include a reflecting surface 1307 of a light-reflecting material and may deform a path of light L incident from outside.

In some embodiments, the prism 1305 may change the path of the light L incident in the first direction (X-direction) into a second direction (Y-direction) that is perpendicular to the first direction (X-direction). In addition, the prism 1305 may rotate the reflecting surface 1307 having the light-reflecting material about a center axis 1306 in a direction A, or about the center axis 1306 in a direction B such that the path of the light L incident in the first direction (X-direction) may be changed to the second direction (Y-direction) perpendicular to the first direction (X-direction). Here, the OPFE 1310 may also move in the third direction (Z-direction) that is perpendicular to the first direction (X-direction) and the second direction (Y-direction).

In some embodiments, as shown in the drawings, the maximum rotation angle of the prism 1305 in the direction A is 15 degrees or less in the positive A direction and is greater than 15 degrees in the negative A direction, but the embodiments are not limited thereto.

In some embodiments, the prism 1305 may be moved by the angle of about 20 degrees, or between 10 degrees to 20 degrees or 15 degrees to 20 degrees in the positive or negative B direction. Here, the moving angle is the same in the positive or negative B direction, or may be similar within a range of about 1 degrees

In some embodiments, the prism 1305 may move the reflecting surface 1307 of the light-reflective material in the third direction (e.g., Z direction) that is parallel to the direction in which the center axis 1306 extends.

The OPFE 1310 may include, for example, optical lenses formed as m groups (here, m is a natural number). Here, m lenses may move in the second direction (Y-direction) and change an optical zoom ratio of the camera module 1300b. In an example case in which a basic optical zoom ratio of the camera module 1300b is Z and m optical lenses included in the OPFE 1310 move, the optical zoom ratio of the camera module 1300b may be changed to 3Z, 5Z, or 10Z or greater.

The actuator 1330 may move the OPFE 1310 or the optical lens (hereinafter, referred to as optical lens) to a certain position. For example, the actuator 1330 may adjust the position of the optical lens such that the image sensor 1342 may be located at a focal length of the optical lens for an exact sensing operation.

The image sensing device 1340 may include the image sensor 1342, a control logic 1344, and a memory 1346. The image sensor 1342 may sense an image of a sensing target by using the light L provided through the optical lens. The control logic 1344 may control the overall operation of the camera module 1300b. For example, the control logic 1344 may control the operations of the camera module 1300b according to a control signal provided through a control signal line CSLb.

For example, the image sensor 1342 may include the color separating lens array or the nano-photonic lens array described above. The image sensor 1342 may receive more signals separated according to wavelengths in each pixel by using the color separating lens array based on the nano-structures. Due to such effects, the optical intensity required to generate high quality images of high resolution and low illuminance may be secured.

The memory 1346 may store information necessary for the operation of the camera module 1300b, e.g., calibration data 1347. The calibration data 1347 may include information necessary to generate image data by using the light L provided from outside through the camera module 1300b. The calibration data 1347 may include, for example, information about the degree of rotation described above, information about the focal length, information about an optical axis, etc. In an example case in which the camera module 1300b is implemented in the form of a multi-state camera of which the focal length is changed according to the position of the optical lens, the calibration data 1347 may include information related to focal length values of the optical lens according to each position (or state) and auto-focusing.

The storage 1350 may store image data sensed through the image sensor 1342. The storage 1350 may be provided outside the image sensing device 1340 and stacked with a sensor chip included in the image sensing device 1340. In some embodiments, the storage 1350 may be implemented as electrically erasable programmable read-only memory (EEPROM), but embodiments are not limited thereto.

Referring to FIGS. 29 and 30, in some embodiments, each of the plurality of camera modules 1300a, 1300b, and 1300c may include the actuator 1330. Accordingly, each of the plurality of camera modules 1300a, 1300b, and 1300c may include the calibration data 1347 that is the same as or different from the others, according to the operation of the actuator 1330 included therein.

In some embodiments, one (e.g., 1300b) of the plurality of camera modules 1300a, 1300b, and 1300c may be a camera module in a folded lens type including the prism 1305 and the OPFE 1310 described above, and the other camera modules (e.g., 1300a and 1300c) may be vertical type camera modules not including the prism 1305 and the OPFE 1310, but embodiments are not limited thereto.

In some embodiments, one (e.g., 1300c) of the plurality of camera modules 1300a, 1300b, and 1300c may be a depth camera of a vertical type, which extracts depth information by using infrared ray (IR).

In some embodiments, at least two camera modules (e.g., 1300a and 1300b) among the plurality of camera module 1300a, 1300b, and 1300c may have different fields of view. In this case, for example, the optical lenses of the at least two camera modules (e.g., 1300a and 1300b) among the plurality of camera modules 1300a, 1300b, and 1300c may be different from each other, but embodiments are not limited thereto.

In addition, in some embodiments, the plurality of camera modules 1300a, 1300b, and 1300c may have different fields of view from one another. In this case, the optical lenses respectively included in the plurality of camera modules 1300a, 1300b, and 1300c may be different from one another, but embodiments are not limited thereto.

In some embodiments, the plurality of camera modules 1300a, 1300b, and 1300c may be physically separated from one another. That is, a sensing region of one image sensor 1342 may not be divided and used by the plurality of camera modules 1300a, 1300b, and 1300c, but the plurality of camera modules 1300a, 1300b, and 1300c may each have an independent image sensor 1342 provided therein.

Referring back to FIG. 29, the application processor 1400 may include an image processing device 1410, a memory controller 1420, and an internal memory 1430. The application processor 1400 may be separately implemented from the plurality of camera modules 1300a, 1300b, and 1300c. For example, the application processor 1400 and the plurality of camera modules 1300a, 1300b, and 1300c may be separately implemented as separate semiconductor chips.

The image processing device 1410 may include a plurality of image processors 1411, 1412, and 1413, and a camera module controller 1414.

The image data generated by each of the camera modules 1300a, 1300b, and 1300c may be provided to the image processing device 1410 through separate image signal lines ISLa, ISLb, and ISLc, respectively. The image data transfer may be performed, for example, by using a camera serial interface (CSI) based on a mobile industry processor interface (MIPI), but embodiments are not limited thereto.

The image data transferred to the image processing device 1410 may be stored in an external memory 1600 before being transferred to the image processors 1411 and 1412. The image data stored in the external memory 1600 may be provided to the image processor 1411 and/or the image processor 1412. The image processor 1411 may correct the image data in order to generate video. The image processor 1412 may correct the image data in order to generate still images. For example, the image processors 1411 and 1412 may perform a pre-processing operation such as a color calibration, a gamma calibration on the image data.

The image processor 1411 may include sub-processors. In an example case in which the number of sub-processors is equal to the number of camera modules 1300a, 1300b, and 1300c, each of the sub-processors may process the image data provided from one camera module. In an example case in which the number of sub-processors is less than the number of camera modules 1300a, 1300b, and 1300c, at least one of the sub-processors may process the image data provided from a plurality of camera module by using a timing-sharing process. The image data processed by the image processor 1411 and/or the image processor 1412 may be stored in the external memory 1600 before being transferred to the image processor 1413. The image data stored in the external memory 1600 may be transferred to the image processor 1412. The image processor 1412 may perform a post-processing operation such as a noise calibration, a sharpen calibration, etc. on the image data.

The image data processed in the image processor 1413 may be provided to the image generator 1700. The image generator 1700 may generate a final image by using the image data provided from the image processor 1413 according to image generating information or a mode signal.

Specifically, the image generator 1700 may generate an output image by merging at least parts of the image data generated by the camera modules 1300a, 1300b, and 1300c having different fields of view, according to the image generating information or the mode signal. In addition, the image generator 1700 may generate the output image by selecting one of pieces of image data generated by the camera modules 1300a, 1300b, and 1300c having different fields of view, according to the image generating information or the mode signal.

In some embodiments, the image generating information may include a zoom signal or a zoom factor. In addition, in some embodiments, the mode signal may be, for example, a signal based on a mode selected by a user.

In an example case in which the image generating information is a zoom signal (zoom factor) and the camera modules 1300a, 1300b, and 1300c have different fields of view (angles of view) from one another, the image generator 1700 may perform different operations according to the kind of zoom signal. In an example case in which the zoom signal is a first signal, the image generator 1700 may merge the image data output from the camera module 1300a with the image data output from the camera module 1300c, and then, generate the output image by using the merged image signal and the image data output from the camera module 1300b and not used in the merge. In an example case in which the zoom signal is a second signal that is different from the first signal, the image generator 1700 may not perform the image data merging, and then, may generate the output image by selecting one piece of the image data output respectively from the camera modules 1300a, 1300b, and 1300c. However, embodiments are not limited thereto, and the method of processing the image data may be modified as necessary.

The camera module controller 1414 may provide each of the camera modules 1300a, 1300b, and 1300c with a control signal. The control signals generated by the camera module controller 1414 may be provided to corresponding camera modules 1300a, 1300b, and 1300c through control signal lines CSLa, CSLb, and CSLc separated from one another.

In some embodiments, the control signal provided to the plurality of camera modules 1300a, 1300b, and 1300c from the camera module controller 1414 may include mode information according to the mode signal. The plurality of camera modules 1300a, 1300b, and 1300c may operate in a first operation mode and a second operation mode in relation to the sensing speed, based on the mode information.

In the first operation mode, the plurality of camera modules 1300a, 1300b, and 1300c may generate the image signal at a first speed (for example, generating an image signal of a first frame rate), encode the image signal at a second speed that is faster than the first speed (for example, encoding the image signal of a second frame rate that is greater than the first frame rate), and transmit the encoded image signal to the application processor 1400. In this regard, the second speed may be 30 times faster than the first speed or less.

The application processor 1400 may store the received image signal, that is, the encoded mage signal, in the internal memory 1430 provided therein or the external memory 1600 outside the application processor 1400, then, read and decode the encoded signal from the internal memory 1430 or the external memory1600, and display the image data generated based on the decoded image signal. For example, the image processors 1411 and 1412 in the image processing device 1410 may perform decoding, and may perform image processing on the decoded image signals.

In the second operation mode, the plurality of camera modules 1300a, 1300b, and 1300c may generate an image signal at a third speed that is slower than the first speed (for example, generating the image signal of a third frame rate that is lower than the first frame rate), and transmit the image signal to the application processor 1400. The image signal provided to the application processor 1400 may be a signal that is not encoded. The application processor 1400 may perform image processing of the received image signal or store the image signal in the internal memory 1430 or the external memory 1600.

The PMIC 1500 may supply power, for example, power voltage, to each of the plurality of camera modules 1300a, 1300b, and 1300c. For example, the PMIC 1500 may supply first power to the camera module 1300a through a power signal line PSLa, second power to the camera module 1300b through a power signal line PSLb, and third power to the camera module 1300c through a power signal line PSLc, by the control of the application processor 1400.

The PMIC 1500 may generate the power corresponding to each of the plurality of camera modules 1300a, 1300b, and 1300c and adjust the power level, based on (or in response to) a power control signal PCON from the application processor 1400. The power control signal PCON may include a power adjusting signal for each operation mode of the plurality of camera modules 1300a, 1300b, and 1300c. For example, the operation mode may include a low power mode, and the power control signal PCON may include information about the camera module operating in the lowpower mode and set power level. The levels of the power provided to the plurality of camera modules 1300a, 1300b, and 1300c may be equal to or different from each other. In addition, the power level may be dynamically changed.

According to an embodiment, an image sensor may include a sensor substrate including a plurality of unit pixel groups each including a first pixel, a second pixel, a third pixel, and a fourth pixel, and a nano-photonic lens array including a plurality of nanostructures configured to separate incident light according to wavelengths and concentrate the incident light onto the first pixel, the second pixel, the third pixel, and the fourth pixel, respectively, wherein the nano-photonic lens array includes a plurality of unit meta-groups each including a first meta-region corresponding to the first pixel, a second meta-region corresponding to the second pixel, a third meta-region corresponding to the third pixel, and a fourth meta-region corresponding to the fourth pixel, each of the first meta-region, the second meta-region, the third meta-region, and the fourth meta-region includes a first sub-region, a second sub-region, a third sub-region, and a fourth sub-region, at least one nanostructure is provided in each of the first sub-region, the second sub-region, the third sub-region, and the fourth sub-region, the plurality of unit meta-groups include a central meta-group located at a center portion of the nano-photonic lens array and a peripheral meta-group located at a periphery of the nano-photonic lens array, in the first meta-region, the second meta-region, the third meta-region, and the fourth meta-region of the peripheral meta-group, a nanostructure of the first sub-region and a nanostructure of the second sub-region adjacent to the first sub-region in a first direction are symmetrically shifted with opposite displacements in the first direction, and the nanostructure of the first sub-region and a nanostructure of the third sub-region adjacent to the first sub-region in a second direction are symmetrically shifted with opposite displacements in the second direction, a distance by which the nanostructure of the first sub-region and the nanostructure of the second sub-region are shifted in the first direction decreases as an azimuth angle of the peripheral meta-group increases from 0 degrees to 90 degrees, and a distance by which the nanostructure of the first sub-region and the nanostructure of the third sub-region are shifted in the second direction increases as the azimuth angle of the peripheral meta-group increases from 0 degrees to 90 degrees.

Each of the first pixel, the second pixel, the third pixel, and the fourth pixel may include a first sub-pixel, a second sub-pixel, a third sub-pixel, and a fourth sub-pixel which are grouped and two-dimensionally arranged in the form of a 2×2 array, and each of the first sub-pixel, the second sub-pixel, the third sub-pixel, and the fourth sub-pixel may be configured to independently sense incident light.

The plurality of nanostructures of the nano-photonic lens array may have dimensions, cross-sectional shapes, heights, and an arrangement form to, in light incident on the nano-photonic lens array, concentrate light of a first wavelength band onto each of the first sub-pixel, the second sub-pixel, the third sub-pixel, and the fourth sub-pixel of the first pixel and each of the first sub-pixel, the second sub-pixel, the third sub-pixel, and the fourth sub-pixel of the fourth pixel, concentrate light of a second wavelength band different from the first wavelength band onto the first sub-pixel, the second sub-pixel, the third sub-pixel, and the fourth sub-pixel of the second pixel, and concentrate light of a third wavelength band different from the first wavelength band and the second wavelength band onto the first sub-pixel, the second sub-pixel, the third sub-pixel, and the fourth sub-pixel of the third pixel.

Each of the first sub-pixel, the second sub-pixel, the third sub-pixel, and the fourth sub-pixel may include a plurality of photosensitive cells configured to independently sense light.

The first meta-region in the peripheral meta-group may be shifted by a first displacement in the first direction and a second displacement in the second direction compared to the first meta-region of the central meta-group, the second meta-region in the peripheral meta-group may be shifted by a third displacement in the first direction and a fourth displacement in the second direction compared to the second meta-region of the central meta-group, the third meta-region in the peripheral meta-group may be shifted by a fifth displacement in the first direction and a sixth displacement in the second direction compared to the third meta-region of the central meta-group, and the fourth meta-region in the peripheral meta-group may be shifted by a seventh displacement in the first direction and an eighth displacement in the second direction compared to the fourth meta-region of the central meta-group.

A gap between the first meta-region and the second meta-region in the central meta-group and a gap between the first meta-region and the second meta-region in the peripheral meta-group are different from each other, a gap between the first meta-region and the third meta-region in the central meta-group and a gap between the first meta-region and the third meta-region in the peripheral meta-group are different from each other, a gap between the second meta-region and the fourth meta-regions in the central meta-group and a gap between the second meta-region and the fourth meta-region in the peripheral meta-group are different from each other, or a gap between the third meta-region and the fourth meta-region in the central meta-group and a gap between the third meta-region and the fourth meta-region in the peripheral meta-group may be different from each other.

A gap between a first nanostructure and a second nanostructure which belong to different meta-regions in the central meta-group may be different from a gap between a third nanostructure in the peripheral meta-group at a relatively same position as the first nanostructure of the central meta-group and a fourth nanostructure in the peripheral meta-group at a relatively same position as the second nanostructure of the central meta-group.

The peripheral meta-group may include a first peripheral meta-group having a first azimuth angle and a second peripheral meta-group having a second azimuth angle different from the first azimuth, and a gap between a fifth nanostructure and a sixth nanostructure which belong to different meta-regions in the first peripheral meta-group may be different from a gap between a seventh nanostructure in the second peripheral meta-group at a relatively same position as the fifth nanostructure of the first peripheral meta-group and an eighth nanostructure in the second peripheral meta-group at a relatively same position as the sixth nanostructure of the first peripheral meta-group.

Each of the plurality of unit meta-groups may include a first boundary nanostructure located at a boundary of all the first meta-region, the second meta-region, the third meta-region, and the fourth meta-region, and the first boundary nanostructure in the peripheral meta-group is shifted by an average of the first displacement, the second displacement, the third displacement, the fourth displacement, the fifth displacement, the sixth displacement, the seventh displacement, and the eighth displacement.

A gap in the first direction between the first sub-region and the second sub-region in the first meta-region of the central meta-group may be different from a gap in the first direction between the first sub-region and the second sub-region in the first meta-region of the peripheral meta-group provided at a position where the azimuth angle is 0 degrees, and a gap in the first direction between the third sub-region and the fourth sub-region in the first meta-region of the central meta-group may be different from a gap in the first direction between the third sub-region and the fourth sub-region in the first meta-region of the peripheral meta-group provided at the position where the azimuth angle is 0 degrees.

A gap in a second direction crossing the first direction between the first sub-region and the third sub-region in the first meta-region of the central meta-group may be the same as a gap in the second direction between the first sub-region and the third sub-region in the first meta-region of the peripheral meta-group provided at the position where the azimuth angle is 0 degrees, and a gap in the second direction between the second sub-region and the fourth sub-region in the first meta-region of the central meta-group may be the same as a gap in the second direction between the second sub-region and the fourth sub-region in the first meta-region of the peripheral meta-group provided at the position where the azimuth angle is 0 degrees.

A gap in a second direction crossing the first direction between the first sub-region and the third sub-region in the first meta-region of the central meta-group may be different from a gap in the second direction between the first sub-region and the third sub-region in the first meta-region of the peripheral meta-group provided at a position where the azimuth angle is 90 degrees, and a gap in the second direction between the second sub-region and the fourth sub-region in the first meta-region of the central meta-group may be different from a gap in the second direction between the second sub-region and the fourth sub-region in the first meta-region of the peripheral meta-group provided at the position where the azimuth angle is 90 degrees.

A gap in the first direction between the first sub-region and the second sub-region in the first meta-region of the central meta-group may be the same as a gap in the first direction between the first sub-region and the second sub-region in the first meta-region of the peripheral meta-group provided at the position where the azimuth angle is 90 degrees, and a gap in the first direction between the third sub-region and the fourth sub-region in the first meta-region of the central meta-group may be the same as a gap in the first direction between the third sub-region and the fourth sub-region in the first meta-region of the peripheral meta-group provided at the position where the azimuth angle is 90 degrees.

A gap between a ninth nanostructure belonging to the first sub-region of the first meta-region of the central meta-group and a tenth nanostructure belonging to the second sub-region of the first meta-region of the central meta-group may be different from a gap between an eleventh nanostructure at the relatively same position as the ninth nanostructure of the central meta-group in the first meta-region of the peripheral meta-group and a twelfth nanostructure at the relatively same position as the tenth nanostructure of the central meta-group in the first meta-region of the peripheral meta-group.

The peripheral meta-group may include a first peripheral meta-group having a first azimuth angle and a second peripheral meta-group having a second azimuth angle different from the first azimuth, and a gap between a thirteenth nanostructure belonging to the first sub-region of the first meta-region of the first peripheral meta-group and a fourteenth nanostructure belonging to the second sub-region of the first meta-region of the first peripheral meta-group may be different from a gap between a fifteenth nanostructure at the relatively same position as the thirteenth nanostructure of the first peripheral meta-group in a first meta-region of the second peripheral meta-group and a sixteenth nanostructure at the relatively same position as the fourteenth nanostructure of the first peripheral meta-group in a first meta-region of the second peripheral meta-group.

Each of the plurality of unit meta-groups may include a second boundary nanostructure located at a boundary of all the first sub-region, the second sub-region, the third sub-region, and the fourth sub-region in the first meta-region, and a gap between the second boundary nanostructure of the central meta-group and a seventeenth nanostructure inside the first sub-region of the first meta-region of the central meta-group may be different from a gap between a second boundary nanostructure of the peripheral meta-group and an eighteenth nanostructure of the peripheral meta-group at the relatively same position as the seventeenth nanostructure of the central meta-group.

The peripheral meta-group may include a first peripheral meta-group having a first azimuth angle and a second peripheral meta-group having a second azimuth angle different from the first azimuth, and a gap between a second boundary nanostructure of the first peripheral meta-group and a nineteenth nanostructure inside the first sub-region of the first meta-region of the first peripheral meta-group may be different from a gap between a second boundary nanostructure of the second peripheral meta-group and a twentieth nanostructure of the second peripheral meta-group at the relatively same position as the nineteenth nanostructure of the first peripheral meta-group.

Each of the plurality of unit meta-groups may include a third boundary nanostructure located at a boundary between the third sub-region and the fourth sub-region in the first meta-region, and a gap in the first direction between the third boundary nanostructure of the central meta-group and a twenty-first nanostructure inside the third sub-region of the first meta-region may be different from a gap in the first direction between the third boundary nanostructure of the peripheral meta-group and a twenty-second nanostructure of the peripheral meta-group at the relatively same position as the twenty-first nanostructure of the central meta-group.

The first meta-region and the fourth meta-region may be symmetrically shifted relative to each other with respect to an azimuth angle of ±45 degrees in the peripheral meta-group.

According to another embodiment, an electronic apparatus may include a lens assembly configured to form an optical image of a subject, an image sensor configured to convert the optical image formed by the lens assembly into an electrical signal, and a processor configured to process the signal generated by the image sensor, wherein the image sensor includes a sensor substrate including a plurality of unit pixel groups each including a first pixel, a second pixel, a third pixel, and a fourth pixel, and a nano-photonic lens array including a plurality of nanostructures configured to separate incident light according to wavelengths and concentrate the incident light onto the first pixel, the second pixel, the third pixel, and the fourth pixel, respectively, the nano-photonic lens array includes a plurality of unit meta-groups each including a first meta-region corresponding to the first pixel, a second meta-region corresponding to the second pixel, a third meta-region corresponding to the third pixel, and a fourth meta-region corresponding to the fourth pixel, each of the first meta-region, the second meta-region, the third meta-region, and the fourth meta-region includes a first sub-region, a second sub-region, a third sub-region, and a fourth sub-region, at least one nanostructure is provided in each of the first sub-region, the second sub-region, the third sub-region, and the fourth sub-region, the plurality of unit meta-groups include a central meta-group located at a center portion of the nano-photonic lens array and a peripheral meta-group located at a periphery of the nano-photonic lens array, in the first meta-region, the second meta-region, the third meta-region, and the fourth meta-region of the peripheral meta-group, a nanostructure of the first sub-region and a nanostructure of the second sub-region adjacent to the first sub-region in a first direction are symmetrically shifted with opposite displacements in the first direction, and the nanostructure of the first sub-region and a nanostructure of the third sub-region adjacent to the first sub-region in a second direction are symmetrically shifted with opposite displacements in the second direction, a distance by which the nanostructure of the first sub-region and the nanostructure of the second sub-region are shifted in the first direction decreases as an azimuth angle of the peripheral meta-group increases from 0 degrees to 90 degrees, and a distance by which the nanostructure of the first sub-region and the nanostructure of the third sub-region are shifted in the second direction increases as the azimuth angle of the peripheral meta-group increases from 0 degrees to 90 degrees.

According to the embodiments, the nano-photonic lens array may separate and concentrate incident light according to wavelengths without absorbing or blocking the incident light, and thus the light utilization efficiency of the image sensor may be improved.

In addition, nanostructures of the nano-photonic lens array may be designed in consideration of a CRA of incident light that is obliquely incident on the periphery of the image sensor, and thus sensitivity deviations between different color pixels, sensitivity deviations between sub-pixels in the same color pixel, and autofocus characteristics deviations may be reduced. Accordingly, image quality and autofocus performance of the image sensor may be improved.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope as defined by the following claims.

## Claims

1. An image sensor comprising:
a sensor substrate comprising a plurality of unit pixel groups, each of the plurality of unit pixel groups comprising a first pixel, a second pixel, a third pixel, and a fourth pixel; and
a nano-photonic lens array comprising a plurality of nanostructures configured to separate incident light according to wavelengths and concentrate the incident light onto the first pixel, the second pixel, the third pixel, and the fourth pixel, respectively,
wherein the nano-photonic lens array comprises a plurality of unit meta-groups, each of the plurality of unit meta-groups comprising a first meta-region corresponding to the first pixel, a second meta-region corresponding to the second pixel, a third meta-region corresponding to the third pixel, and a fourth meta-region corresponding to the fourth pixel,
wherein each of the first meta-region, the second meta-region, the third meta-region, and the fourth meta-region comprises a first sub-region, a second sub-region, a third sub-region, and a fourth sub-region,
wherein at least one nanostructure is provided in each of the first sub-region, the second sub-region, the third sub-region, and the fourth sub-region,
wherein the plurality of unit meta-groups comprise a central meta-group located at a center portion of the nano-photonic lens array and a plurality of peripheral meta-groups located at a periphery of the nano-photonic lens array,
wherein, in the first meta-region, the second meta-region, the third meta-region, and the fourth meta-region of the plurality of peripheral meta-groups, a nanostructure of the first sub-region and a nanostructure of the second sub-region adjacent to the first sub-region in a first direction are symmetrically shifted with opposite displacements in the first direction, and the nanostructure of the first sub-region and a nanostructure of the third sub-region adjacent to the first sub-region in a second direction crossing the first direction are symmetrically shifted with opposite displacements in the second direction, and
wherein a first distance by which the nanostructure of the first sub-region and the nanostructure of the second sub-region are shifted in the first direction decreases as an azimuth angle of a respective one of the plurality of peripheral meta-groups increases from 0 degrees to 90 degrees, and a second distance by which the nanostructure of the first sub-region and the nanostructure of the third sub-region are shifted in the second direction increases as the azimuth angle of the respective one of the plurality of the plurality of peripheral meta-groups increases from 0 degrees to 90 degrees.

2. The image sensor of claim 1, wherein:
each of the first pixel, the second pixel, the third pixel, and the fourth pixel comprises a first sub-pixel, a second sub-pixel, a third sub-pixel, and a fourth sub-pixel two-dimensionally arranged in the form of a 2×2 array; and
each of the first sub-pixel, the second sub-pixel, the third sub-pixel, and the fourth sub-pixel is configured to independently sense incident light,
and optionally wherein each of the first sub-pixel, the second sub-pixel, the third sub-pixel, and the fourth sub-pixel comprises a plurality of photosensitive cells configured to independently sense light.

3. The image sensor of claim 2, wherein:
the plurality of nanostructures of the nano-photonic lens array have dimensions, cross-sectional shapes, heights, and an arrangement form to concentrate light of a first wavelength band onto each of the first sub-pixel, the second sub-pixel, the third sub-pixel, and the fourth sub-pixel of the first pixel and each of the first sub-pixel, the second sub-pixel, the third sub-pixel, and the fourth sub-pixel of the fourth pixel, concentrate light of a second wavelength band onto the first sub-pixel, the second sub-pixel, the third sub-pixel, and the fourth sub-pixel of the second pixel, and concentrate light of a third wavelength band onto the first sub-pixel, the second sub-pixel, the third sub-pixel, and the fourth sub-pixel of the third pixel; and
wherein the first wavelength band, the second wavelength band and the third wavelength band are different from each other.

4. The image sensor of any preceding claim, wherein:
the first meta-region in one or more of the plurality of peripheral meta-groups is shifted by a first displacement in the first direction and a second displacement in the second direction compared to the first meta-region of the central meta-group;
the second meta-region in one or more of the plurality of peripheral meta-groups is shifted by a third displacement in the first direction and a fourth displacement in the second direction compared to the second meta-region of the central meta-group;
the third meta-region in one or more of the plurality of peripheral meta-groups is shifted by a fifth displacement in the first direction and a sixth displacement in the second direction compared to the third meta-region of the central meta-group; and
the fourth meta-region in one or more of the plurality of peripheral meta-groups is shifted by a seventh displacement in the first direction and an eighth displacement in the second direction compared to the fourth meta-region of the central meta-group.

5. The image sensor of claim 4, wherein:
a gap between the first meta-region and the second meta-region in the central meta-group is different from a gap between the first meta-region and the second meta-region in one or more of the plurality of peripheral meta-groups, a gap between the first meta-region and the third meta-region in the central meta-group is different from a gap between the first meta-region and the third meta-region in one or more of the plurality of peripheral meta-groups, a gap between the second meta-region and the fourth meta-region in the central meta-group is different from a gap between the second meta-region and the fourth meta-region in one or more of the plurality of peripheral meta-groups, or a gap between the third meta-region and the fourth meta-region in the central meta-group is different from a gap between the third meta-region and the fourth meta-region in one or more of the plurality of peripheral meta-groups, and optionally wherein:
a gap between a first nanostructure in the first meta-region in the central meta-group and a second nanostructure in the second meta-region in the central meta-group is different from a gap between a third nanostructure in the first meta-region in a first peripheral meta-group, among the plurality of peripheral meta-groups, at a relatively same position as the first nanostructure of the central meta-group and a fourth nanostructure in the first peripheral meta-group at a relatively same position as the second nanostructure of the central meta-group.

6. The image sensor of claim 5, wherein:
the plurality of peripheral meta-groups comprise a first peripheral meta-group having a first azimuth angle and a second peripheral meta-group having a second azimuth angle different from the first azimuth; and
a gap between a first nanostructure in the first meta-region in the first peripheral meta-group and a second nanostructure in the second meta-region in the first peripheral meta-group is different from a gap between a third nanostructure in the first meta-region in the second peripheral meta-group at a relatively same position as the first nanostructure of the first peripheral meta-group and a fourth nanostructure in the second meta-region in the second peripheral meta-group at a relatively same position as the second nanostructure of the first peripheral meta-group.

7. The image sensor of any preceding claim, wherein:
a gap, in the first direction, between the first sub-region and the second sub-region in the first meta-region of the central meta-group is different from a gap in the first direction, between the first sub-region and the second sub-region in the first meta-region of a first peripheral meta-group provided at a position where the azimuth angle is 0 degrees, among the plurality of peripheral meta-groups, and
a gap, in the first direction, between the third sub-region and the fourth sub-region in the first meta-region of the central meta-group is different from a gap, in the first direction, between the third sub-region and the fourth sub-region in the first meta-region of the first peripheral meta-group.

8. The image sensor of claim 7, wherein:
a gap, in the second direction, between the first sub-region and the third sub-region in the first meta-region of the central meta-group is same as a gap, in the second direction, between the first sub-region and the third sub-region in the first meta-region of the first peripheral meta-group; and
a gap, in the second direction, between the second sub-region and the fourth sub-region in the first meta-region of the central meta-group is same as a gap, in the second direction, between the second sub-region and the fourth sub-region in the first meta-region of the first peripheral meta-group.

9. The image sensor of claim 7, wherein
a gap, in the second direction, between the first sub-region and the third sub-region in the first meta-region of the central meta-group is different from a gap, in the second direction between, the first sub-region and the third sub-region in the first meta-region of a second peripheral meta-group provided at a position where the azimuth angle is 90 degrees, among the plurality of peripheral meta-groups, and
a gap, in the second direction, between the second sub-region and the fourth sub-region in the first meta-region of the central meta-group is different from a gap in the second direction between the second sub-region and the fourth sub-region in the first meta-region of the second peripheral meta-group, and optionally wherein:
the gap, in the first direction, between the first sub-region and the second sub-region in the first meta-region of the central meta-group is same as a gap, in the first direction, between the first sub-region and the second sub-region in the first meta-region of the second peripheral meta-group; and
the gap, in the first direction, between the third sub-region and the fourth sub-region in the first meta-region of the central meta-group is same as a gap, in the first direction, between the third sub-region and the fourth sub-region in the first meta-region of the second peripheral meta-group.

10. The image sensor of any preceding claim, wherein:
a gap between a first nanostructure belonging to the first sub-region of the first meta-region of the central meta-group and a second nanostructure belonging to the second sub-region of the first meta-region of the central meta-group is different from a gap between a third nanostructure at a relatively same position as the first nanostructure of the central meta-group in the first meta-region of a first peripheral meta-group, among the plurality of peripheral meta-groups and a fourth nanostructure at a relatively same position as the second nanostructure of the central meta-group in the first meta-region of the first peripheral meta-group.

11. The image sensor of claim 1, wherein:
the plurality of peripheral meta-groups comprises a first peripheral meta-group having a first azimuth angle and a second peripheral meta-group having a second azimuth angle different from the first azimuth; and
a gap between a first nanostructure belonging to the first sub-region of the first meta-region of the first peripheral meta-group and a second nanostructure belonging to the second sub-region of the first meta-region of the first peripheral meta-group is different from a gap between a third nanostructure at a relatively same position as the first nanostructure of the first peripheral meta-group in the first meta-region of the second peripheral meta-group and a fourth nanostructure at a relatively same position as the second nanostructure of the first peripheral meta-group in the first meta-region of the second peripheral meta-group.

12. The image sensor of any preceding claim, wherein:
each of the plurality of unit meta-groups comprises a boundary nanostructure located at a boundary of all the first sub-region, the second sub-region, the third sub-region, and the fourth sub-region in the first meta-region; and
a gap between the boundary nanostructure of the central meta-group and a first nanostructure inside the first sub-region of the first meta-region of the central meta-group is different from a gap between the boundary nanostructure of a first peripheral meta-group, among the plurality of peripheral meta-groups and a second nanostructure of the first peripheral meta-group at a relatively same position as the first nanostructure of the central meta-group.

13. The image sensor of any preceding claim, wherein:
the plurality of peripheral meta-groups comprises a first peripheral meta-group having a first azimuth angle and a second peripheral meta-group having a second azimuth angle different from the first azimuth; and
a gap between a boundary nanostructure of the first peripheral meta-group and a first nanostructure inside the first sub-region of the first meta-region of the first peripheral meta-group is different from a gap between a boundary nanostructure of the second peripheral meta-group and a second nanostructure of the second peripheral meta-group at a relatively same position as the first nanostructure of the first peripheral meta-group.

14. The image sensor of any preceding claim, wherein:
each of the plurality of unit meta-groups comprises a boundary nanostructure located at a boundary between the third sub-region and the fourth sub-region in the first meta-region; and
a gap, in the first direction, between the boundary nanostructure of the central meta-group and a first nanostructure inside the third sub-region of the first meta-region of the central meta-group is different from a gap, in the first direction, between the boundary nanostructure of a first peripheral meta-group, among the plurality of peripheral meta-groups, and a second nanostructure of the first peripheral meta-group at a relatively same position as the first nanostructure of the central meta-group.

15. The image sensor of any preceding claim, wherein the first meta-region and the fourth meta-region are symmetrically shifted relative to each other with respect to an azimuth angle of ±45 degrees in one or more the plurality of peripheral meta-groups.
